# EUROPEAN PATENT APPLICATION

(11) **EP 4 553 100 A1**
(43) Date of publication of application: **14.05.2025**
(21) Application number: 24210475.0
(22) Date of filing: 04.11.2024
(51) Int. Cl.: C08G 69/26, C08G 69/32, C08G 69/40, C08G 69/42, C08G 73/10, C08G 73/14, G03F 7/038

(54) **POLYMER, POSITIVE AND NEGATIVE PHOTOSENSITIVE RESIN COMPOSITIONS, PATTERNING PROCESS, METHOD FOR FORMING CURED FILM, INTERLAYER INSULATING FILM, SURFACE PROTECTIVE FILM, AND ELECTRONIC COMPONENT**

(30) Priority: 08.11.2023 JP 2023191153
(71) Applicant: SHIN-ETSU CHEMICAL CO., LTD., Tokyo 1000005 (JP)
(72) Inventor: Urano, Hiroyuki, Niigata (JP); Iio, Masashi, Niigata (JP); Watanabe, Osamu, Niigata (JP); Takemura, Katsuya, Niigata (JP)
(74) Representative: Sonnenhauser, Thomas Martin

(57) **Abstract**

The present invention is a polymer containing: a structural unit of general formula (1) and/or (2); and a structural unit of general formula (3) and/or (4), where X₁ represents a tetravalent organic group, R₁ to R₄ each represent a monovalent organic group or a hydrogen atom, provided that at least one is a monovalent organic group, L represents a divalent organic group or a divalent atom, X₂ represents a divalent organic group, X₃ represents a tetravalent organic group, "s" represents 0 or 1, Z represents a divalent bonding group, and X₄ represents a divalent organic group. This provides a polymer soluble in an aqueous alkaline solution and usable as a base resin for positive and negative photosensitive resin compositions which enable fine pattern formation, provide high resolution, and have excellent mechanical characteristics even when cured at low temperatures.

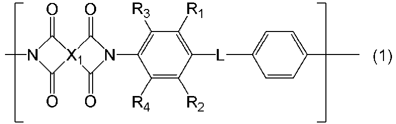

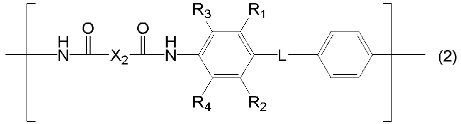

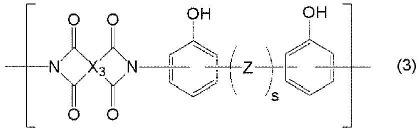

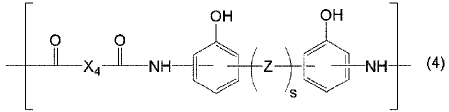

## Description

### TECHNICAL FIELD

The present invention relates to: a polymer; positive and negative photosensitive resin compositions; a patterning process; a method for forming a cured film; an interlayer insulating film; a surface protective film; and an electronic component.

### BACKGROUND ART

As miniaturization and higher performance of various electronic devices such as personal computers, digital cameras, and mobile phones advance, a demand for further miniaturization, thinning, and higher density in semiconductor devices are also increasing rapidly. Accompanying these, it is demanded for interlayer insulating films and surface protective films of semiconductor devices to combine better electric characteristics, heat resistance, mechanical characteristics, and the like.

In a high-density mounting technology such as a three-dimensional lamination, as a photosensitive insulation material capable of forming a pattern on a substrate, a polyimide film has been utilized as a protective film or an insulation layer, its insulation property, mechanical characteristics, adhesiveness with a substrate, and so forth have continued to draw attention, and its development is active even now.

To improve the required properties further, various approaches are taken. As one such approach, a photosensitive resin composition has been proposed, which uses a closed-ring polyimide resin in order to lower a post-curing temperature (Patent Document 1, Patent Document 2). However, it is difficult to achieve all of the physical properties of the cured film such as resolution, mechanical characteristics (elongation and tensile strength), and adhesion, and there is room for improvement.

In addition, to improve the mechanical strength of a cured film, a composition containing a polymer having a structural unit derived from ester-containing diamine is proposed (Patent Document 3, Patent Document 4). Patent Document 3 proposes a positive photosensitive resin composition containing an esterdiamine-containing polybenzoxazole precursor and a naphthoquinonediazide compound. However, regarding lithography characteristics, only dissolution contrast and sensitivity are described and there is no description regarding pattern resolution, and there is also room for improvement regarding the value of mechanical strength.

Patent Document 4 proposes a polyamic acid and a polyimide obtained by the ring closure of the polyamic acid, containing, as a diamine residue, a diamine residue derived from an ester-containing diamine and a flexible diamine, and an acid dianhydride residue. However, there is no description regarding photosensitive resin compositions, and there is room for improvement regarding mechanical strength, especially elongation.

Thus, hereafter, as higher densification and higher integration of chips proceed, the miniaturization of patterns in a rewiring technology of the insulation protective film further proceeds. Accordingly, as the photosensitive resin composition, there is strong demand for a composition that can realize high resolution and a pattern profile with good rectangularity without damaging excellent features such as the mechanical characteristics and adhesiveness of a pattern and a protective film obtained by heating.

### CITATION LIST

### PATENT LITERATURE

Patent Document 1: JP 4530284 B
Patent Document 2: JP 2006-313237 A
Patent Document 3: JP 2020-152768 A
Patent Document 4: JP 2021-187934 A

### SUMMARY OF INVENTION

### TECHNICAL PROBLEM

The present invention has been made in view of the above-described circumstances. An object of the present invention is to provide a polymer selected from polyamide, polyamide-imide, and polyimide, usable as a base resin for a positive photosensitive resin composition and a negative photosensitive resin composition which are soluble in an aqueous alkaline solution, enable fine pattern formation, provide high resolution, and have excellent mechanical characteristics even when cured at low temperatures.

Another object of the present invention is to provide a positive photosensitive resin composition and a negative photosensitive resin composition which include the polymer, and in patterning, are soluble in an aqueous alkaline solution, excellent in resolution, and enable fine pattern formation, and have excellent mechanical characteristics even when cured at low temperatures.

### SOLUTION TO PROBLEM

To achieve the object, the present invention provides a polymer comprising: a structural unit represented by the following general formula (1) and/or (2); and a structural unit represented by the following general formula (3) and/or (4), 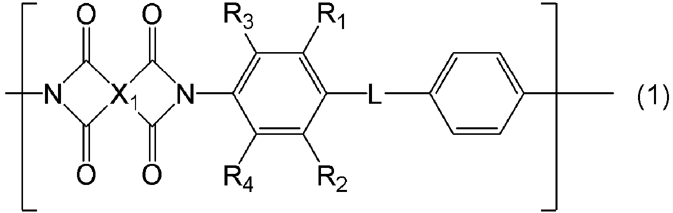 wherein X₁ represents a tetravalent organic group, R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom, and L represents a divalent organic group excluding a -O-C(=O)- bond or a -C(=O)-O- bond or represents a divalent atom, 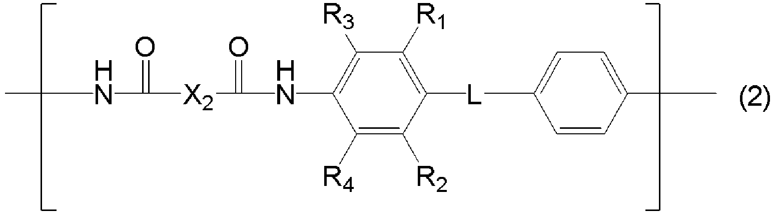 wherein X₂ represents a divalent organic group, and R₁ to R₄ and L are as defined above, 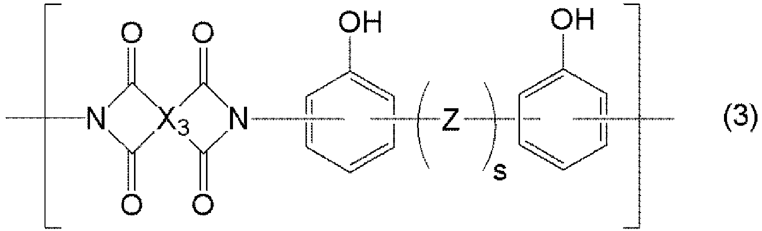 wherein X₃ represents a tetravalent organic group that is identical to or different from the X₁, "s" represents 0 or 1, Z represents a divalent bonding group, and when s=0, the two aromatic rings in the formula are directly bonded without an intervening bonding group, 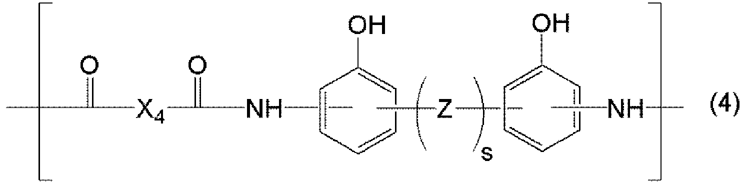 wherein X₄ represents a divalent organic group that is identical to or different from the X₂, and "s" and Z are as defined above.

Such a polymer is soluble in an aqueous alkaline solution by the general formula (3) or (4) having a phenolic hydroxy group, so that a fine pattern can be formed and high resolution can be achieved, and suitable interaction between molecules is promoted by the general formula (1) or (2) having a phenyl group having a substituent, so that the polymer is usable as a base resin of a photosensitive resin composition having excellent mechanical properties even when cured at low temperatures.

Furthermore, it is preferable that, in the general formulae (1) and (2), either one of the R₁ and the R₂ represents a monovalent organic group having 1 to 15 carbon atoms and optionally containing a heteroatom, the other of the R₁ and the R₂ represents a hydrogen atom, and the R₃ and the R₄ each represent a hydrogen atom.

A photosensitive resin composition containing such a polymer has a substituent at an ortho position of an attachment point, and therefore, free rotation of the polymer chain is suppressed by the steric hindrance of the substituent, so that suitable interaction between molecules can be achieved. Thus, the composition has excellent mechanical properties even when cured at low temperatures.

Furthermore, it is preferable that, in the general formulae (1) and (2), either one of the R₁ and the R₂ represents an aromatic group having 6 to 12 carbon atoms, and the other of the R₁ and the R₂ represents a hydrogen atom.

A photosensitive resin composition containing such a polymer has better mechanical properties even when cured at low temperatures.

Furthermore, it is preferable that the L in the general formulae (1) and (2) is at least one selected from any of an oxygen atom, a sulfur atom, a carbonyl group, a linear alkylene group having 1 to 15 carbon atoms, and a branched alkylene group having 3 to 15 carbon atoms.

A photosensitive resin composition containing such a polymer has excellent mechanical properties by flexibility being imparted to the polymer chain.

Furthermore, the Z in the general formulae (3) and (4) is preferably at least one bonding group selected from any of groups represented by the following formulae (5), (6), (7), and (8), 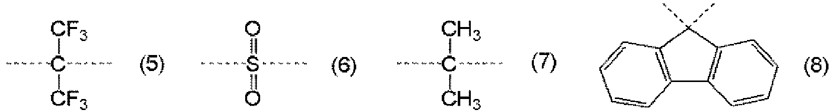 wherein a dotted line represents an attachment point.

Regarding a photosensitive resin composition containing such a polymer, solubility in an aqueous alkaline solution can be enhanced, a finer pattern can be formed, and high resolution can be obtained.

In addition, the present invention provides a positive photosensitive resin composition comprising:
(A) the above-described polymer;
(B) a photosensitizer which is a compound having a quinonediazide structure and generates an acid by light to increase a dissolution rate in an aqueous alkaline solution; and
(D) a solvent.

The use of a photosensitizer of the component (B) as stated above increases the dissolution rate in a developing solution of an aqueous alkaline solution, so that the exposed part becomes soluble upon patterning. Meanwhile, the unexposed part is not dissolved due to the alkaline-dissolution prevention property of the photosensitizer. Hence, a positive image can be obtained. The polymer exhibits alkali solubility by itself. Therefore, residue such as scum and pattern degradation such as tailing are unlikely to occur at the bottom of an open pattern, which benefits fine patterning.

In this case, the positive photosensitive resin composition preferably further comprises the following component (C):
(C) one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (C-1), and a compound containing two or more nitrogen atoms each having a glycidyl group represented by the following formula (C-2), 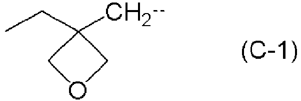 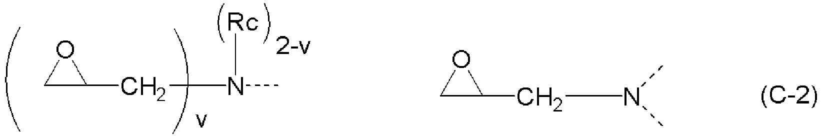 wherein a dotted line represents an attachment point, Rc represents a linear, branched, or cyclic alkyl group having 1 to 6 carbon atoms, and "v" represents 1 or 2.

Such a component (C) can cause, after the patterning with the inventive positive photosensitive resin composition, a crosslinking reaction by post-curing and further raise the strength of the cured product, thereby forming a more suitable cured film.

Furthermore, the present invention provides a negative photosensitive resin composition comprising:
(A) the above-described polymer;
(B') a photoacid generator;
(C) one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (C-1), and a compound containing two or more nitrogen atoms each having a glycidyl group represented by the following formula (C-2), 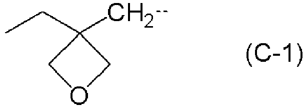 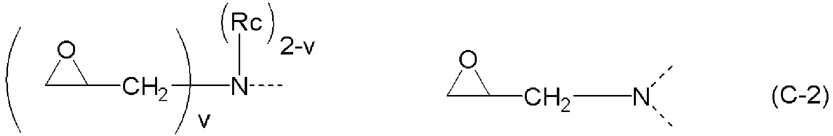 wherein a dotted line represents an attachment point, Rc represents a linear, branched, or cyclic alkyl group having 1 to 6 carbon atoms, and "v" represents 1 or 2; and
   (D) a solvent.

The use of a photoacid generator of the component (B') as stated above generates an acid in the exposed part upon patterning, allowing crosslinkage between crosslinking groups of a crosslinking agent of the added component (C) and crosslinking reaction points of the polymer. This makes the exposed part insoluble in a developing solution. Hence, the composition can provide a negative image.

Furthermore, the present invention provides a patterning process comprising the steps of:
(1) applying the above-described positive photosensitive resin composition onto a substrate to form a photosensitive material film;
(2) heating the photosensitive material film;
(3) exposing the photosensitive material film with a high-energy beam having a wavelength of 190 to 500 nm or an electron beam through a photomask; and
(4) developing the film with a developing solution of an aqueous alkaline solution.

Such a patterning process using the above positive photosensitive resin composition makes the exposed part soluble in an aqueous alkaline solution, can form a fine pattern without scum or the like, and achieves high resolution.

Furthermore, the present invention provides a patterning process comprising the steps of:
(I) applying the above-described negative photosensitive resin composition onto a substrate to form a photosensitive material film;
(II) heating the photosensitive material film;
(III) exposing the photosensitive material film with a high-energy beam having a wavelength of 190 to 500 nm or an electron beam through a photomask; and
(IV) after irradiation, subjecting the substrate to heat treatment, followed by development using a developing solution of an aqueous alkaline solution.

Since the polymer serving as the base resin for the inventive negative photosensitive resin composition contains the structural unit represented by the general formula (3) and/or (4), this enables alkali development with an aqueous alkaline solution.

Furthermore, the present invention provides a method for forming a cured film, comprising heating and post-curing a patterned film obtained by the above-described patterning process at a temperature of 100 to 300°C.

Such a method for forming a cured film makes it possible to form a cured film (pattern) with favorable mechanical properties even when it is cured at low temperatures.

Furthermore, the present invention provides an interlayer insulating film comprising a cured film of the above-described positive photosensitive resin composition.

Furthermore, the present invention provides an interlayer insulating film comprising a cured film of the above-described negative photosensitive resin composition.

Furthermore, the present invention provides a surface protective film comprising a cured film of the above-described positive photosensitive resin composition.

Furthermore, the present invention provides a surface protective film comprising a cured film of the above-described negative photosensitive resin composition.

The cured film formed by curing the inventive positive photosensitive resin composition or the inventive negative photosensitive resin composition is excellent in adhesiveness to a substrate, heat resistance, electrical properties, mechanical strength, and chemical resistance to alkaline stripping solution etc. Moreover, a semiconductor device using the cured film as a protection film is also excellent in reliability. Therefore, the cured film is suitable as a protective film (interlayer insulating film or surface protective film) for electrical and electronic components, semiconductor devices, etc.

Furthermore, the present invention provides an electronic component comprising the above-described interlayer insulating film, or the above-described surface protective film.

Because of the heat resistance, chemical resistance, and insulating property, such a protective film (interlayer insulating film or surface protective film) is effective as an insulating film for semiconductor devices including a rewiring application, an insulating film for multilayer printed circuit boards, etc. Thus, the inventive protection film can make the electronic component excellent in reliability.

### ADVANTAGEOUS EFFECTS OF INVENTION

As described above, according to the present invention, it is possible to provide a polymer selected from polyamide, polyamide-imide, and polyimide, usable as a base resin for a positive photosensitive resin composition and a negative photosensitive resin composition which are soluble in an aqueous alkaline solution, enable fine pattern formation, provide high resolution, and have excellent mechanical characteristics even when cured at low temperatures.

Also, it is possible to provide a positive photosensitive resin composition and a negative photosensitive resin composition which include the polymer, and in patterning, are soluble in an aqueous alkaline solution, excellent in resolution, and enable fine pattern formation, and have excellent mechanical characteristics even when cured at low temperatures.

### DESCRIPTION OF EMBODIMENTS

As described above, there has been demand for a polymer usable as a base resin for a photosensitive resin composition which is soluble in an aqueous alkaline solution, enables fine pattern formation, provides high resolution, and has excellent mechanical characteristics even when cured at low temperatures.

To achieve the object, the present inventors have earnestly studied and found out that when a polymer containing a structural unit represented by the following general formula (1) and/or (2) and a structural unit represented by the following general formula (3) and/or (4) is used as a base resin for a photosensitive resin composition, such a polymer can be utilized for either a positive or negative photosensitive resin composition to allow development with an aqueous alkaline solution. This is because this polymer is soluble in a developing solution of an aqueous alkaline solution. Further, the inventors have found that patterns obtained by using these photosensitive resin compositions are fine and have favorable pattern shapes.

Furthermore, the present inventors have found that a protective film excellent in mechanical strength and adhesiveness is obtained by using a photosensitive resin composition containing as a base resin a polymer containing a structural unit represented by the following general formula (3) and/or (4), and by subjecting the composition to patterning and then heating at low temperatures. That is, the obtained cured film having a pattern formed using the photosensitive resin composition containing a base resin of a polymer having the structural unit is excellent as an insulating protective film and a protective film for electrical and electronic components. These findings have led to the completion of the present invention. Note that, in the specification, electrical and electronic components are also altogether referred to as "electronic component".

That is, the present invention is a polymer comprising: a structural unit represented by the following general formula (1) and/or (2); and a structural unit represented by the following general formula (3) and/or (4), 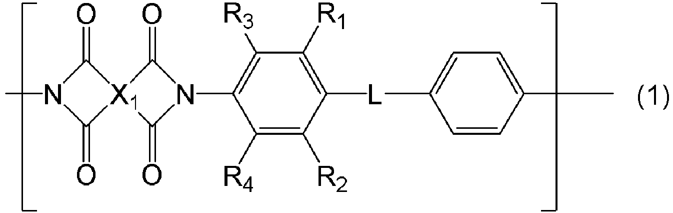 wherein X₁ represents a tetravalent organic group, R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom, and L represents a divalent organic group excluding a -O-C(=O)- bond or a -C(=O)-O- bond or represents a divalent atom, 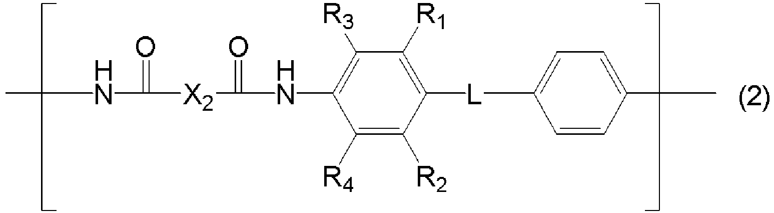 wherein X₂ represents a divalent organic group, and R₁ to R₄ and L are as defined above, 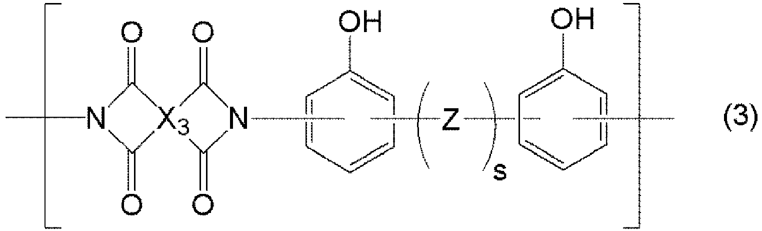 wherein X₃ represents a tetravalent organic group that is identical to or different from the X₁, "s" represents 0 or 1, Z represents a divalent bonding group, and when s=0, the two aromatic rings in the formula are directly bonded without an intervening bonding group, 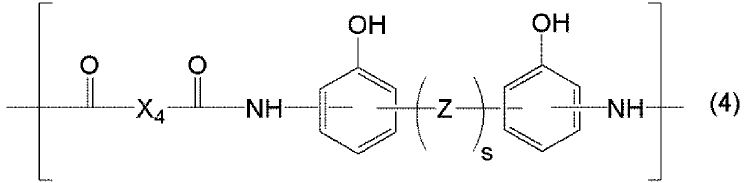 wherein X₄ represents a divalent organic group that is identical to or different from the X₂, and "s" and Z are as defined above.

Hereinafter, the present invention will be described in detail, but the present invention is not limited thereto.

### [(A) Polymer]

The inventive polymer contains: a structural unit represented by the following general formula (1) and/or (2) (hereinafter, also referred to as structural unit (1) and structural unit (2)); and a structural unit represented by the following general formula (3) and/or (4) (hereinafter, also referred to as structural unit (3) and structural unit (4)).

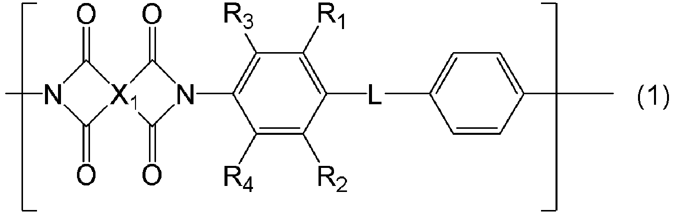

In the formula, X₁ represents a tetravalent organic group, R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom, and L represents a divalent organic group excluding a -O-C(=O)- bond or a -C(=O)-O- bond or represents a divalent atom.

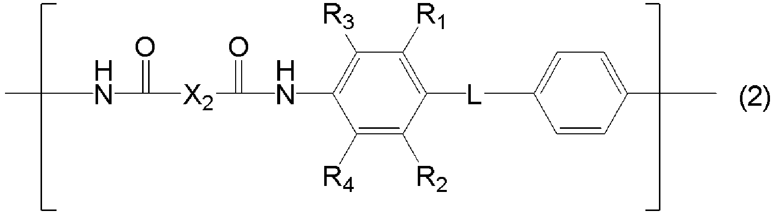

In the formula, X₂ represents a divalent organic group, and R₁ to R₄ and L are as defined above.

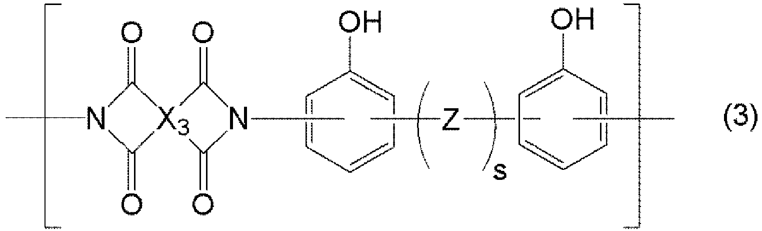

In the formula, X₃ represents a tetravalent organic group that is identical to or different from the X₁, "s" represents 0 or 1, Z represents a divalent bonding group, and when s=0, the two aromatic rings in the formula are directly bonded without an intervening bonding group.

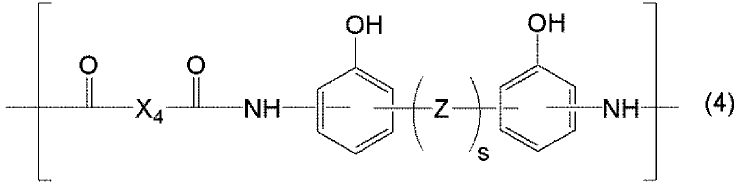

In the formula, X₄ represents a divalent organic group that is identical to or different from the X₂, and "s" and Z are as defined above.

The X₁ in the general formula (1) is a tetravalent organic group, and is not limited as long as it is a tetravalent organic group. X₁ is preferably a tetravalent alicyclic aliphatic group having 4 to 40 carbon atoms or a tetravalent aromatic group having 6 to 40 carbon atoms and optionally contains a siloxane skeleton. X₁ is further preferably a tetravalent organic group represented by one of the following formulae (9). In addition, the structure of X₁ may be of one kind or a combination of two or more kinds.

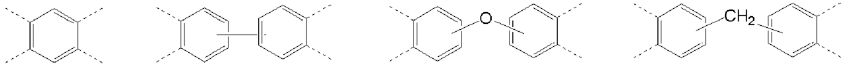

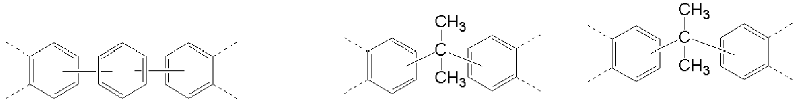

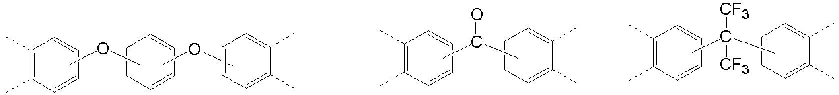

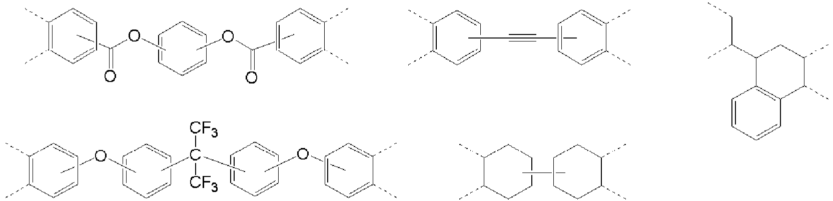

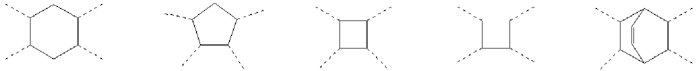

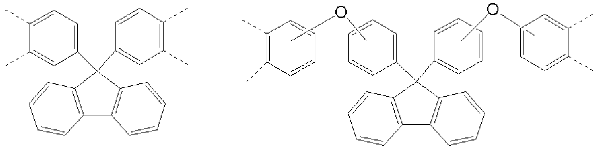

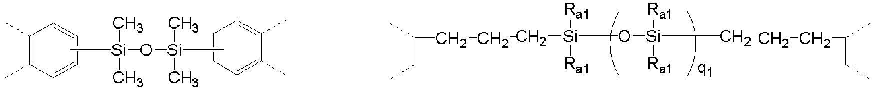

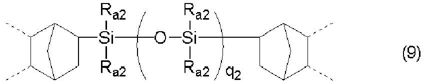

In the formula, Rₐ₁ and Rₐ₂ each independently represent a methyl group or a phenyl group, "q₁" and "q₂" each represent an integer of 1 to 20, and a dotted line represents an attachment point.

At least one of the R₁ to R₄ in the general formula (1) represents a monovalent organic group having 1 to 15 carbon atoms and optionally containing a heteroatom. Preferably, either one of the R₁ and the R₂ represents a monovalent organic group having 1 to 15 carbon atoms and optionally containing a heteroatom, the other of the R₁ and the R₂ represents a hydrogen atom, and the R₃ and the R₄ each represent a hydrogen atom. More preferably, either one of the R₁ and the R₂ represents a group selected from an alkyl group having 1 to 12 carbon atoms, an alkoxy group having 1 to 12 carbon atoms, an aromatic group having 6 to 12 carbon atoms, a phenoxy group having 6 to 10 carbon atoms, a benzyl group having 7 to 10 carbon atoms, and a benzyloxy group having 7 to 10 carbon atoms, the other of the R₁ and the R₂ represents a hydrogen atom, and the R₃ and the R₄ each represent a hydrogen atom. Further preferably, either one of the R₁ and the R₂ represents a monovalent organic group having 1 to 10 carbon atoms and optionally containing a heteroatom, the other of the R₁ and the R₂ represents a hydrogen atom, and the R₃ and the R₄ each represent a hydrogen atom.

Examples of the alkyl group having 1 to 12 carbon atoms include a methyl group, a trifluoromethyl group, an ethyl group, a propyl group, an isopropyl group, a butyl group, an isobutyl group, a pentyl group, a hexyl group, etc. Examples of the alkoxy group having 1 to 12 carbon atoms include a methoxy group, an ethoxy group, a propoxy group, a butoxy group, a pentoxy group, etc. Examples of the aromatic group having 6 to 12 carbon atoms include a phenyl group, a methylphenyl group, a dimethylphenyl group, an ethylphenyl group, a diethylphenyl group, a propylphenyl group, a butylphenyl group, a fluorophenyl group, a chlorophenyl group, a bromophenyl group, a methoxyphenyl group, a dimethoxyphenyl group, an ethoxyphenyl group, a diethoxyphenyl group, an aminophenyl group, a nitrophenyl group, a cyanophenyl group, a phenethyl group, a phenylpropyl group, a phenylamino group, a diphenylamino group, a biphenyl group, a naphthyl group, etc. Examples of the phenoxy group having 6 to 10 carbon atoms include a methylphenoxy group, an ethylphenoxy group, a propylphenoxy group, a dimethylphenoxy group, a diethylphenoxy group, a methoxyphenoxy group, an ethoxyphenoxy group, a dimethoxyphenoxy group, etc. Examples of the benzyl group having 7 to 10 carbon atoms include a benzyl group, a methylbenzyl group, an ethylbenzyl group, a propylbenzyl group, a dimethylbenzyl group, a diethylbenzyl group, a methoxybenzyl group, an ethoxybenzyl group, a dimethoxybenzyl group, a diethoxybenzyl group, an aminobenzyl group, a nitrobenzyl group, a cyanobenzyl group, etc. Examples of the benzyloxy group having 7 to 10 carbon atoms include a benzyloxy group, a methylbenzyloxy group, an ethylbenzyloxy group, a propylbenzyloxy group, a dimethylbenzyloxy group, a diethylbenzyloxy group, a methoxybenzyloxy group, an ethoxybenzyloxy group, etc.

Out of the above, an aromatic group having 6 to 12 carbon atoms, a phenoxy group having 6 to 10 carbon atoms, a benzyl group having 7 to 10 carbon atoms, and a benzyloxy group having 7 to 10 carbon atoms are preferable, an aromatic group having 6 to 12 carbon atoms is more preferable, and a phenyl group, a methylphenyl group, a dimethylphenyl group, an ethylphenyl group, and a diethylphenyl group are further preferable. It is thought that such an organic group suppresses the free rotation of the polymer chain by the bulkiness of the organic group, thus suppressing the packing effect between molecules, so that suitable interaction between the molecules is achieved and the mechanical properties, especially rupture elongation, of the cured film are improved.

The L in the general formula (1) represents a divalent organic group excluding a -O-C(=O)- bond or a -C(=O)-O- bond or represents a divalent atom, and is not limited. The L is preferably an oxygen atom, a sulfur atom, a carbonyl group, a linear alkylene group having 1 to 15 carbon atoms, or a branched alkylene group having 3 to 15 carbon atoms. In view of the availability of raw materials, an oxygen atom is further preferable. When the L is such an organic group or atom, excellent mechanical properties can be achieved by flexibility being imparted to the polymer chain.

The X₂ in the general formula (2) represents a divalent organic group, and is not limited as long as it is a divalent organic group. The X₂ is preferably a divalent organic group having an aliphatic chain length structure having 4 to 40 carbon atoms, a divalent alicyclic aliphatic group having 4 to 40 carbon atoms, or a divalent aromatic group having 6 to 40 carbon atoms. The X₂ is further preferably a divalent organic group represented by one of the following formulae (10). In addition, the structure of X₂ may be of one kind or a combination of two or more kinds.

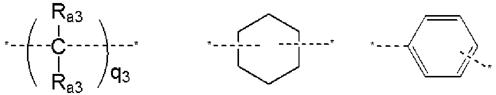

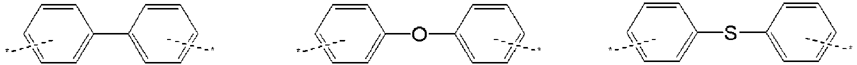

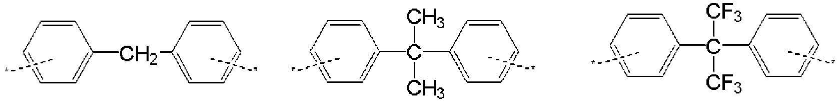

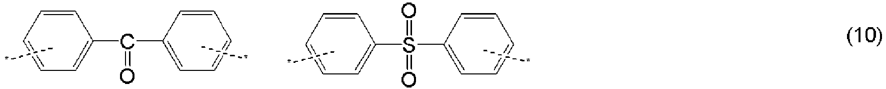

In the formulae, each Rₐ₃ independently represents a hydrogen atom, a fluorine atom, or an alkyl group having 1 to 6 carbon atoms, "q₃" represents an integer of 1 to 30, and a dotted line represents an attachment point.

The R₁ to R₄ and L in the general formula (2) are as defined in the general formula (1).

The X₃ in the general formula (3) represents a tetravalent organic group, is identical to or different from the above-described X₁, and is not limited as long as it is a tetravalent organic group. The X₃ is preferably a tetravalent alicyclic aliphatic group having 4 to 40 carbon atoms or a tetravalent aromatic group having 6 to 40 carbon atoms, and optionally contains a siloxane skeleton. The X₃ is further preferably a tetravalent organic group represented by one of the formulae (9). In addition, the structure of X₃ may be of one kind or a combination of two or more kinds.

The "s" in the general formula (3) represents 0 or 1, and when "s" is 0, the two aromatic rings in the general formula (3) are directly bonded without the intervening divalent bonding group Z.

On the other hand, when "s" is 1, the two aromatic rings in the general formula (3) are bonded via the divalent bonding group Z. The Z is not limited as long as it is a divalent group. Preferably, the Z is a divalent alicyclic aliphatic group having 4 to 40 carbon atoms or a divalent aromatic group having 6 to 40 carbon atoms, further preferably a divalent bonding group represented by one of the following formulae (11). In addition, the structure of Z may be of one kind or a combination of two or more kinds.

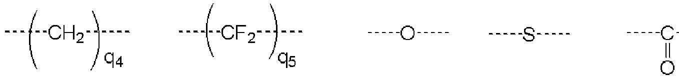

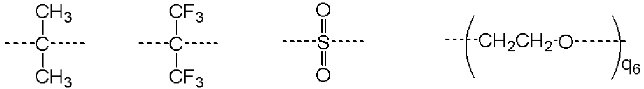

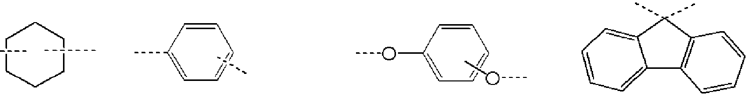

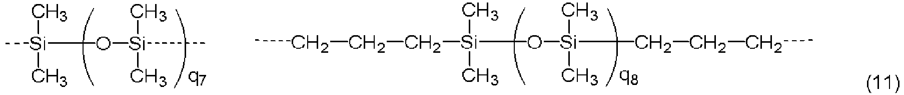

In the formulae, "q₄", "q₅", and "q₆" each represent an integer of 1 to 6, and "q₇" and "qe" each represent an integer of 1 to 10. A dotted line represents an attachment point.

In particular, preferable divalent bonding groups Z are divalent groups represented by the following general formulae (5), (6), (7), and (8). That is, the Z in the general formulae (3) and (4) is preferably at least one bonding group selected from any of the groups represented by the following formulae (5), (6), (7), and (8) .

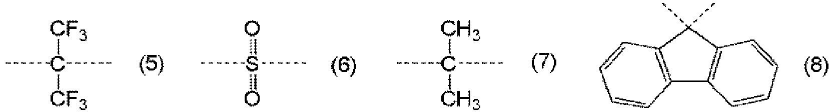

In the formulae, a dotted line represents an attachment point.

Furthermore, a preferable divalent bonding group Z is a divalent group represented by the general formula (5) or (6).

As the structural unit represented by the general formula (3), the structural unit represented by the following general formula (3-1) is preferable when the Z in the general formula (3) is the group represented by the formula (5), and the structural unit represented by the following general formula (3-2) is preferable when the Z in the general formula (3) is the group represented by the formula (6).

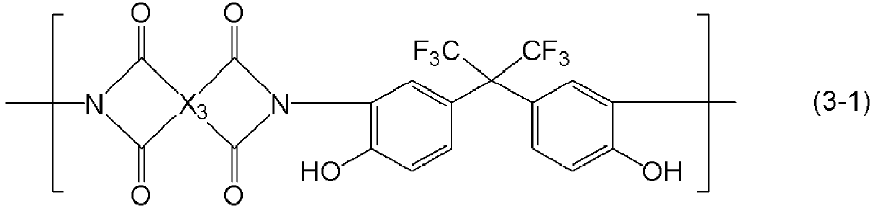

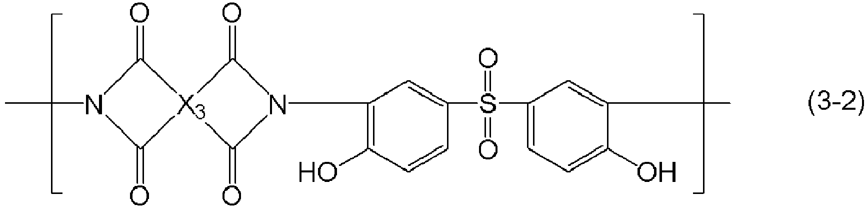

In the formulae, X₃ is as defined above.

When the divalent bonding group Z is the hexafluoropropylene group represented by the formula (5) and is located in the p-position of the phenolic hydroxy group as in the general formula (3-1), the acidity of the phenolic hydroxy group is increased since the hexafluoropropylene group is an electron-withdrawing group, and solubility in the developing solution, being an aqueous alkaline solution, is enhanced. Therefore, such a case is favorable.

Similarly, when the divalent bonding group Z is the sulfonic group represented by the formula (6) and is located in the p-position of the phenolic hydroxy group as in the general formula (3-2), the acidity of the phenolic hydroxy group is increased since the sulfonic group is also an electron-withdrawing group, and solubility in the developing solution, being an aqueous alkaline solution, is enhanced. Therefore, such a case is favorable.

The X₄ in the general formula (4) represents a divalent organic group, is identical to or different from the above-described X₂, and is not limited as long as it is a divalent organic group. The X₄ is preferably a divalent organic group having an aliphatic chain length structure having 4 to 40 carbon atoms, a divalent alicyclic aliphatic group having 4 to 40 carbon atoms, or a divalent aromatic group having 6 to 40 carbon atoms. The X₄ is further preferably a divalent organic group represented by one of the formulae (10). In addition, the structure of X₄ may be of one kind or a combination of two or more kinds.

When the X₄ in the general formula (4) is a divalent organic group having an aliphatic chain length structure, the mechanical strength, especially elongation, of the cured film of the inventive negative photosensitive resin composition is increased, and therefore, such a case is preferable.

The "s" and Z in the general formula (4) are as defined above, and for Z, the general formula (5) or (6) is preferable from the viewpoint of solubility in a developing solution, being an aqueous alkaline solution.

Furthermore, the inventive polymer can further contain, in addition to the structural units represented by the general formulae (1), (2), (3), and (4), any one or more of the structural units represented by the following general formulae (12) to (15).

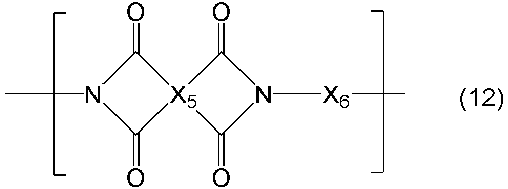

In the formula, X₅ represents a tetravalent organic group identical to or different from the X₁, and X₆ represents a divalent organic group.

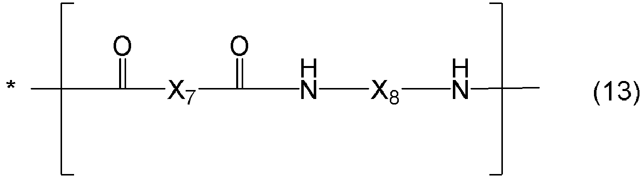

In the formula, X₇ represents a divalent organic group identical to or different from the X₂, and X₈ represents a divalent organic group identical to or different from the X₆.

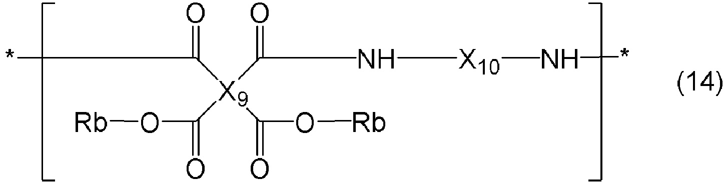

In the formula, X₉ represents a tetravalent organic group identical to or different from the X₁, X₁₀ represents a divalent organic group identical to or different from the X₆, and the Rbs are identical to or different from each other and each represent a hydrogen atom or an organic group having 1 to 10 carbon atoms, optionally contain an intervening heteroatom, and optionally have a substituent.

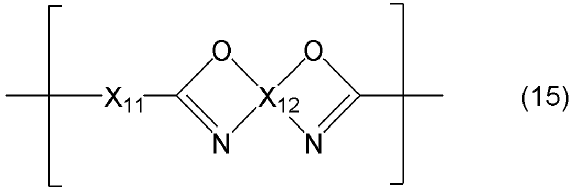

In the formula, X₁₁ represents a divalent organic group identical to or different from the X₂, and X₁₂ represents a tetravalent organic group.

The X₅ in the general formula (12) is a tetravalent organic group and is identical to or different from the above-described X₁, and is not limited as long as it is a tetravalent organic group. The X₅ is preferably a tetravalent alicyclic aliphatic group having 4 to 40 carbon atoms or a tetravalent aromatic group having 6 to 40 carbon atoms, and optionally contains a siloxane skeleton. The X₅ is further preferably a tetravalent organic group represented by one of the formulae (9). In addition, the structure of X₅ may be of one kind or a combination of two or more kinds.

The X₆ in the general formula (12) is a divalent organic group and is not limited as long as it is a divalent organic group. The X₆ is preferably a divalent organic group having 6 to 40 carbon atoms, more preferably a divalent cyclic organic group containing 1 to 4 aromatic rings or aliphatic rings each having a substituent, a divalent aliphatic group not having a cyclic structure, or a siloxane group. Further suitable examples of X₆ include structures represented by the following formulae (16) or (17). In addition, the structure of X₆ may be of one kind or a combination of two or more kinds.

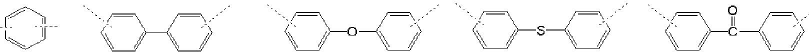

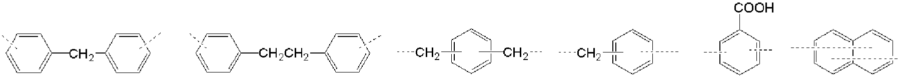

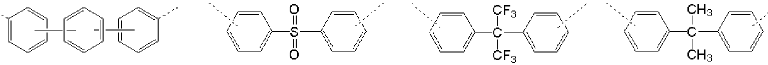

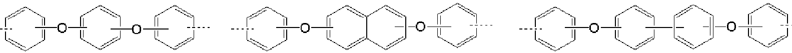

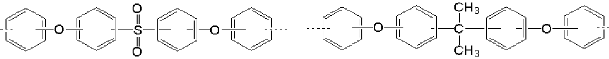

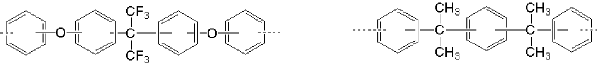

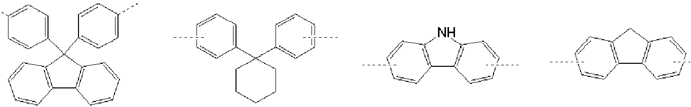

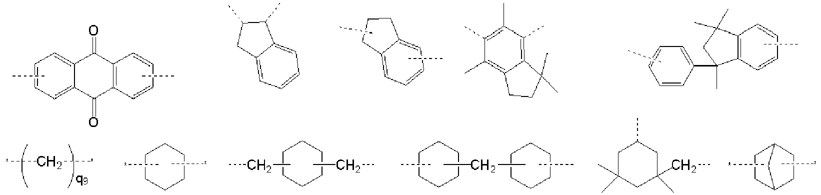

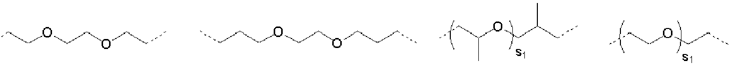

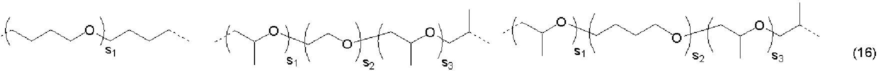

In the formulae, "q₉" represents an integer of 1 to 20, "s₁" represents an integer of 1 to 40, "s₂" and "s₃" each independently represent an integer of 0 to 40, and a dotted line represents an attachment point.

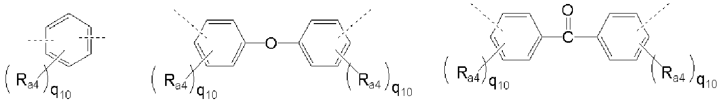

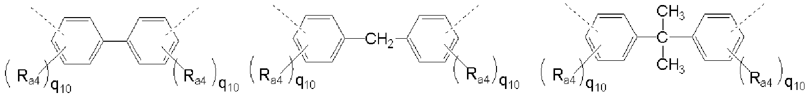

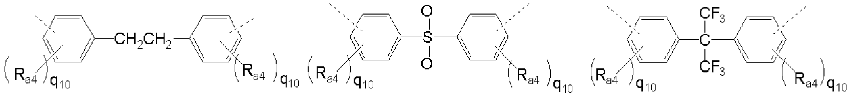

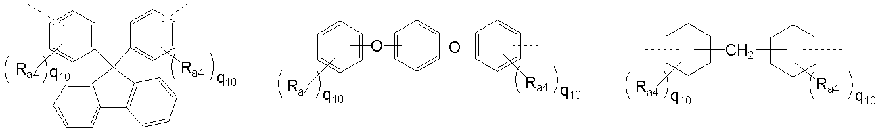

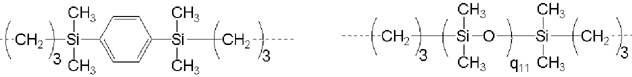

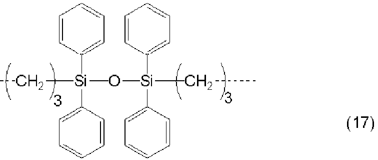

In the formulae, "qio" represents an integer of 1 to 4, Rₐ₄ represents a fluorine atom, a methyl group, an ethyl group, a propyl group, an n-butyl group, a methoxy group, an ethoxy group, a propoxy group, a butoxy group, or a trifluoromethyl group, the Rₐ₄s are identical to or different from each other when "q₁₀" is 2 or more, "q₁₁" represents an integer of 1 to 40, and a dotted line represents an attachment point.

The resin composition containing the polymer containing the structural unit represented by the general formula (12) is preferable because it is possible to enhance the mechanical strength, adhesive force to substrate, and heat resistance of the cured film obtained by patterning. Moreover, the structural unit (12) does not require ring-closing reaction in post-curing, so that the curing reaction temperature can be reduced relatively, which is preferable.

The X₇ in the general formula (13) is a divalent organic group and is identical to or different from the above-described X₂, and is not limited as long as it is a divalent organic group. The X₇ is preferably a divalent organic group having an aliphatic chain length structure having 4 to 40 carbon atoms, a divalent alicyclic aliphatic group having 4 to 40 carbon atoms, or a divalent aromatic group having 6 to 40 carbon atoms. The X₇ is further preferably a divalent organic group represented by one of the formulae (10). In addition, the structure of X₇ may be of one kind or a combination of two or more kinds.

The X₈ in the general formula (13) is a divalent organic group and is identical to or different from the above-described X₆, and is not limited as long as it is a divalent organic group. The X₈ is preferably a divalent organic group having 6 to 40 carbon atoms, more preferably a divalent cyclic organic group containing 1 to 4 aromatic rings or aliphatic rings each having a substituent, a divalent aliphatic group not having a cyclic structure, or a siloxane group. Further preferable examples include structures represented by the formulae (16) or (17). In addition, the structure of X₈ may be of one kind or a combination of two or more kinds.

The resin composition containing the polymer containing the structural unit represented by the general formula (13) is preferable because it is possible to enhance mechanical properties, such as elongation, and adhesive force to substrate of the cured film obtained by patterning.

The X₉ in the general formula (14) is a tetravalent organic group and is identical to or different from the above-described X₁, and is not limited as long as it is a tetravalent organic group. The X₉ is preferably a tetravalent alicyclic aliphatic group having 4 to 40 carbon atoms or a tetravalent aromatic group having 6 to 40 carbon atoms and optionally contains a siloxane skeleton. The X₉ is further preferably a tetravalent organic group represented by one of the formulae (9). In addition, the structure of X₉ may be of one kind or a combination of two or more kinds.

The X₁₀ in the general formula (14) is a divalent organic group and is identical to or different from the above-described X₆, and is not limited as long as it is a divalent organic group. The X₁₀ is preferably a divalent organic group having 6 to 40 carbon atoms, more preferably a divalent cyclic organic group containing 1 to 4 aromatic rings or aliphatic rings each having a substituent, a divalent aliphatic group not having a cyclic structure, or a siloxane group. Further preferable examples include structures represented by the formulae (16) or (17). In addition, the structure of X₁₀ may be of one kind or a combination of two or more kinds.

In the general formula (14), the organic groups of the Rb, having 1 to 10 carbon atoms, are not particularly limited, but can each be, for example, an organic group containing an acryloyl group or a methacryloyl group.

The resin composition containing the polymer containing the structural unit represented by the general formula (14) is preferable because it is possible to enhance mechanical strength and adhesive force to substrate of the cured film.

The X₁₁ in the general formula (15) is a divalent organic group and is identical to or different from the above-described X₂, and is not limited as long as it is a divalent organic group. The X₁₁ is preferably a divalent organic group having an aliphatic chain length structure having 4 to 40 carbon atoms, a divalent alicyclic aliphatic group having 4 to 40 carbon atoms, or a divalent aromatic group having 6 to 40 carbon atoms. The X₁₁ is further preferably a divalent organic group represented by one of the formulae (10). In addition, the structure of X₁₁ may be of one kind or a combination of two or more kinds.

The X₁₂ in the general formula (15) is a tetravalent organic group and is not limited as long as it is a tetravalent organic group. The X₁₂ is preferably a tetravalent organic group having 6 to 40 carbon atoms, more preferably a tetravalent cyclic organic group containing 1 to 4 aromatic rings or aliphatic rings each having a substituent, a tetravalent aliphatic group not having a cyclic structure, or a siloxane group. Further suitable examples of the X₁₂ include structures represented by the following formulae (18). In addition, the structure of X₁₂ may be of one kind or a combination of two or more kinds.

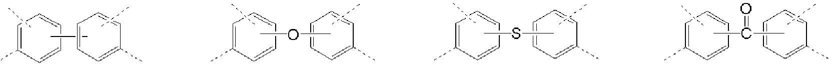

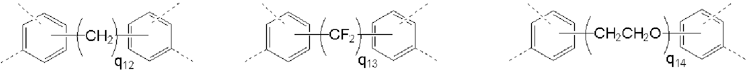

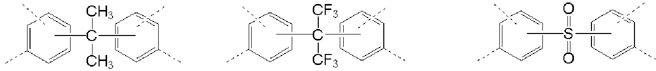

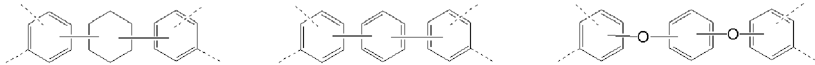

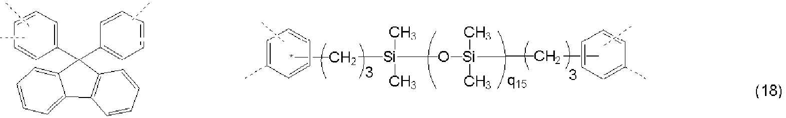

In the formulae, "q₁₂", "q₁₃", and "q₁₄" each represent an integer of 1 to 10, "q₁₅" represents an integer of 1 to 20, and a dotted line represents an attachment point.

The resin composition containing the polymer containing the structural unit represented by the general formula (15) is preferable because it is possible to enhance the mechanical strength, adhesive force to substrate, and heat resistance of the cured film obtained by patterning. Moreover, when the structure represented by the formula (15) is contained, a ring-closure reaction is not required in post-curing, so that the curing reaction temperature can be reduced relatively, which is preferable.

In the polymer, the proportion of the structural unit represented by the general formula (1) and/or (2) and the structural unit represented by the general formula (3) and/or (4) is not particularly limited. For example, the structural unit represented by the general formula (1) and/or (2) may be 1 to 99 mol%, preferably 2 to 50 mol%, more preferably 3 to 20 mol%, and further preferably 5 to 15 mol% relative to a total of 100 mol% of the structural units of the general formulae (1) to (4) .

In addition, the polymer may contain only structural units represented by the general formulae (1) to (4) (except for the terminal moieties), or may contain other structural units (for example, structural units represented by the general formulae (12) to (15)) in addition to the structural units represented by the general formulae (1) to (4) as described above. The proportion of the structural units represented by the general formulae (1) to (4) contained in the polymer is not particularly limited, and for example, can be 60 to 100 mol%, preferably 80 to 100 mol% relative to a total of 100 mol% of the structural units contained in the polymer.

### [Method for Manufacturing Polymer]

The inventive polymer contains: a structural unit represented by the following general formula (1) and/or (2); and a structural unit represented by the following general formula (3) and/or (4). Hereinafter, these structural units are also referred to as structural units (1) to (4).

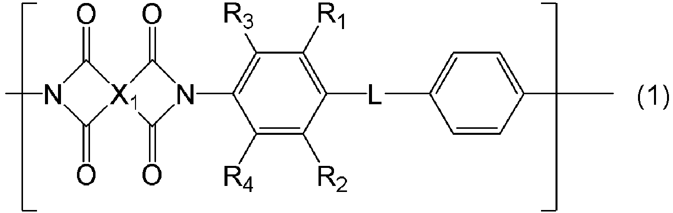

In the formula, X₁, R₁ to R₄, and L are as defined above.

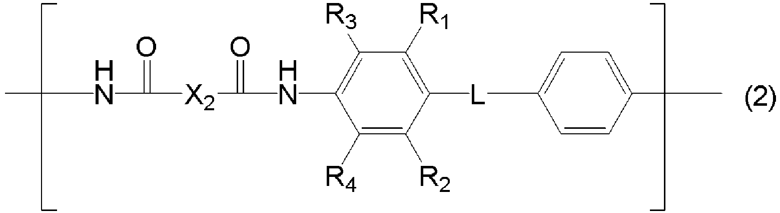

In the formula, X₂, R₁ to R₄, and L are as defined above.

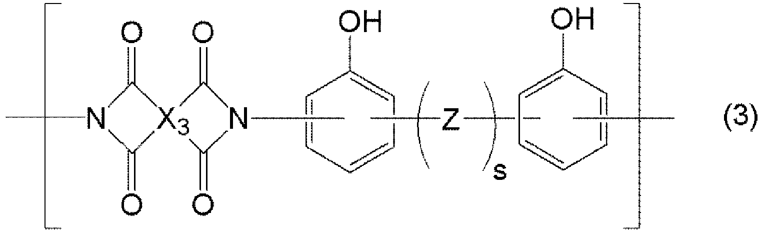

In the formula, X₃, Z, and "s" are as defined above.

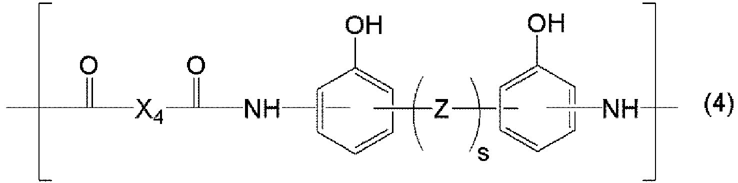

In the formula, X₄, Z, and "s" are as defined above.

A polymer containing the structural unit represented by the general formula (1) can be obtained by allowing a tetracarboxylic dianhydride represented by the following general formula (19) to react with a diamine represented by the following general formula (20). Firstly, a tetracarboxylic dianhydride represented by the following general formula (19) is allowed to react with a diamine represented by the following general formula (20) to synthesize an amic acid, and then subsequently, an imide ring is formed through thermal dehydration to give a polymer containing the structural unit (1).

The structural unit (1) can be prepared by: dissolving a diamine in a solvent that has a high boiling point and high polarity, such as γ-butyrolactone and N-methyl-2-pyrrolidone; then adding an acid anhydride thereto and carrying out a reaction of the resultant mixture at 0 to 80°C, preferably 10 to 50°C, to form an amic acid; then adding a non-polar solvent, such as xylene, thereto; and heating the reaction solution at 100 to 200°C, preferably 130 to 180°C, thereby carrying out imidization reaction while removing water from the reaction system.

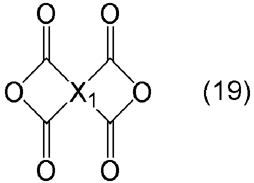

In the formula, X₁ is as defined above.

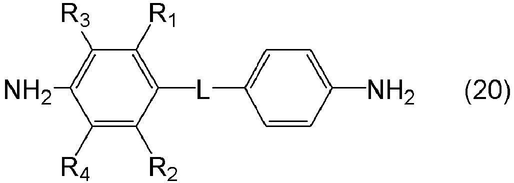

In the formula, R₁ to R₄ and L are as defined above.

Suitable examples of the tetracarboxylic dianhydride represented by the general formula (19) include aromatic acid dianhydrides, alicyclic acid dianhydrides, aliphatic acid dianhydrides, siloxane skeleton-containing acid dianhydrides, etc.

Examples of the aromatic acid dianhydride include, but are not limited to, for example, pyromellitic dianhydride, 3,3',4,4'-biphenyltetracarboxylic dianhydride, 2,3,3',4'-biphenyltetracarboxylic dianhydride, 2,3,2',3'-biphenyltetracarboxylic dianhydride, 3,3',4,4'-terphenyltetracarboxylic dianhydride, 3,3',4,4'-oxyphthalic dianhydride, 2,3,3',4'-oxyphthalic dianhydride, 2,3,2',3'-oxyphthalic dianhydride, diphenylsulfone-3,3',4,4'-tetracarboxylic dianhydride, benzophenone-3,3',4,4'-tetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,4-(3,4-dicarboxyphenoxy)benzene dianhydride, p-phenylenebis(trimellitic acid monoester acid anhydride), bis(1,3-dioxo-1,3-dihydroisobenzfuran-5-carboxylic acid)1,4-phenylene, 2,2-bis(4-(4-aminophenoxy)phenyl)propane, 1,2,5,6-naphthalenetetracarboxylic dianhydride, 2,3,6,7-naphthalenetetracarboxylic dianhydride, 9,9-bis(3,4-dicarboxyphenyl)fluorene dianhydride, 9,9-bis(4-(3,4-dicarboxyphenoxy)phenyl)fluorene dianhydride, 2,3,5,6-pyridinetetracarboxylic dianhydride, 3,4,9,10-perylenetetracarboxylic dianhydride, 2,2-bis(3,4-dicarboxyphenyl)hexafluoropropane dianhydride, 2,2-bis(4-(3,4-dicarboxybenzoyloxy)phenyl)hexafluoropropane dianhydride, 1,6-difluoropyromellitic dianhydride, 1-trifluoromethylpyromellitic dianhydride, 1,6-ditrifluoromethylpyromellitic dianhydride, 2,2'-bis(trifluoromethyl)-4,4'-bis(3,4-dicarboxyphenoxy)biphenyl dianhydride, 2,2'-bis[(dicarboxyphenoxy)phenyl]propane dianhydride, 2,2'-bis[ (dicarboxyphenoxy)phenyl]hexafluoropropane dianhydride, and acid dianhydride compounds formed by substituting aromatic rings of the above compounds with an alkyl group, an alkoxy group, a halogen atom, or the like.

Examples of the alicyclic acid dianhydride include, but are not limited to, for example, 1,2,3,4-cyclobutanetetracarboxylic dianhydride, 1,2,3,4-cyclopentanetetracarboxylic dianhydride, 1,2,4,5-cyclohexanetetracarboxylic dianhydride, 1,2,4,5-cyclopentanetetracarboxylic dianhydride, 1,2,3,4-tetramethyl-1,2,3,4-cyclobutanetetracarboxylic dianhydride, 1,2-dimethyl-1,2,3,4-cyclobutanetetracarboxylic dianhydride, 1,3-dimethyl-1,2,3,4-cyclobutanetetracarboxylic dianhydride, 1,2,3,4-cycloheptanetetracarboxylic dianhydride, 2,3,4,5-tetrahydrofurantetracarboxylic dianhydride, 3,4-dicarboxy-1-cyclohexylsuccinic dianhydride, 2,3,5-tricarboxycyclopentylacetic dianhydride, 3,4-dicarboxy-1,2,3,4-tetrahydro-1-naphthalenesuccinic dianhydride, bicyclo[3.3.0]octane-2,4,6,8-tetracarboxylic dianhydride, bicyclo[4.3.0]nonane-2,4,7,9-tetracarboxylic dianhydride, bicyclo[4.4.0]decane-2,4,7,9-tetracarboxylic dianhydride, bicyclo[4.4.0]decane-2,4,8,10-tetracarboxylic dianhydride, tricyclo[6.3.0.0^{2,6}]undecane-3,5,9,11-tetracarboxylic dianhydride, bicyclo[2.2.2]octane-2,3,5,6-tetracarboxylic dianhydride, bicyclo[2.2.2]oct-7-ene-2,3,5,6-tetracarboxylic dianhydride, bicyclo[2.2.1]heptanetetracarboxylic dianhydride, bicyclo[2.2.1]heptane-5-carboxymethyl-2,3,6-tricarboxylic dianhydride, 7-oxabicyclo[2.2.1]heptane-2,4,6,8-tetracarboxylic dianhydride, octahydronaphthalene-1,2,6,7-tetracarboxylic dianhydride, tetradecahydroanthracene-1,2,8,9-tetracarboxylic dianhydride, 3,3',4,4'-dicyclohexanetetracarboxylic dianhydride, 3,3',4,4'-oxydicyclohexanetetracarboxylic dianhydride, 5-(2,5-dioxotetrahydro-3-furanyl)-3-methyl-3-cyclohexene-1,2-dicarboxylic anhydride, and "RIKACID" (Registered Trademark) BT-100 (trade name, manufactured by New Japan Chemical Co., Ltd.) and derivatives thereof, or acid dianhydride compounds formed by substituting aliphatic rings of the above compounds with an alkyl group, an alkoxy group, a halogen atom or the like.

Examples of the aliphatic acid dianhydride include, but are not limited to, for example, 1,2,3,4-butanetetracarboxylic dianhydride, 1,2,3,4-pentanetetracarboxylic dianhydride, and derivatives thereof.

Examples of the siloxane skeleton-containing acid dianhydride include, but are not limited to, for example, 1,3-bis(3,4-dicarboxyphenyl)-1,1,3,3-tetramethyldisiloxane dianhydride, 3,3'-((1,1,3,3-tetramethyl-1,3-disiloxanediyl)di-3,1-propanediyl)bis(dihydro-2,5-furandione), and derivatives thereof.

Any one of these aromatic acid dianhydrides, alicyclic acid dianhydrides, aliphatic acid dianhydrides, or siloxane skeleton-containing acid dianhydrides may be used, or two or more thereof may be used in combination.

Suitable examples of the diamine represented by the general formula (20) include, but are not limited to 4-(4-aminophenoxy)-3-methylbenzenamine, 4-(4-aminophenoxy)-2-methylbenzenamine, 4-(4-aminophenoxy)-3-ethylbenzenamine, 4-(4-aminophenoxy)-2-ethylbenzenamine, 4-(4-aminophenoxy)-3-propylbenzenamine, 4-(4-aminophenoxy)-2-propylbenzenamine, 4-(4-aminophenoxy)-3-isopropylbenzenamine, 4-(4-aminophenoxy)-2-isopropylbenzenamine, 4-(4-aminophenoxy)-3-butylbenzenamine, 4-(4-aminophenoxy)-2-butylbenzenamine, 4-(4-aminophenoxy)-3-isobutylbenzenamine, 4-(4-aminophenoxy)-2-isobutylbenzenamine, 4-(4-aminophenoxy)-3-pentylbenzenamine, 4-(4-aminophenoxy)-2-pentylbenzenamine, 4-(4-aminophenoxy)-3-hexylbenzenamine, 4-(4-aminophenoxy)-2-hexylbenzenamine, 4-(4-aminophenoxy)-3-(trifluoromethyl)benzenamine, 4-(4-aminophenoxy)-2-(trifluoromethyl)benzenamine, 4-(4-aminophenoxy)-3-methoxybenzenamine, 4-(4-aminophenoxy)-2-methoxybenzenamine, 4-(4-aminophenoxy)-3-ethoxybenzenamine, 4-(4-aminophenoxy)-2-ethoxybenzenamine, 4-(4-aminophenoxy)-3-propoxybenzenamine, 4-(4-aminophenoxy)-2-propoxybenzenamine, 4-(4-aminophenoxy)-3-butoxybenzenamine, 4-(4-aminophenoxy)-2-butoxybenzenamine, 4-(4-aminophenoxy)-3-phenylbenzenamine, 4-(4-aminophenoxy)-2-phenylbenzenamine, 4-(4-aminophenoxy)-3-methylphenylbenzenamine, 4-(4-aminophenoxy)-2-methylphenylbenzenamine, 4-(4-aminophenoxy)-3-ethylphenylbenzenamine, 4-(4-aminophenoxy)-2-ethylphenylbenzenamine, 4-(4-aminophenoxy)-3-propylphenylbenzenamine, 4-(4-aminophenoxy)-2-propylphenylbenzenamine, 4-(4-aminophenoxy)-3-butylphenylbenzenamine, 4-(4-aminophenoxy)-2-butylphenylbenzenamine, 4-(4-aminophenoxy)-3-fluorophenylbenzenamine, 4-(4-aminophenoxy)-2-fluorophenylbenzenamine, 4-(4-aminophenoxy)-3-chlorophenylbenzenamine, 4-(4-aminophenoxy)-2-chlorophenylbenzenamine, 4-(4-aminophenoxy)-3-bromophenylbenzenamine, 4-(4-aminophenoxy)-2-bromophenylbenzenamine, 4-(4-aminophenoxy)-3-methoxyphenylbenzenamine, 4-(4-aminophenoxy)-2-methoxyphenylbenzenamine, 4-(4-aminophenoxy)-3-ethoxyphenylbenzenamine, 4-(4-aminophenoxy)-2-ethoxyphenylbenzenamine, 4-(4-aminophenoxy)-3-(phenylethyl)phenylbenzenamine, 4-(4-aminophenoxy)-2-(phenylethyl)phenylbenzenamine, 4-(4-aminophenoxy)-3-naphthylphenylbenzenamine, 4-(4-aminophenoxy)-2-naphthylphenylbenzenamine, 4-(4-aminophenoxy)-3-benzylphenylbenzenamine, 4-(4-aminophenoxy)-2-benzylphenylbenzenamine, 4-((4-aminophenyl)thio)-3-methylbenzenamine, 4-((4-aminophenyl)thio)-2-methylbenzenamine, 4-((4-aminophenyl)thio)-3-ethylbenzenamine, 4-((4-aminophenyl)thio)-2-ethylbenzenamine, 4-((4-aminophenyl)thio)-3-propylbenzenamine, 4-((4-aminophenyl)thio)-2-propylbenzenamine, 4-((4-aminophenyl)thio)-3-isopropylbenzenamine, 4-((4-aminophenyl)thio)-2-isopropylbenzenamine, 4-((4-aminophenyl)thio)-3-butylbenzenamine, 4-((4-aminophenyl)thio)-2-butylbenzenamine, 4-((4-aminophenyl)thio)-3-isobutylbenzenamine, 4-((4-aminophenyl)thio)-2-isobutylbenzenamine, 4-((4-aminophenyl)thio)-3-(trifluoromethyl)benzenamine, 4-((4-aminophenyl)thio)-2-(trifluoromethyl)benzenamine, 4-((4-aminophenyl)thio)-3-methoxybenzenamine, 4-((4-aminophenyl)thio)-2-methoxybenzenamine, 4-((4-aminophenyl)thio)-3-ethoxybenzenamine, 4-((4-aminophenyl)thio)-2-ethoxybenzenamine, 4-((4-aminophenyl)thio)-3-propoxybenzenamine, 4-((4-aminophenyl)thio)-2-propoxybenzenamine, 4-((4-aminophenyl)thio)-3-isopropoxybenzenamine, 4-((4-aminophenyl)thio)-2-isopropoxybenzenamine, 4-((4-aminophenyl)thio)-3-butoxybenzenamine, 4-((4-aminophenyl)thio)-2-butoxybenzenamine, 4-((4-aminophenyl)thio)-3-phenylbenzenamine, 4-((4-aminophenyl)thio)-2-phenylbenzenamine, 4-((4-aminophenyl)thio)-3-naphthylbenzenamine, 4-((4-aminophenyl)thio)-2-naphthylbenzenamine, 4-((4-aminophenyl)thio)-3-methoxyphenylbenzenamine, 4-((4-aminophenyl)thio)-2-methoxyphenylbenzenamine, 4-((4-aminophenyl)methyl)-3-methylbenzenamine, 4-((4-aminophenyl)methyl)-2-methylbenzenamine, 4-((4-aminophenyl)methyl)-3-ethylbenzenamine, 4-((4-aminophenyl)methyl)-2-ethylbenzenamine, 4-((4-aminophenyl)methyl)-3-propylbenzenamine, 4-((4-aminophenyl)methyl)-2-propylbenzenamine, 4-((4-aminophenyl)methyl)-3-isopropylbenzenamine, 4-((4-aminophenyl)methyl)-2-isopropylbenzenamine, 4-((4-aminophenyl)methyl)-3-butylbenzenamine, 4-((4-aminophenyl)methyl)-2-butylbenzenamine, 4-((4-aminophenyl)methyl)-3-isobutylbenzenamine, 4-((4-aminophenyl)methyl)-2-isobutylbenzenamine, 4-((4-aminophenyl)methyl)-3-(trifluoromethyl)benzenamine, 4-((4-aminophenyl)methyl)-2-(trifluoromethyl)benzenamine, 4-((4-aminophenyl)methyl)-3-methoxybenzenamine, 4-((4-aminophenyl)methyl)-2-methoxybenzenamine, 4-((4-aminophenyl)methyl)-3-ethoxybenzenamine, 4-((4-aminophenyl)methyl)-2-ethoxybenzenamine, 4-((4-aminophenyl)methyl)-3-propoxybenzenamine, 4-((4-aminophenyl)methyl)-2-propoxybenzenamine, 4-((4-aminophenyl)methyl)-3-isopropoxybenzenamine, 4-((4-aminophenyl)methyl)-2-isopropoxybenzenamine, 4-((4-aminophenyl)methyl)-3-butoxybenzenamine, 4-((4-aminophenyl)methyl)-2-butoxybenzenamine, 4-((4-aminophenyl)methyl)-3-phenylbenzenamine, 4-((4-aminophenyl)methyl)-2-phenylbenzenamine, 4-((4-aminophenyl)methyl)-3-naphthylbenzenamine, 4-((4-aminophenyl)methyl)-2-naphthylbenzenamine, 4-((4-aminophenyl)methyl)-3-methoxyphenylbenzenamine, 4-((4-aminophenyl)methyl)-2-methoxyphenylbenzenamine, (4-amino-2-methylphenyl)(4-aminophenyl)methanone, (4-amino-2-ethylphenyl)(4-aminophenyl)methanone, (4-amino-2-propylphenyl)(4-aminophenyl)methanone, (4-amino-2-isopropylphenyl)(4-aminophenyl)methanone, (4-amino-2-butylphenyl) (4-aminophenyl)methanone, (4-amino-2-(trifluoromethyl)phenyl) (4-aminophenyl)methanone, 4-amino-2-methoxyphenyl) (4-aminophenyl)methanone, 4-amino-2-ethoxyphenyl)(4-aminophenyl)methanone, (4-amino-2-(phenyl)phenyl)(4-aminophenyl)methanone, and (4-amino-2-(methoxyphenyl)phenyl) (4-aminophenyl)methanone.

Meanwhile, a polymer containing a structural unit represented by the general formula (2) can be obtained by a reaction of a dicarboxylic acid compound represented by the following general formula (21) with a diamine represented by the general formula (20).

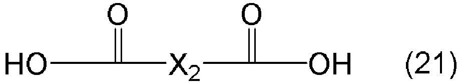

In the formula, X₂ is as defined above.

Here, the polymer containing the structural unit (2) can be obtained by, for example, reacting a dicarboxylic acid compound represented by the general formula (21) with a diamine represented by the general formula (20) in the presence of a dehydration condensation agent. That is, the polymer containing the structural unit (2) can be obtained by using the dicarboxylic acid compound represented by the general formula (21) for the reaction in the state of being dissolved in a reaction solvent; adding into this reaction solution a known dehydration condensation agent (for example, dicyclohexylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate or the like) and mixing the resultant mixture under ice cooling to make the dicarboxylic acid compound represented by the general formula (21) into an acid anhydride; and then adding dropwise to this the diamine represented by the general formula (20) that has been dissolved or dispersed in a solvent separately to carry out the polycondensation.

In addition, examples of other methods of obtaining the polymer containing the structural unit (2) by reacting the dicarboxylic acid compound represented by the general formula (21) with the diamine (diamine compound) represented by the general formula (20) include a process in which the polymer is synthesized by converting the dicarboxylic acid compound represented by the general formula (21) into an acid chloride with using a chlorinating agent such as thionyl chloride or oxalyl chloride, and reacting the acid chloride with the diamine represented by the general formula (20).

In the reaction in which the dicarboxylic acid compound is converted into an acid chloride with using a chlorinating agent, a basic compound may be further used. For this basic compound, for example, pyridine, N,N-dimethyl-4-aminopyridine, triethylamine, or the like can be used.

Then, by reacting the obtained acid chloride of the dicarboxylic acid compound with the diamine represented by the general formula (20) in the presence of a basic catalyst, the target polymer containing the structural unit (2) can be obtained. Upon this, examples of the basic catalyst include pyridine, N,N-dimethyl-4-aminopyridine, 1,8-diazabicyclo[5.4.0]undec-7-ene, 1,5-diazabicyclo[4.3.0]non-5-ene, etc. Any one of these basic catalysts may be used, or two or more thereof may be used in combination.

In the method of producing the inventive polymer, the preferable solvent to be used in the process through the acid chloride well dissolves the above-described dicarboxylic acid compound and an acid chloride thereof, as well as the polymer obtained through the polycondensation reaction of them with the diamine. Specific examples thereof include N-methyl-2-pyrrolidone, N,N-dimethylacetamide, N,N-dimethylformamide, dimethylsulfoxide, tetramethylurea, hexamethylphosphoric triamide and γ-butyrolactone. In addition, other than polar solvents, ketones, esters, lactones, ethers, halogenated hydrocarbons, hydrocarbons and the like can also be used. Examples thereof include acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, xylene, etc. Any one of these organic solvents may be used, or two or more thereof may be used in combination.

Suitable examples of the X₂ in the dicarboxylic acid compound represented by the general formula (21) may include the same examples as those mentioned above.

In addition, examples of the dicarboxylic acid compound represented by the general formula (21) include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, etc.

Further, examples of the dicarboxylic acid compound having an aromatic ring include, but are not limited to phthalic acid, isophthalic acid, terephthalic acid, 4,4'-diphenyl ether dicarboxylic acid, 3,4'-diphenyl ether dicarboxylic acid, 3,3'-diphenyl ether dicarboxylic acid, 4,4'-biphenyldicarboxylic acid, 3,4'-biphenyldicarboxylic acid, 3,3'-biphenyldicarboxylic acid, 4,4'-benzophenonedicarboxylic acid, 3,4'-benzophenonedicarboxylic acid, 3,3'-benzophenonedicarboxylic acid, 4,4'-hexafluoroisopropylidenedibenzoic acid, 4,4'-dicarboxydiphenylamide, 1,4-phenylenediethanoic acid, bis(4-carboxyphenyl)sulfide, 2,2-bis(4-carboxyphenyl)-1,1,1,3,3,3-hexafluoropropane, bis (4-carboxyphenyl)tetraphenyldisiloxane, bis(4-carboxyphenyl)tetramethyldisiloxane, bis(4-carboxyphenyl)sulfone, bis(4-carboxyphenyl)methane, 5-tert-butylisophthalic acid, 5-bromoisophthalic acid, 5-fluoroisophthalic acid, 5-chloroisophthalic acid, 2,2-bis-(p-carboxyphenyl)propane, and 2,6-naphthalenedicarboxylic acid, etc. In addition, they may be used singly or mixed for use.

Meanwhile, a polymer containing the structural unit (3) can be obtained by performing the same reaction procedure as in the case of the structural unit (1). That is, the polymer can be obtained by allowing a reaction between a tetracarboxylic dianhydride represented by the following general formula (22) and a diamine represented by the following general formula (23). Firstly, a tetracarboxylic dianhydride represented by the following general formula (22) is allowed to react with a diamine represented by the following general formula (23) to synthesize an amic acid, and then subsequently, an imide ring is formed through thermal dehydration to give a polymer containing the structural unit (3).

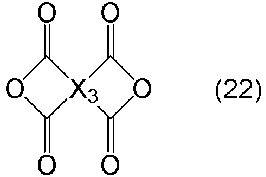

In the formula, X₃ is as defined above.

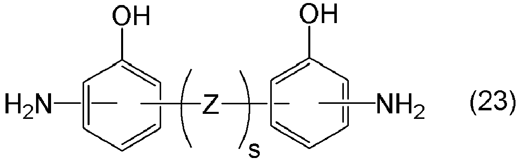

In the formula, "s" and Z are as defined above.

Suitable examples of the tetracarboxylic dianhydride represented by the general formula (22) include the examples given for the tetracarboxylic dianhydride represented by the general formula (19).

Meanwhile, the "s" in the general formula (23) represents 0 or 1, and when s=0, the two aromatic rings in the general formula (23) are bonded to each other directly without an intervening divalent bonding group Z.

Meanwhile, when the "s" in the general formula (23) satisfies s=1, the Z in the general formula (23) is not limited as long as it is a divalent group. The Z is preferably a divalent alicyclic aliphatic group having 4 to 40 carbon atoms or a divalent aromatic group having 6 to 40 carbon atoms as described above, further preferably a divalent bonding group represented by one of the formulae (11). In addition, the structure of Z may be of one kind or a combination of two or more kinds.

Furthermore, suitable examples of the diamine represented by the general formula (23) are compounds represented by the following formulae (24), (25), (26), and (27) .

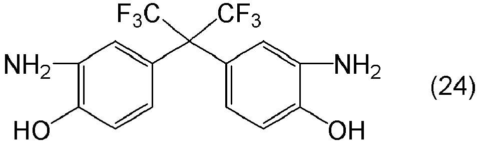

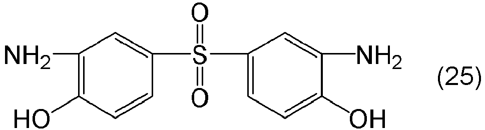

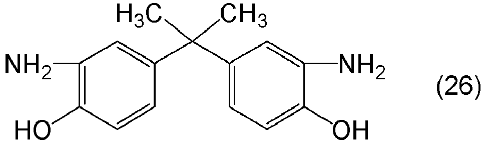

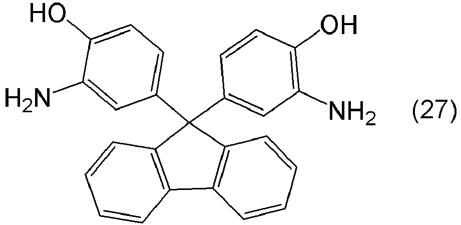

Furthermore, particularly suitable examples of the diamine represented by the general formula (23) are compounds represented by the formulae (24) and (25).

A polymer obtained by allowing the diamine represented by the formula (24) to react with a tetracarboxylic dianhydride represented by the general formula (22) contains a structural unit represented by the general formula (3-1), which is a favorable structural unit.

Meanwhile, a polymer obtained by allowing the diamine represented by the formula (25) to react with a tetracarboxylic dianhydride represented by the general formula (22) contains a structural unit represented by the general formula (3-2), which is a favorable structural unit.

Meanwhile, a polymer containing the structural unit (4) can be obtained by performing the same reaction procedure as in the case of the structural unit (2). That is, the polymer can be obtained by reacting a dicarboxylic acid compound represented by the following general formula (28) in the presence of a dehydration condensation agent or using a chlorinating agent to convert the compound into an acid chloride, and then reacting the acid chloride with a diamine represented by the general formula (23).

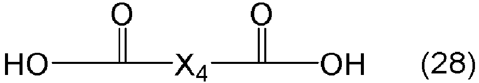

In the formula, X₄ is as defined above.

Favorable examples of the dicarboxylic acid compound represented by the general formula (28) include the examples given for the dicarboxylic acid compound represented by the general formula (21).

Furthermore, as stated above, the inventive polymer can further contain, in addition to the structural units represented by the general formulae (1), (2), (3), and (4), a structural unit represented by the following general formula (12).

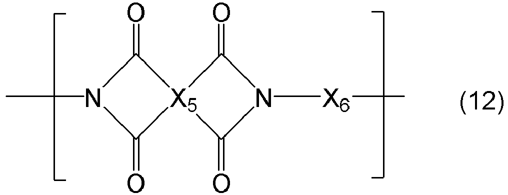

In the formula, X₅ and X₆ are as defined above.

A polymer containing the structural unit represented by the general formula (12) can be obtained by performing the same reaction procedure as in the case of the structural unit (1). That is, the polymer containing the structural unit represented by the general formula (12) can be obtained by allowing a reaction between a tetracarboxylic dianhydride represented by the following general formula (29) and a diamine represented by the following general formula (30) to synthesize an amic acid, and then forming an imide ring through a thermal dehydration process.

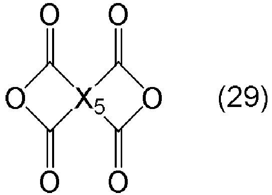

In the formula, X₅ is as defined above.

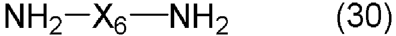

In the formula, X₆ is as defined above.

Suitable examples of the tetracarboxylic dianhydride represented by the general formula (29) include the examples given for the tetracarboxylic dianhydride represented by the general formula (19).

Examples of the diamine represented by the general formula (30) include aromatic diamines, alicyclic diamines, aliphatic diamines, polyether diamines, etc.

Examples of favorable aromatic diamines include, but are not limited to, 3,4'-diaminodiphenyl ether, 4,4'-diaminodiphenyl ether, 3,4'-diaminodiphenylmethane, 4,4'-diaminodiphenylmethane, 3,3'-diaminodiphenylsulfone, 3,4'-diaminodiphenylsulfone, 4,4'-diaminodiphenylsulfone, 3,4'-diaminodiphenylsulfide, 4,4'-diaminodiphenylsulfide, 1,4-bis(4-aminophenoxy)benzene, benzidine, 2,2'-bis(trifluoromethyl)benzidine, 3,3'-bis(trifluoromethyl)benzidine, 2,2'-dimethylbenzidine, 3,3'-dimethylbenzidine, 2,2'3,3'-tetramethylbenzidine, 2,2'-dichlorobenzidine, 3,3'-dichlorobenzidine, 2,2'3,3'-tetrachlorobenzidine, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis[4-(3-aminophenoxy)phenyl]sulfone, bis(4-aminophenoxy)biphenyl, bis{4-(4-aminophenoxy)phenyl} ether, 1,4-bis(4-aminophenoxy)benzene, 9,9-bis(4-aminophenyl)fluorene, 2,2'-bis[3-(3-aminobenzamide)-4-hydroxyphenyl]hexafluoropropane, 4-aminophenyl-4'-aminobenzoate, 4,4'-diaminobenzanilide, diamine compounds in which an aromatic ring of these compounds is substituted with an alkyl group, an alkoxy group, a halogen atom, or the like, etc.

Examples of alicyclic diamines include, but are not limited to, cyclobutanediamine, isophoronediamine, bicyclo[2,2,1]heptanebismethylamine, tricyclo[3,3,1,1^{3,7}]decane-1,3-diamine, 1,2-cyclohexyldiamine, 1,3-cyclohexyldiamine, 1,4-diaminocyclohexane, trans-1,4-diaminocyclohexane, cis-1,4-diaminocyclohexane, 4,4'-diaminodicyclohexylmethane, 3,3'-dimethyl-4,4'-diaminodicyclohexylmethane, 3,3'-diethyl-4,4'-diaminodicyclohexylmethane, 3,3',5,5'-tetramethyl-4,4'-diaminodicyclohexylmethane, 3,3',5,5'-tetraethyl-4,4'-diaminodicyclohexylmethane, 3,5-diethyl-3',5'-dimethyl-4,4'-diaminodicyclohexylmethane, 4,4'-diaminodicyclohexyl ether, 3,3'-dimethyl-4,4'-diaminodicyclohexyl ether, 3,3'-diethyl-4,4'-diaminodicyclohexyl ether, 3,3',5,5'-tetramethyl-4,4'-diaminodicyclohexyl ether, 3,3',5,5'-tetraethyl-4,4'-diaminodicyclohexyl ether, 3,5-diethyl-3',5'-dimethyl-4,4'-diaminodicyclohexyl ether, 2,2-bis(4-aminocyclohexyl)propane, 2,2-bis(3-methyl-4-aminocyclohexyl)propane, 2,2-bis(3-ethyl-4-aminocyclohexyl)propane, 2,2-bis(3,5-dimethyl-4-aminocyclohexyl)propane, 2,2-bis(3,5-diethyl-4-aminocyclohexyl)propane, 2,2-(3,5-diethyl-3',5'-dimethyl-4,4'-diaminodicyclohexyl)propane, diamine compounds in which an aliphatic ring of these compounds is substituted with an alkyl group, an alkoxy group, a halogen atom, or the like, etc.

Examples of aliphatic diamines include, but are not limited to: alkylene diamines, such as ethylenediamine, 1,3-diaminopropane, 1,4-diaminobutane, 1,5-diaminopentane, 1,6-diaminohexane, 1,7-diaminoheptane, 1,8-diaminooctane, 1,9-diaminononane, and 1,10-diaminodecane; bis(aminomethyl) ether; bis(2-aminoethyl) ether; siloxane diamines such as 1,3-bis(3-aminopropyl)tetramethyldisiloxane, 1,3-bis(4-aminobutyl)tetramethyldisiloxane, and α,ω-bis(3-aminopropyl)polydimethylsiloxane; etc.

Examples of polyether diamines include, but are not limited to, 1,2-bis(aminoethoxy)ethane, HK-511, ED-600, ED-900, ED-2003, EDR-148, EDR-176, D-230, D-400, D-2000, THF-100, THF-140, THF-170, RE-600, RE-900, RE-2000, RP-405, RP-409, RP-2005, RP-2009, RT-1000, HE-1000, HT-1700 (trade names, manufactured by Huntsman Corporation), etc. One of these may be used, or they may be used in mixture.

One of these aromatic diamines, alicyclic diamines, aliphatic diamines, and polyether diamines can be used, or two or more kinds thereof may be used in combination.

Siloxane diamines can also be used suitably.

Furthermore, as stated above, the inventive polymer can further contain, in addition to the structural units represented by the general formulae (1), (2), (3), and (4), a structural unit represented by the following general formula (13).

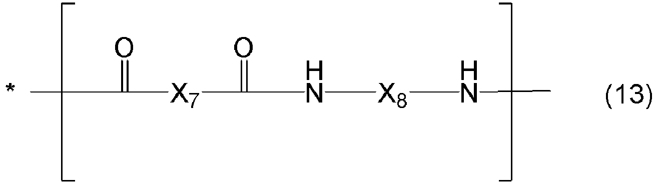

In the formula, X₇ and X₈ are as defined above.

A polymer containing the structural unit represented by the general formula (13) can be obtained by performing the same reaction procedure as in the case of the structural unit (2). That is, the polymer can be obtained by reacting a dicarboxylic acid compound represented by the following general formula (31) in the presence of a dehydration condensation agent or using a chlorinating agent to convert the compound into an acid chloride, and then reacting the acid chloride with a diamine represented by the following general formula (32) .

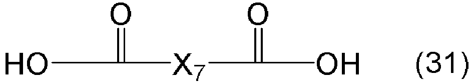

In the formula, X₇ is as defined above.

NH₂-X₈-NH₂ (32)

In the formula, X₈ is as defined above.

Favorable examples of the dicarboxylic acid compound represented by the general formula (31) include the examples given for the dicarboxylic acid compound represented by the general formula (21).

Meanwhile, favorable examples of the diamine represented by the general formula (32) include the examples given for the diamine represented by the general formula (30).

Furthermore, as stated above, the inventive polymer can further contain, in addition to the structural units represented by the general formulae (1), (2), (3), and (4), a structural unit represented by the following general formula (14).

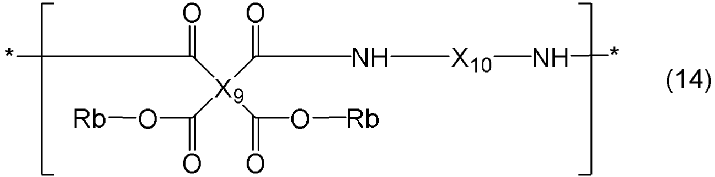

In the formula, X₉, X₁₀, and R_{b} are as defined above.

A polymer containing the structural unit represented by the general formula (14) can be obtained by performing the same reaction procedure as in the case of the structural unit (2). That is, the polymer can be obtained by reacting a tetracarboxylic acid diester compound represented by the following general formula (33) in the presence of a dehydration condensation agent or using a chlorinating agent to convert the compound into an acid chloride, and then reacting the acid chloride with a diamine represented by the following general formula (34).

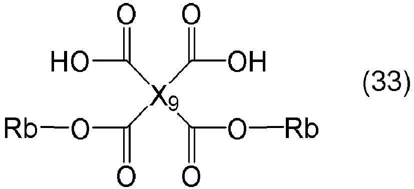

In the formula, R_{b} and X₉ are as defined above.

H₂N-X₁₀·NH₂ (34)

In the formula, X₁₀ is as defined above.

Methods for producing the tetracarboxylic acid diester compound represented by the general formula (33) include a method of allowing a reaction between a tetracarboxylic dianhydride represented by the following general formula (35) and a compound represented by the following general formula (36), having a hydroxy group on an end, in the presence of a basic catalyst, such as pyridine, to introduce the R_{b}. Here, the tetracarboxylic dianhydride represented by the following general formula (35) is a compound from which the X₉ (for example, a tetravalent organic group represented by one of the formulae (9)) in the general formula (14) is derived.

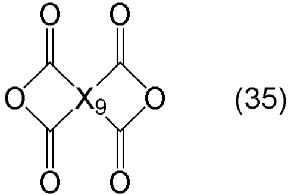

In the formula, X₉ is as defined above.

**HO-Rb** (36)

In the formula, R_{b} is as defined above.

Favorable examples of the tetracarboxylic dianhydride represented by the general formula (35) include the examples given for the tetracarboxylic dianhydride represented by the general formula (19).

Regarding the reaction between the tetracarboxylic dianhydride represented by the general formula (35) and the compound, having a hydroxy group on an end, represented by the general formula (36), the tetracarboxylic dianhydride represented by the general formula (35) and the compound, having a hydroxy group on an end, represented by the general formula (36) are stirred, dissolved, and mixed in the presence of a basic catalyst, such as pyridine, in a reaction solvent at a reaction temperature of 20 to 50°C for 4 to 10 hours. Thus, a half-esterification reaction of an acid dianhydride progresses, and the desired tetracarboxylic acid diester compound represented by the general formula (33) can be obtained as a solution in which the compound is dissolved in the reaction solvent.

The obtained tetracarboxylic acid diester compound may be subjected to isolation, or the obtained solution may be used as it is in the above-described subsequent reaction with the diamine.

The reaction solvent preferably dissolves well a polymer having a structural unit of a polyimide precursor obtained from the above-described tetracarboxylic acid diester compound and by the polycondensation reaction between the tetracarboxylic acid diester compound and a diamine performed subsequently, and examples include N-methyl-2-pyrrolidone, N,N-dimethylacetamide, N,N-dimethylformamide, dimethylsulfoxide, tetramethylurea, γ-butyrolactone, etc. It is also possible to use ketones, esters, lactones, ethers, halogenated hydrocarbons, hydrocarbons, etc., and specific examples include acetone, methyl ethyl ketone, methyl isobutyl ketone, cyclohexanone, methyl acetate, ethyl acetate, butyl acetate, diethyl oxalate, ethylene glycol dimethyl ether, diethylene glycol dimethyl ether, tetrahydrofuran, dichloromethane, 1,2-dichloroethane, 1,4-dichlorobutane, chlorobenzene, o-dichlorobenzene, hexane, heptane, benzene, toluene, xylene, etc. One of these solvents may be used or two or more thereof may be used in mixture as necessary.

Meanwhile, suitable examples of the diamine represented by the general formula (34) include the examples given for the diamine represented by the general formula (30).

Furthermore, as stated above, the inventive polymer can further contain, in addition to the structural units represented by the general formulae (1), (2), (3), and (4), a structural unit represented by the following general formula (15).

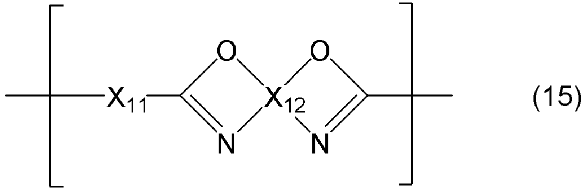

In the formula, X₁₁ and X₁₂ are as defined above.

A polymer containing the structural unit represented by the general formula (15) can be obtained by reacting a dicarboxylic acid compound represented by the following general formula (37) in the presence of a dehydration condensation agent or using a chlorinating agent to convert the compound into an acid chloride, then reacting the acid chloride with a dihydroxydiamine compound represented by the following general formula (38) to synthesize a hydroxyamide (polyoxazole precursor), and then forming an oxazole ring through a thermal dehydration process.

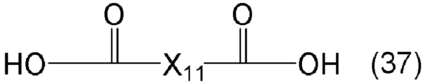

In the formula, X₁₁ is as defined above.

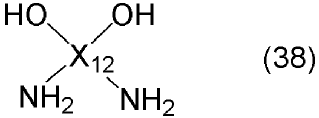

In the formula, X₁₂ is as defined above.

Suitable examples of the dicarboxylic acid compound represented by the general formula (37) include the examples given for the dicarboxylic acid compound represented by the general formula (21).

Examples of the dihydroxydiamine compound represented by the general formula (38) include, but are not limited to, 3,3'-diamino-4,4'-dihydroxybiphenyl, 3,3'-diamino-4,4'-dihydroxybiphenyl ether, 2,2'-bis(3-amino-4-hydroxyphenyl)sulfide, 2,2'-bis(3-amino-4-hydroxyphenyl)ketone, 3,3'-diamino-4,4'-dihydroxyphenylmethane, 1,2-bis(3-amino-4-hydroxyphenyl)ethane, 2,2'-bis(3-amino-4-hydroxyphenyl)difluoromethane, 4,4'-(1,1,2,2,3,3-hexafluoro-1,3-propanediyl)bis(2-aminophenol), 2,2'-bis(3-amino-4-hydroxyphenyl)propane, 2,2'-bis(3-amino-4-hydroxyphenyl)hexafluoropropane, 2,2'-bis(3-amino-4-hydroxyphenyl)sulfone, 1,1-bis(3-amino-4-hydroxyphenyl)cyclohexane, 4,4'-(1,4-phenylenebis(oxy))bis(2-aminophenol), 9,9-bis(3-amino-4-hydroxyphenyl)fluorene, etc. Furthermore, one of these compounds may be used, or a mixture thereof may be used.

### (Molecular Weight of Polymer and Introduction of End-Capping Agent)

A suitable molecular weight of the above-described polymer is preferably 5,000 to 100,000, more preferably 7,000 to 50,000. When the molecular weight is 5,000 or more, it is easy to form a film of the inventive positive and negative photosensitive resin composition containing the above-described polymer with a desired film thickness on a substrate. When the molecular weight is 100,000 or less, the viscosity of the positive and negative photosensitive resin composition is not remarkably high, and there is no fear of failing to form a film. Note that, in the present invention, the weight-average molecular weight is a value obtained by gel permeation chromatography (GPC) in terms of polystyrene.

The above-described polymer may be capped at both ends with an end-capping agent for the purposes of controlling the molecular weight in the polycondensation reaction and preventing temporal change in the molecular weight of the obtained polymer, that is, gelation. Examples of an end-capping agent that reacts with an acid dianhydride include monoamines, monohydric alcohols, etc. In addition, examples of an end-capping agent that reacts with a diamine compound include acid anhydrides, monocarboxylic acids, monoacid chloride compounds, monoactive ester compounds, dicarbonate esters, vinyl ethers, etc. In addition, by reacting the polymer with an end-capping agent, a variety of organic groups can be introduced as end group.

Examples of the monoamine to be used as the capping agent for the acid anhydride group terminal include, but are not limited to, aniline, 5-amino-8-hydroxyquinoline, 4-amino-8-hydroxyquinoline, 1-hydroxy-8-aminonaphthalene, 1-hydroxy-7-aminonaphthalene, 1-hydroxy-6-aminonaphthalene, 1-hydroxy-5-aminonaphthalene, 1-hydroxy-4-aminonaphthalene, 1-hydroxy-3-aminonaphthalene, 1-hydroxy-2-aminonaphthalene, 1-amino-7-hydroxynaphthalene, 2-hydroxy-7-aminonaphthalene, 2-hydroxy-6-aminonaphthalene, 2-hydroxy-5-aminonaphthalene, 2-hydroxy-4-aminonaphthalene, 2-hydroxy-3-aminonaphthalene, 1-amino-2-hydroxynaphthalene, 1-carboxy-8-aminonaphthalene, 1-carboxy-7-aminonaphthalene, 1-carboxy-6-aminonaphthalene, 1-carboxy-5-aminonaphthalene, 1-carboxy-4-aminonaphthalene, 1-carboxy-3-aminonaphthalene, 1-carboxy-2-aminonaphthalene, 1-amino-7-carboxynaphthalene, 2-carboxy-7-aminonaphthalene, 2-carboxy-6-aminonaphthalene, 2-carboxy-5-aminonaphthalene, 2-carboxy-4-aminonaphthalene, 2-carboxy-3-aminonaphthalene, 1-amino-2-carboxynaphthalene, 2-aminonicotinic acid, 4-aminonicotinic acid, 5-aminonicotinic acid, 6-aminonicotinic acid, 4-aminosalicylic acid, 5-aminosalicylic acid, 6-aminosalicylic acid, ammelide, 2-aminobenzoic acid, 3-aminobenzoic acid, 4-aminobenzoic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 5-amino-8-mercaptoquinoline, 4-amino-8-mercaptoquinoline, 1-mercapto-8-aminonaphthalene, 1-mercapto-7-aminonaphthalene, 1-mercapto-6-aminonaphthalene, 1-mercapto-5-aminonaphthalene, 1-mercapto-4-aminonaphthalene, 1-mercapto-3-aminonaphthalene, 1-mercapto-2-aminonaphthalene, 1-amino-7-mercaptonaphthalene, 2-mercapto-7-aminonaphthalene, 2-mercapto-6-aminonaphthalene, 2-mercapto-5-aminonaphthalene, 2-mercapto-4-aminonaphthalene, 2-mercapto-3-aminonaphthalene, 1-amino-2-mercaptonaphthalene, 3-amino-4,6-dimercaptopyrimidine, 2-aminothiophenol, 3-aminothiophenol, 4-aminothiophenol, 2-ethynylaniline, 3-ethynylaniline, 4-ethynylaniline, 2,4-diethynylaniline, 2,5-diethynylaniline, 2,6-diethynylaniline, 3,4-diethynylaniline, 3,5-diethynylaniline, 1-ethynyl-2-aminonaphthalene, 1-ethynyl-3-aminonaphthalene, 1-ethynyl-4-aminonaphthalene, 1-ethynyl-5-aminonaphthalene, 1-ethynyl-6-aminonaphthalene, 1-ethynyl-7-aminonaphthalene, 1-ethynyl-8-aminonaphthalene, 2-ethynyl-1-aminonaphthalene, 2-ethynyl-3-aminonaphthalene, 2-ethynyl-4-aminonaphthalene, 2-ethynyl-5-aminonaphthalene, 2-ethynyl-6-aminonaphthalene, 2-ethynyl-7-aminonaphthalene, 2-ethynyl-8-aminonaphthalene, 3,5-diethynyl-1-aminonaphthalene, 3,5-diethynyl-2-aminonaphthalene, 3,6-diethynyl-1-aminonaphthalene, 3,6-diethynyl-2-aminonaphthalene, 3,7-diethynyl-1-aminonaphthalene, 3,7-diethynyl-2-aminonaphthalene, 4,8-diethynyl-1-aminonaphthalene, 4,8-diethynyl-2-aminonaphthalene, 4-fluoroaniline, 3-fluoroaniline, 2-fluoroaniline, 2,4-difluoroaniline, 3,4-difluoroaniline, 2,4,6-trifluoroaniline, 2,3,4-trifluoroaniline, pentafluoroaniline, etc. One of these monoamines may be used, or two or more thereof may be used in combination.

Meanwhile, examples of the monohydric alcohol to be used as the capping agent for the acid anhydride group terminal include, but are not limited to, methanol, ethanol, 1-propanol, 2-propanol, 1-butanol, 2-butanol, 1-pentanol, 2-pentanol, 3-pentanol, 1-hexanol, 2-hexanol, 3-hexanol, 1-heptanol, 2-heptanol, 3-heptanol, 1-octanol, 2-octanol, 3-octanol, 1-nonanol, 2-nonanol, 1-decanol, 2-decanol, 1-undecanol, 2-undecanol, 1-dodecanol, 2-dodecanol, 1-tridecanol, 2-tridecanol, 1-tetradecanol, 2-tetradecanol, 1-pentadecanol, 2-pentadecanol, 1-hexadecanol, 2-hexadecanol, 1-heptadecanol, 2-heptadecanol, 1-octadecanol, 2-octadecanol, 1-nonadecanol, 2-nonadecanol, 1-icosanol, 2-methyl-1-propanol, 2-methyl-2-propanol, 2-methyl-1-butanol, 3-methyl-1-butanol, 2-methyl-2-butanol, 3-methyl-2-butanol, 2-propyl-1-pentanol, 2-ethyl-1-hexanol, 4-methyl-3-heptanol, 6-methyl-2-heptanol, 2,4,4-trimethyl-1-hexanol, 2,6-dimethyl-4-heptanol, isononyl alcohol, 3,7-dimethyl-3-octanol, 2,4-dimethyl-1-heptanol, 2-heptylundecanol, ethylene glycol monoethyl ether, ethylene glycol monomethyl ether, ethylene glycol monobutyl ether, propylene glycol 1-methyl ether, diethylene glycol monoethyl ether, diethylene glycol monomethyl ether, diethylene glycol monobutyl ether, cyclopentanol, cyclohexanol, cyclopentanemonomethylol, dicyclopentanemonomethylol, tricyclodecanemonomethylol, norborneol, terpineol, etc. One of these may be used, or two or more thereof may be used in combination.

Examples of the acid anhydride, monocarboxylic acid, monoacid chloride compound and monoactive ester compound to be used as the capping agent for the amino group terminal include acid anhydrides, such as phthalic anhydride, maleic anhydride, nadic anhydride, cyclohexanedicarboxylic anhydride and 3-hydroxyphthalic anhydride; monocarboxylic acids, such as 2-carboxyphenol, 3-carboxyphenol, 4-carboxyphenol, 2-carboxythiophenol, 3-carboxythiophenol, 4-carboxythiophenol, 1-hydroxy-8-carboxynaphthalene, 1-hydroxy-7-carboxynaphthalene, 1-hydroxy-6-carboxynaphthalene, 1-hydroxy-5-carboxynaphthalene, 1-hydroxy-4-carboxynaphthalene, 1-hydroxy-3-carboxynaphthalene, 1-hydroxy-2-carboxynaphthalene, 1-mercapto-8-carboxynaphthalene, 1-mercapto-7-carboxynaphthalene, 1-mercapto-6-carboxynaphthalene, 1-mercapto-5-carboxynaphthalene, 1-mercapto-4-carboxynaphthalene, 1-mercapto-3-carboxynaphthalene, 1-mercapto-2-carboxynaphthalene, 2-carboxybenzenesulfonic acid, 3-carboxybenzenesulfonic acid, 4-carboxybenzenesulfonic acid, 2-ethynylbenzoic acid, 3-ethynylbenzoic acid, 4-ethynylbenzoic acid, 2,4-diethynylbenzoic acid, 2,5-diethynylbenzoic acid, 2,6-diethynylbenzoic acid, 3,4-diethynylbenzoic acid, 3,5-diethynylbenzoic acid, 2-ethynyl-1-naphthoic acid, 3-ethynyl-1-naphthoic acid, 4-ethynyl-1-naphthoic acid, 5-ethynyl-1-naphthoic acid, 6-ethynyl-1-naphthoic acid, 7-ethynyl-1-naphthoic acid, 8-ethynyl-1-naphthoic acid, 2-ethynyl-2-naphthoic acid, 3-ethynyl-2-naphthoic acid, 4-ethynyl-2-naphthoic acid, 5-ethynyl-2-naphthoic acid, 6-ethynyl-2-naphthoic acid, 7-ethynyl-2-naphthoic acid and 8-ethynyl-2-naphthoic acid, and monoacid chloride compounds in which the carboxy group of the above monocarboxylic acids is acid-chlorinated; monoacid chloride compounds of dicarboxylic acids, such as terephthalic acid, phthalic acid, maleic acid, cyclohexanedicarboxylic acid, 3-hydroxyphthalic acid, 5-norbornene-2,3-dicarboxylic acid, 1,2-dicarboxynaphthalene, 1,3-dicarboxynaphthalene, 1,4-dicarboxynaphthalene, 1,5-dicarboxynaphthalene, 1,6-dicarboxynaphthalene, 1,7-dicarboxynaphthalene, 1,8-dicarboxynaphthalene, 2,3-dicarboxynaphthalene, 2,6-dicarboxynaphthalene and 2,7-dicarboxynaphthalene, in which only a monocarboxy group is acid-chlorinated; and monoactive ester compounds obtained through reaction between monoacid chloride compounds and N-hydroxybenzotriazole or N-hydroxy-5-norbornene-2,3-dicarboxyimide.

Examples of the dicarbonate ester compound to be used as the capping agent for the amino group terminal include di-tert-butyl dicarbonate, dibenzyl dicarbonate, dimethyl dicarbonate, diethyl dicarbonate, etc.

Examples of the vinyl ether compound to be used as the capping agent for the amino group terminal include butyl vinyl ether, cyclohexyl vinyl ether, ethyl vinyl ether, 2-ethylhexyl vinyl ether, isobutyl vinyl ether, isopropyl vinyl ether, n-propyl vinyl ether, tert-butyl vinyl ether, benzyl vinyl ether, etc.

Examples of another compound to be used as the capping agent for the amino group terminal include benzoyl chloride; chloroformate esters, such as fluorenylmethyl chloroformate, 2,2,2-trichloroethyl chloroformate, tert-butyl chloroformate, n-butyl chloroformate, isobutyl chloroformate, benzyl chloroformate, allyl chloroformate, ethyl chloroformate, and isopropyl chloroformate; isocyanate compounds, such as butyl isocyanate, 1-naphthyl isocyanate, octadecyl isocyanate, and phenyl isocyanate; methanesulfonic acid chloride and p-toluenesulfonic acid chloride, etc.

The proportion of the capping agent to be introduced for the acid anhydride group terminal is preferably in the range of 0.1 to 60 mol%, particularly preferably 5 to 50 mol%, and further preferably 5 to 20 mol% relative to the total amount of the tetracarboxylic dianhydride component and the dicarboxylic acid component. Moreover, the proportion of the capping agent to be introduced for the amino group terminal is preferably in the range of 0.1 to 100 mol% and particularly preferably 5 to 90 mol% relative to the diamine component. Moreover, by allowing a reaction with a plurality of end-capping agents, a plurality of different end groups may be introduced.

### [Photosensitive Resin Composition]

Next, a photosensitive resin composition containing the inventive polymer as a base resin will be described. In the present invention, by using the above-described inventive polymer as a base resin, a positive photosensitive resin composition and a negative photosensitive resin composition can be obtained.

### [Positive Photosensitive Resin Composition]

First, among photosensitive resin compositions containing the inventive polymer as a base resin, a positive photosensitive resin composition capable of alkaline development will be described. The inventive positive photosensitive resin composition can be, for example, the two embodiments described below, but is not limited thereto.

The first embodiment of the inventive positive photosensitive resin composition contains:
(A) a polymer containing the structural unit (1) and/or the structural unit (2) and the structural unit (3) and/or the structural unit (4);
(B) a photosensitizer which is a compound having a quinonediazide structure and generates an acid by light to increase a dissolution rate in an aqueous alkaline solution; and
(D) a solvent.

As the component (A) of the inventive positive photosensitive resin composition, the above-described polymer is contained. The amount of the component (A) to be contained is preferably 1 to 50 parts by mass, more preferably 5 to 40 parts by mass, and further preferably 10 to 30 parts by mass based on 100 parts by mass of the entire composition. Moreover, one kind of the component (A) may be used, or two or more kinds thereof may be used in combination.

Since the structural unit (3) or the structural unit (4) in the inventive positive photosensitive resin composition has a phenolic hydroxy group, it is possible to achieve the desired alkali dissolution rate in a developing solution, which is an aqueous alkaline solution, and a fine pattern can be formed and high resolution can be achieved.

In the inventive positive photosensitive resin composition, the component (B) is a photosensitizer which generates an acid by light to increase a dissolution rate in an aqueous alkaline solution, and is a compound having a quinonediazide structure. Examples of the component (B) may include compounds having a 1,2-naphthoquinonediazidosulfonyl group in the molecules.

Examples of the compounds having a 1,2-naphthoquinonediazidosulfonyl group in the molecules include compounds having a 1,2-naphthoquinonediazidosulfonyl group represented by the following general formula (39) or (40) in the molecules.

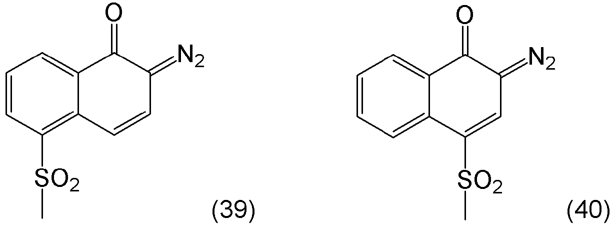

Illustrative examples of a preferable compound into which the 1,2-naphthoquinone diazide sulfonyl group is introduced include trihydroxybenzophenone or tetrahydroxybenzophenone, a ballast molecule represented by the following general formula (41) having a phenolic hydroxy group and a novolak resin having a repeating unit represented by the following formula (46) with a weight-average molecular weight in the range of 2,000 to 20,000, preferably 3,000 to 10,000. That is, those obtained by substituting a hydrogen atom(s) of the phenolic hydroxy group of the following resin or compound which has the phenolic hydroxy group with the 1,2-naphthoquinone diazide sulfonyl group are suitable as the component (B).

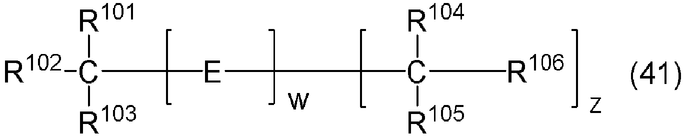

Here, R¹⁰¹ to R¹⁰⁶ each independently represent a hydrogen atom, a methyl group, a group represented by the following formula (42), or a group represented by the following formula (43). "w" is an integer of 0 to 2, and "z" is an integer of 0 to 2. When "z" is 0, "w" is 1 or 2. E is represented as follows: when "z" is 0 and "w" is 1, a hydrogen atom, a methyl group, or a group represented by the following formula (42); when "z" is 0 and "w" is 2, one E is a methylene group or a group represented by the following formula (44), and the other E is a hydrogen atom, a methyl group, or a group represented by the following formula (42); when "z" is 1, E is a methylene group or a group represented by the following formula (44); when "z" is 2 and "w" is 1, E is a methine group or a group represented by the following formula (45); and when "z" is 2 and "w" is 2, one of the Es is a methylene group or a group represented by the following formula (44), and the other is a methine group or a group represented by the following formula (45).

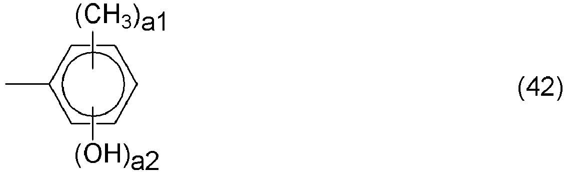

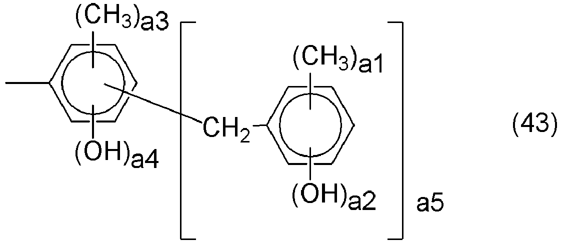

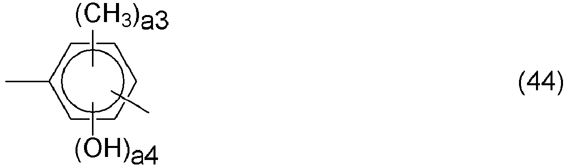

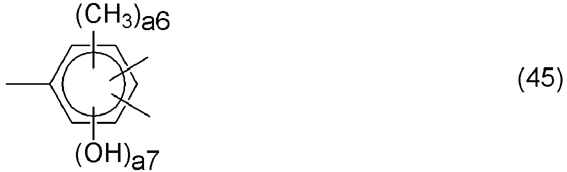

In the formulae, a1, a2, a3, a4, a5, a6, and a7 are each an integer of 0 to 3, and satisfy a1 + a2 ≤ 5, a3 + a4 ≤ 4, and a6 + a7 ≤ 3.

In this case, a low nucleus body (ballast molecule) of the formula (41) has 2 to 20 benzene rings, more preferably 2 to 10, and further preferably 3 to 6. In addition, a ratio of the number of the phenolic hydroxy groups to the number of the benzene rings is in the range of 0.5 to 2.5, more preferably 0.7 to 2.0, and further preferably 0.8 to 1.5.

Specific examples of such a low nucleus body (ballast molecule) include the following (B-1) to (B-44).

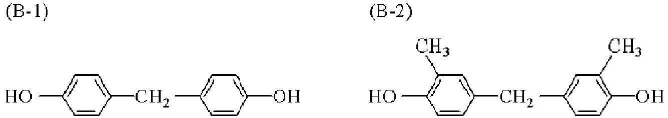

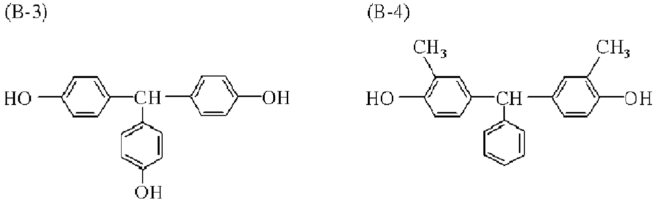

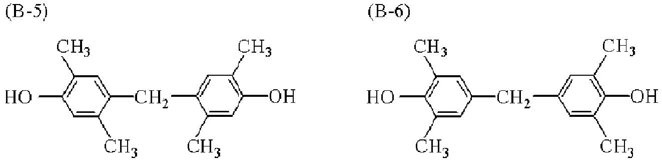

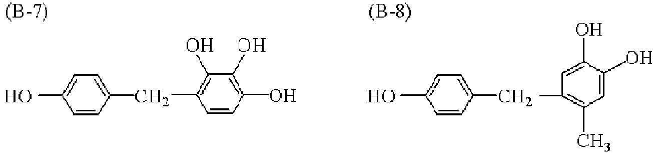

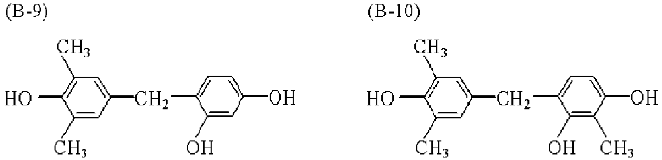

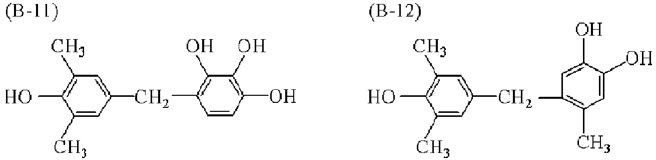

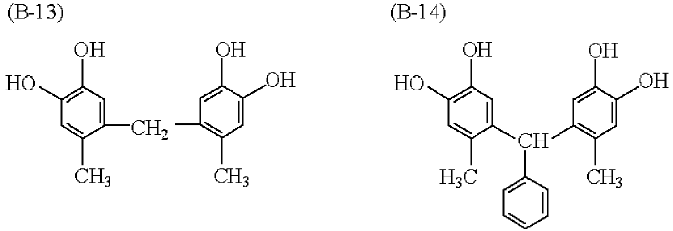

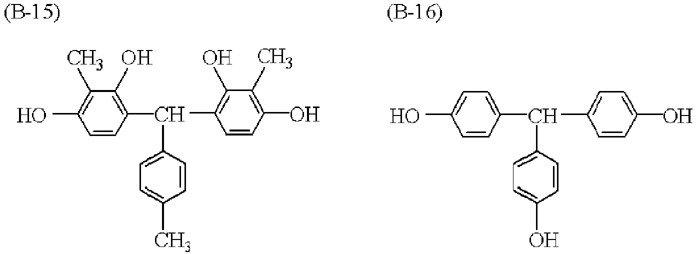

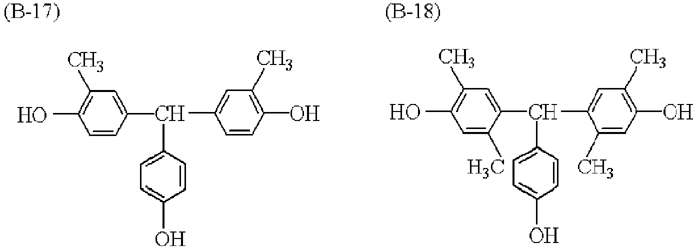

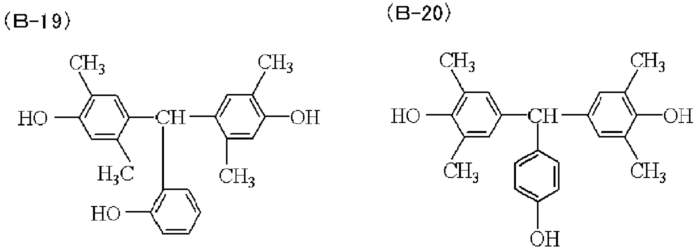

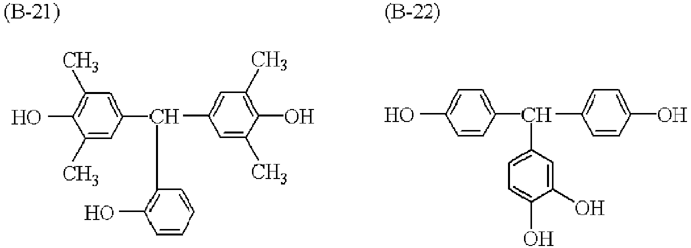

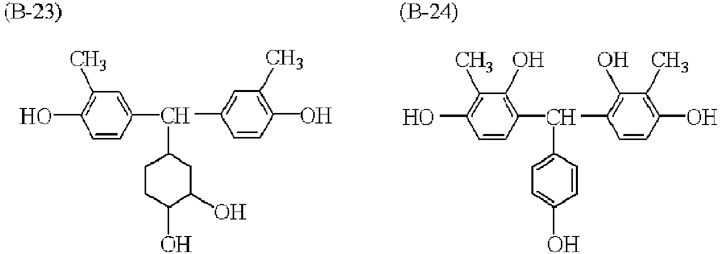

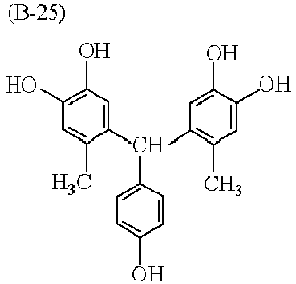

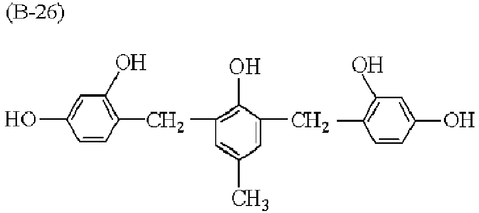

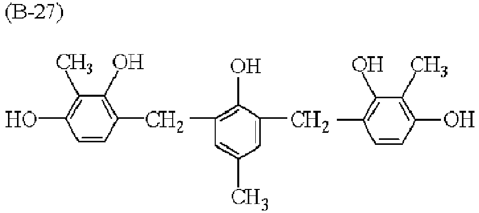

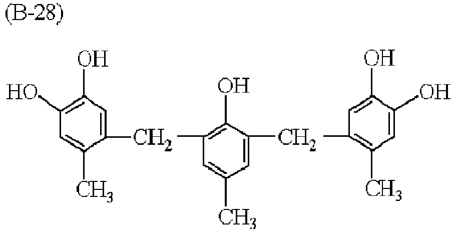

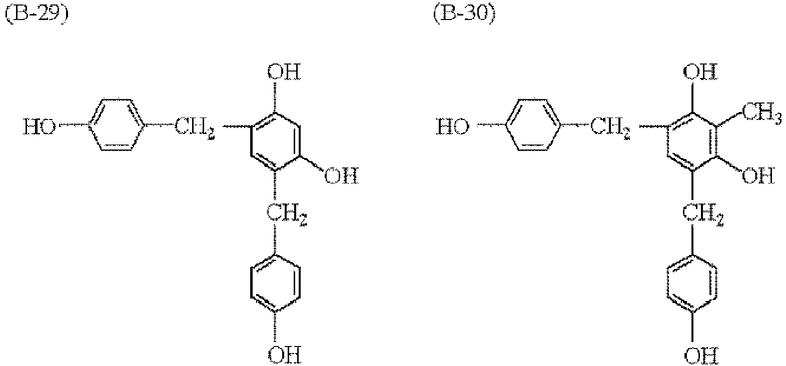

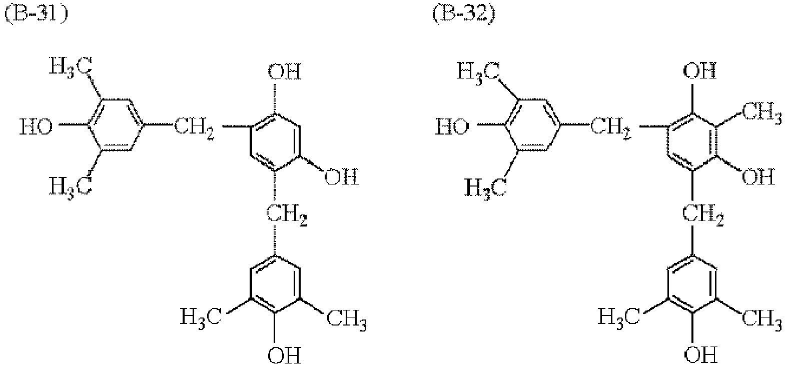

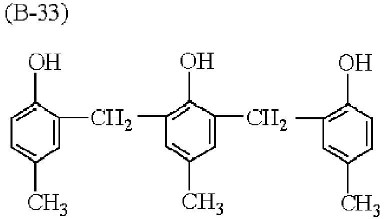

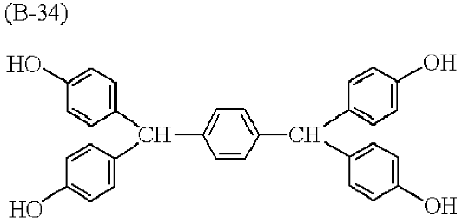

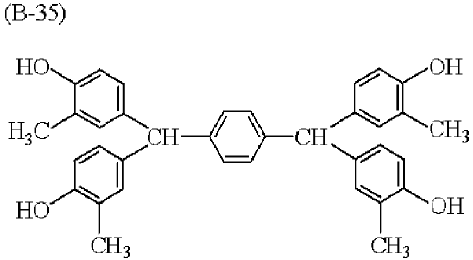

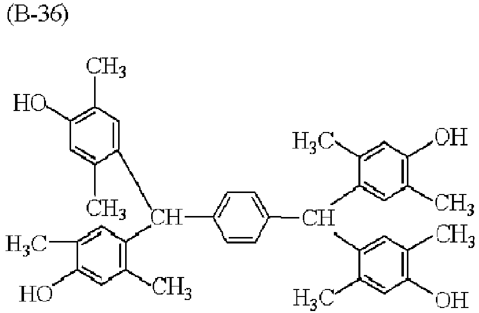

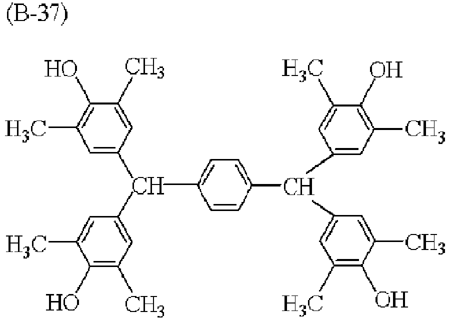

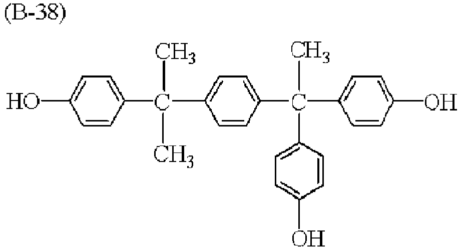

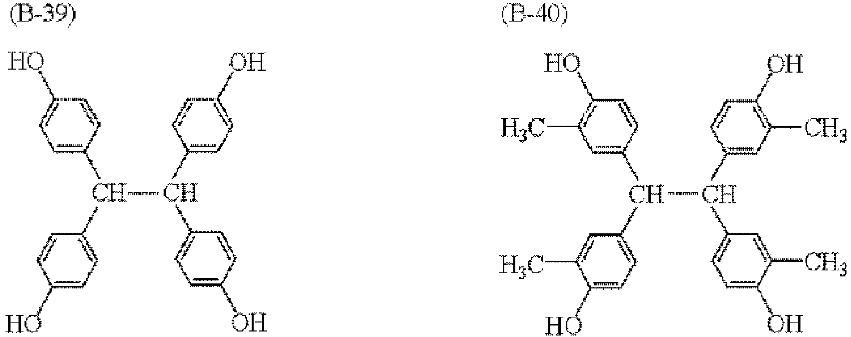

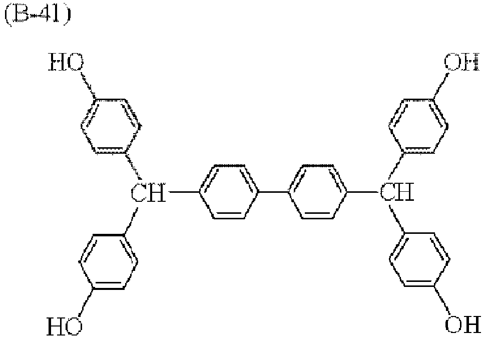

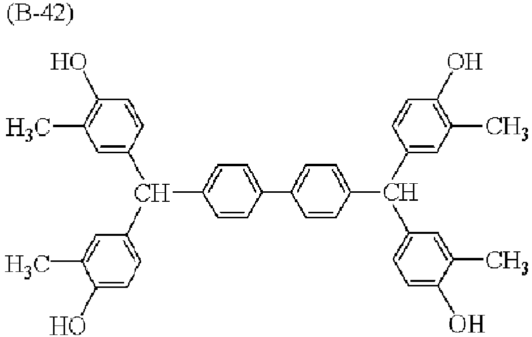

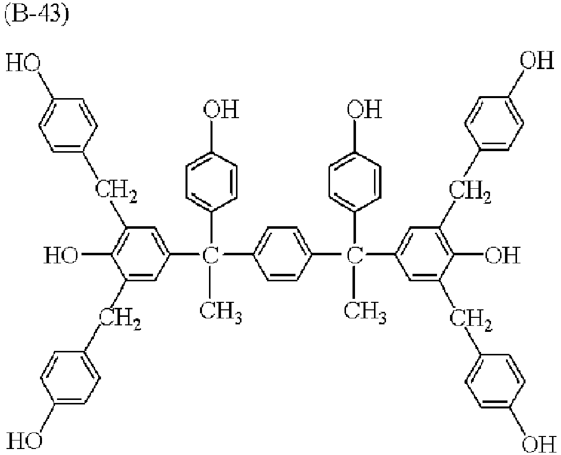

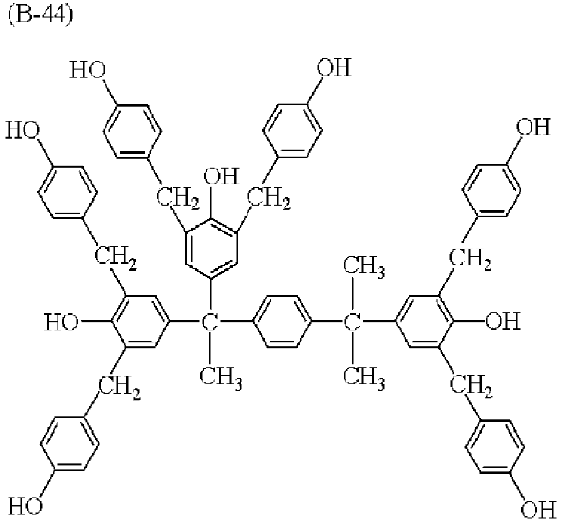

Among the low nucleus bodies (ballast molecules) illustrated above, (B-3), (B-29), (B-33), (B-38) and the like are preferred. Compounds obtained by substituting a hydrogen atom of the phenolic hydroxy group of these ballast molecules with the 1,2-naphthoquinone diazide sulfonyl group are suited for the component (B) of the inventive positive photosensitive resin composition.

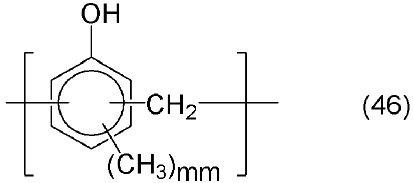

In the formula, "mm" is an integer of 0 to 3.

The novolak resin having a repeating unit represented by the formula (46) may be synthesized by making condensed aldehydes and the phenols shown by the following formula (47), specifically, at least one kind of phenol such as o-cresol, m-cresol, p-cresol, 3,5-xylenol, and the like according to an ordinary method.

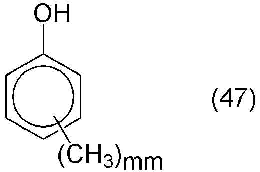

In the formula, "mm" is an integer of 0 to 3.

In this case, examples of the aldehydes include formaldehyde, para-formaldehyde, acetaldehyde, benzaldehyde and the like, and the formaldehyde is preferable.

A ratio of the phenols represented by the formula (47) to the aldehydes is preferably 0.2 to 2, particularly preferably 0.3 to 2, by molar ratio.

As a method for introducing the 1,2-naphthoquinone diazide sulfonyl group into a compound into which the 1,2-naphthoquinone diazide sulfonyl group is introduced, it is preferable to perform a dehydrochlorination condensation reaction between the 1,2-naphthoquinone diazide sulfonyl chloride and the phenolic hydroxy group with a basic catalyst. In the case of reacting with the ballast molecule represented by the formula (41), trihydroxybenzophenone or tetrahydroxybenzophenone, a ratio of substituting hydrogen atoms of the phenolic hydroxy group with the 1,2-naphthoquinone diazide sulfonyl group is 10 to 100 mol%, preferably 50 to 100 mol%. In the case of reacting with the novolak resin having a repeating unit represented by the formula (46), a ratio of substituting hydrogen atoms of the phenolic hydroxy group with the 1,2-naphthoquinone diazide sulfonyl group is 2 to 50 mol%, preferably 3 to 27 mol%.

The component (B) is preferably added in an amount of 1 to 50 parts by mass, more preferably 10 to 40 parts by mass relative to 100 parts by mass of the component (A). Furthermore, one kind or two or more kinds of the component (B) in combination may be used.

By blending such a component (B), before exposure, the solubility to the alkaline aqueous solution is suppressed due to the dissolution preventing effect of the component (B), and the system becomes alkaliinsoluble; and when exposed, the photosensitizer of the component (B) generates an acid by light, a dissolution rate to the aqueous alkaline solution increases, and the system becomes alkali-soluble. That is, when an aqueous alkaline solution is used as a developer, an unexposed part is not dissolved in the developer and an exposed part is soluble in the developer. As a result, a positive pattern may be formed.

Next, the component (D) in the positive photosensitive resin composition of the first embodiment is a solvent. The solvent of the component (D) is not limited as long as it is capable of dissolving the components (A) and (B). Examples of the solvent include: ketones, such as cyclohexanone, cyclopentanone, and methyl-2-n-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone. One or more kinds thereof may be used. In particular, ethyl lactate, cyclohexanone, cyclopentanone, propylene glycol monomethyl ether acetate, γ-butyrolactone or a mixed solvent thereof is preferable.

The amount of the component (D) to be contained is preferably 50 to 2,000 parts by mass, particularly preferably 100 to 1,000 parts by mass based on a total of 100 parts by mass of the contained amount of the components (A) and (B).

Next, the second embodiment of the inventive positive photosensitive resin composition will be described.

The positive photosensitive resin composition of the seconds embodiment of the present invention further contains, in addition to the components (A), (B), and (D), (C) one or more kinds of crosslinking agents selected from an amino condensate modified by formaldehyde or formaldehyde-alcohol; a phenol compound having two or more methylol groups or alkoxymethylol groups by average in one molecule; a compound in which a hydrogen atom of a hydroxy group of polyhydric phenol is substituted with a glycidyl group; a compound in which a hydrogen atom of a hydroxy group of polyhydric phenol or a hydroxy group of polyhydric alcohol is substituted with a substituent represented by the following formula (C-1); and a compound having two or more nitrogen atoms having a glycidyl group represented by the following formula (C-2).

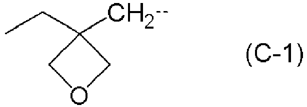

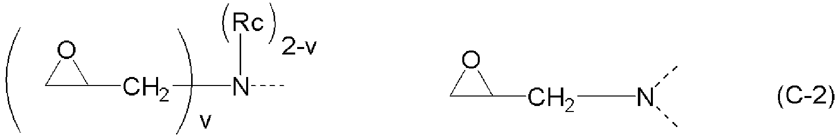

In the formulae, a dotted line represents an attachment point, Rc represents a linear, branched, or cyclic alkyl group having 1 to 6 carbon atoms, and "v" represents 1 or 2.

As the components (A) and (B) of the positive photosensitive resin composition of the second embodiment of the present invention, the same components as those in the positive photosensitive resin composition of the first embodiment described above can be used suitably.

The component (C) in the positive photosensitive resin composition of the second embodiment of the present invention is one or more crosslinking agents selected from an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (C-1), and a compound containing two or more nitrogen atoms each having a glycidyl group represented by the following formula (C-2). 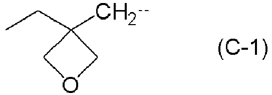 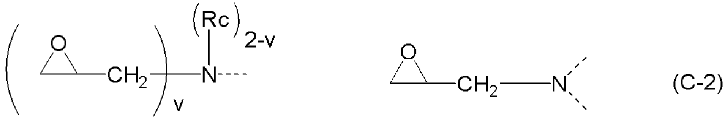 In the formulae, a dotted line represents an attachment point, Rc represents a linear, branched, or cyclic alkyl group having 1 to 6 carbon atoms, and "v" represents 1 or 2.

Examples of the amino condensates modified by the formaldehyde or formaldehyde-alcohol include a melamine condensate modified by the formaldehyde or formaldehyde-alcohol, and a urea condensate modified by the formaldehyde or formaldehyde-alcohol.

The melamine condensate modified by the formaldehyde or formaldehyde-alcohol is prepared, for example, in such a manner that, firstly, according to a well-known method, a melamine monomer is modified by methylol reaction with formalin, or this is further modified by alkoxylation with alcohol, and thus modified melamine represented by the following general formula (48) is obtained. As the alcohol, a lower alcohol, for example alcohols having 1 to 4 carbon atoms is preferable.

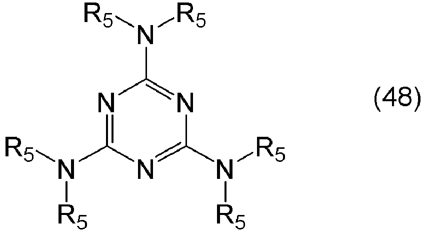

In the formula, R₅s may be the same or different from each other, and are methylol groups, alkoxymethyl groups containing an alkoxy group having 1 to 4 carbon atoms, or hydrogen atoms, and at least one R₅ is a methylol group or the alkoxymethyl group.

Examples of the R₅ include a hydrogen atom, a methylol group, and alkoxymethyl groups such as a methoxymethyl group and an ethoxymethyl group.

Specific examples of the modified melamine represented by the general formula (48) include trimethoxymethylmonomethylol melamine, dimethoxymethylmonomethylol melamine, trimethylol melamine, hexamethylol melamine, and hexamethoxymethylol melamine. Next, the modified melamine represented by the general formula (48) or its multimer (for example, an oligomer such as a dimer or a trimer) is subjected to addition condensation polymerization with formaldehyde until a desired molecular weight is obtained according to the conventional method to obtain a melamine condensate modified by formaldehyde or formaldehyde-alcohol.

The urea condensate modified by the formaldehyde or formaldehyde-alcohol is prepared, according to, for example, a well-known method, by modifying a urea condensate having a desired molecular weight by methylol reaction with formaldehyde, or by further modifying by alkoxylation with alcohol.

Specific examples of the urea condensate modified by the formaldehyde or formaldehyde-alcohol include a methoxymethylated urea condensate, an ethoxymethylated urea condensate, a propoxymethylated urea condensate, and the like.

One of these modified melamine condensates and modified urea condensates may be used or two or more kinds thereof may be used in mixture.

Next, examples of the phenol compound having two or more methylol groups or alkoxymethylol groups in average in one molecule include (2-hydroxy-5-methyl)-1,3-benzenedimethanol, 2,2',6,6'-tetramethoxymethylbisphenol A, compounds represented by the following formulae (C-3) to (C-7), and the like.

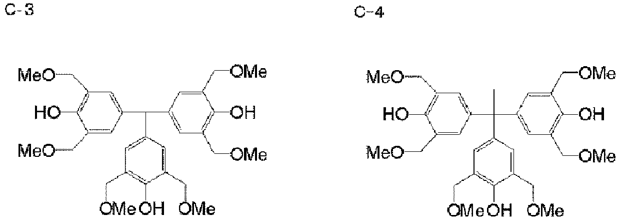

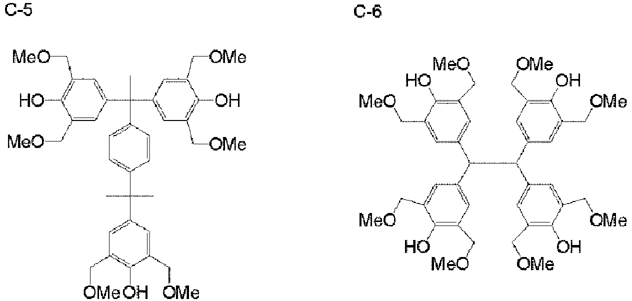

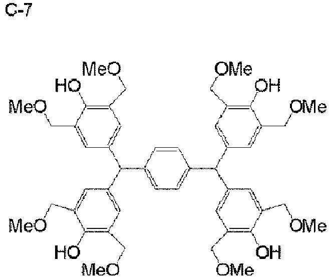

One of the crosslinking agents may be used or two or more kinds may be used in combination.

Meanwhile, examples of the compounds in which a hydrogen atom of a hydroxy group of polyhydric phenol is substituted with a glycidyl group include a compound obtained by reaction of the hydroxy group of bisphenol A, tris(4-hydroxyphenyl)methane, and 1,1,1-tris(4-hydroxyphenyl)ethane with epichlorohydrin in the presence of a base. Suitable examples of the compound in which a hydrogen atom of a hydroxy group of a polyhydric phenol is substituted with a glycidyl group include the compounds represented by the following formulae (C-8) to (C-14) .

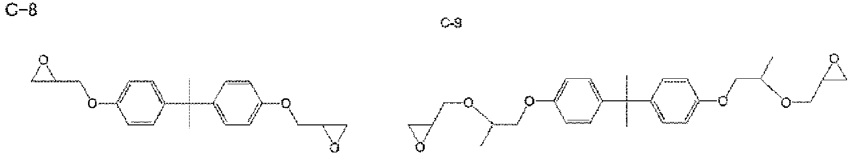

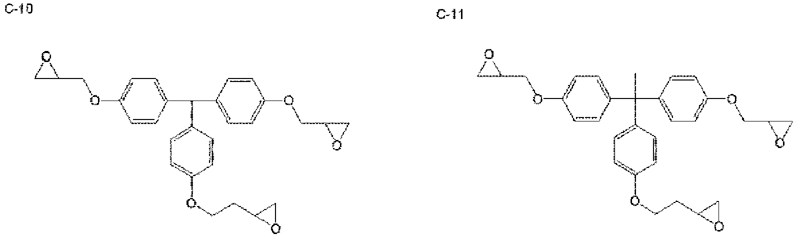

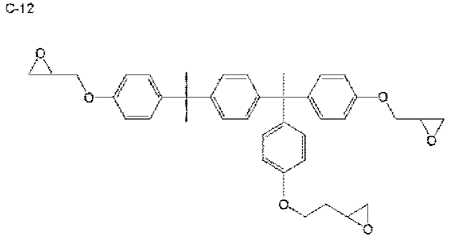

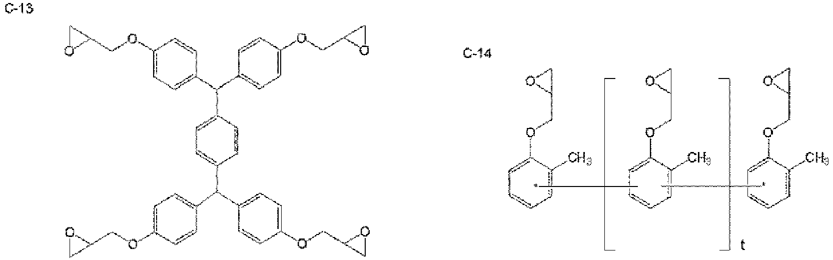

In the formulae, "t" satisfies 2 ≤ t ≤ 3.

One kind or two kinds of the compounds obtained by substituting a hydroxy group of the polyhydric phenol with a glycidoxy group (a compound in which a hydrogen atom of a hydroxy group of polyhydric phenol is substituted with a glycidyl group) may be used as a crosslinking agent.

Examples of the compound in which a hydrogen atom of a hydroxy group of polyhydric phenol is substituted with a substituent represented by the following formula (C-1) include ones containing two or more of the substituents and represented by the following formula (C-15).

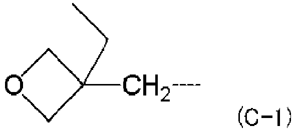

In the formula, a dotted line represents an attachment point.

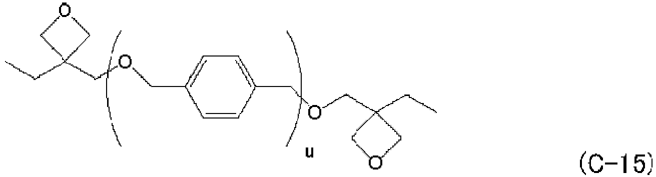

In the formula, 1 ≤ u ≤ 3.

Meanwhile, examples of the compound containing two or more nitrogen atoms having a glycidyl group represented by the following formulae (C-2) include ones represented by the following formula (C-16).

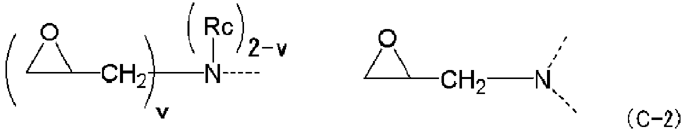

In the formulae, a dotted line represents an attachment point, Rc represents a linear, branched, or cyclic alkyl group having 1 to 6 carbon atoms, and "v" represents 1 or 2.

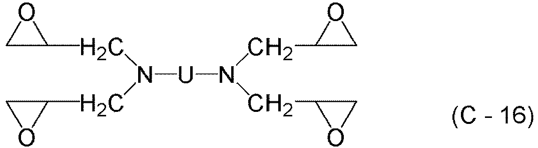

In the formula, U represents a linear, branched, or cyclic alkylene group having 2 to 12 carbon atoms or a divalent aromatic group.

Examples of the compounds represented by the formula (C-16) include compounds represented by the following formulae (C-17) to (C-20).

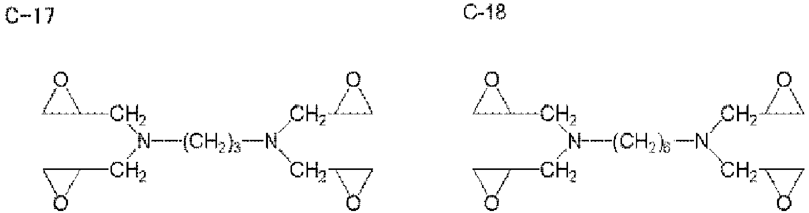

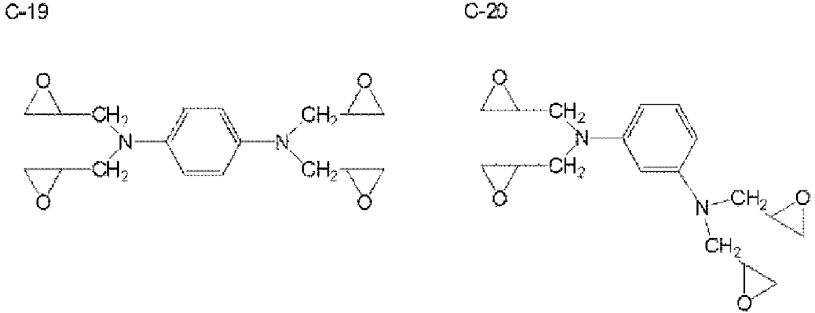

Meanwhile, as the compound containing two or more nitrogen atoms each of which has a glycidyl group(s) represented by the formula (C-2), a compound represented by the following formula (C-21) may be suitably used.

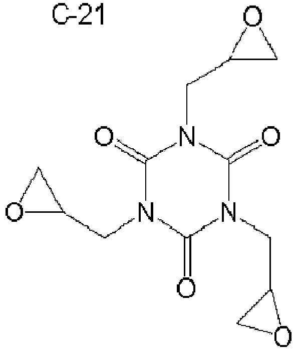

One kind or two kinds of these compounds containing two or more nitrogen atoms each of which has a glycidyl group(s) represented by the formula (C-2) may be used as a crosslinking agent.

The component (C) is a component that causes a crosslinking reaction in the post-curing after forming a pattern of the positive photosensitive resin composition containing the inventive polymer to further increase the strength of a cured product. A weight-average molecular weight of such a component (C) is preferably 150 to 10,000, and particularly preferably 200 to 3,000, from the viewpoint of the photocurability and heat resistance.

In the second embodiment of the inventive positive photosensitive resin composition, the amount of the component (C) to be contained is preferably 0.5 to 50 parts by mass, particularly preferably 1 to 30 parts by mass relative to 100 parts by mass of the component (A).

Meanwhile, suitable examples of the solvent of the component (D) in the positive photosensitive resin composition of the second embodiment of the present invention include the solvents described in the case of the positive photosensitive resin composition of the first embodiment.

The inventive positive photosensitive resin composition can further contain (E) a compound which generates an acid by heat. The component (E), the compound that generates an acid by heat, can be added for the purpose of thermally accelerating crosslinking reaction with the component (A) in the step of heating and post-curing the composition at a temperature of 100 to 300°C performed after the patterning.

Particularly, as the component (E), preferable are those that do not promote curing of the film before a pattern is formed by development and do not inhibit the patterning. In order to accomplish this, the component (E) preferably does not generate an acid at a temperature of the step of removing the solvent and drying the film after the coating (application) of the photosensitive resin composition, but generates an acid only by heat treatment after the patterning to thereby promote curing of the pattern and film of the positive photosensitive resin composition. Specifically, the component (E) is preferably a compound that is decomposed and generates an acid through a heat treatment at 100°C to 300°C, preferably 150°C to 300°C. When such component (E) is contained, the pattern and film of the positive photosensitive resin composition can be changed to a state where crosslinking and curing reaction are more advanced in the step of heating and post-curing at a temperature of 100 to 300°C performed after the patterning. The component (E) can even further improve the mechanical strength, chemical resistance, adhesiveness, and the like of the obtained pattern or film by even further advancing crosslinking and curing reaction.

A suitable compound that generates an acid by heat is not particularly limited. For example, compounds described in paragraphs [0061] to [0085] of JP 2007-199653 A can be used.

The compound that generates an acid by heat is blended in an amount of preferably 0.1 parts by mass or more, more preferably 0.5 parts by mass or more, and preferably 30 parts by mass or less, more preferably 10 parts by mass or less, relative to 100 parts by mass of the component (A) in the inventive positive photosensitive resin composition.

In addition, the inventive positive photosensitive resin composition may further contain, in addition to the components (A), (B), (C), (D), and (E), one or more selected from (F) a protective amine compound, (G) an antioxidant, (H) a silane compound, (I) a surfactant, (J) a dissolution inhibitor, etc.

The inventive positive photosensitive resin composition can further contain (F) a protective amine compound in addition to the components (A), (B), (C), and (D). The component (F) protective amine compound can be any protective amine compound, as long as it is a nitrogen-containing organic compound in which a group that is deprotected by heat or an acid is bonded to a nitrogen atom. In particular, the protective amine compound is not particularly limited as long as it has a carbamate structure represented by the following general formula (49) or (50) .

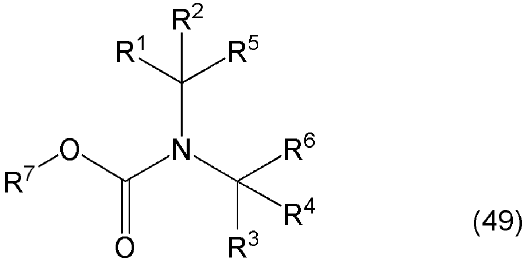

Here, in the formula, R¹, R², R³, and R⁴ each independently represent hydrogen, an alkyl group having 1 to 8 carbon atoms optionally having a substituent, a cycloalkyl group having 3 to 8 carbon atoms optionally having a substituent, an alkoxyl group having 1 to 8 carbon atoms optionally having a substituent, an alkenyl group having 2 to 8 carbon atoms optionally having a substituent, an alkynyl group having 2 to 8 carbon atoms optionally having a substituent, an aryl group optionally having a substituent, or a heterocyclic group optionally having a substituent. R⁵ and R⁶ each independently represent hydrogen, an alkyl group having 1 to 8 carbon atoms optionally having a substituent, a cycloalkyl group having 3 to 8 carbon atoms optionally having a substituent, an alkoxyl group having 1 to 8 carbon atoms optionally having a substituent, an alkenyl group having 2 to 8 carbon atoms optionally having a substituent, an alkynyl group having 2 to 8 carbon atoms optionally having a substituent, an aryl group optionally having a substituent, a heterocyclic group optionally having a substituent, a single ring optionally having a substituent formed by bonding with each other, or a polycycle optionally having a substituent formed by bonding with each other. Here, the total number of carbon atoms in the formula is preferably 10 or less.

Meanwhile, R⁷ represents an alkyl group having 1 to 12 carbon atoms optionally having a substituent, a cycloalkyl group having 3 to 12 carbon atoms optionally having a substituent, an alkenyl group having 2 to 12 carbon atoms optionally having a substituent, an alkynyl group having 2 to 12 carbon atoms optionally having a substituent, an aryl group optionally having, as a substituent, an alkyl group having 1 to 3 carbon atoms, an aralkyl group optionally having, as a substituent, an alkyl group having 1 to 3 carbon atoms, or a heterocyclic group optionally having a substituent. Here, the total number of carbon atoms constituting R⁷ is 12 or less. Any substituent may be used as the substituent that the above groups optionally have as long as it does not conflict with the intensions of the present invention.

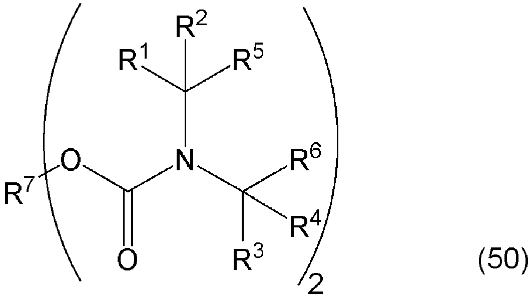

Specific examples of the formulae (49) and (50) include the following: N-(isopropoxycarbonyl)-2,6-dimethylpiperidine, N-(isopropoxycarbonyl)-2,2,6,6-tetramethylpiperidine, N-(isopropoxycarbonyl)diisopropylamine, N-(isopropoxycarbonyl)pyrrolidine, N-(isopropoxycarbonyl)-2,5-dimethylpyrrolidine, N-(isopropoxycarbonyl)-azetidine, N-(1-ethylpropoxycarbonyl)-2,6-dimethylpiperidine, N-(1-ethylpropoxycarbonyl)-2,2,6,6-tetramethylpiperidine, N-(1-ethylpropoxycarbonyl)diisopropylamine, N-(1-ethylpropoxycarbonyl)pyrrolidine, N-(1-ethylpropoxycarbonyl)-2,5-dimethylpyrrolidine, N-(1-ethylpropoxycarbonyl)-azetidine, N-(1-propylbutoxycarbonyl)-2,6-dimethylpiperidine, N-(1-propylbutoxycarbonyl)-2,2,6,6-tetramethylpiperidine, N-(1-propylbutoxycarbonyl)diisopropylamine, N-(1-propylbutoxycarbonyl)pyrrolidine, N-(1-propylbutoxycarbonyl)-2,5-dimethylpyrrolidine, N-(1-propylbutoxycarbonyl)-azetidine, N-(cyclopentoxycarbonyl)-2,6-dimethylpiperidine, N-(cyclopentoxycarbonyl)-2,2,6,6-tetramethylpiperidine, N-(cyclopentoxycarbonyl)diisopropylamine, N-(cyclopentoxycarbonyl)pyrrolidine, N-(cyclopentoxycarbonyl)-2,5-dimethylpyrrolidine, N-(cyclopentoxycarbonyl)-azetidine, N-(cyclohexylcarbonyl)-2,6-dimethylpiperidine, N-(cyclohexylcarbonyl)-2,2,6,6-tetramethylpiperidine, N-(cyclohexylcarbonyl)diisopropylamine, N-(cyclohexylcarbonyl)pyrrolidine, N-(cyclohexylcarbonyl)-2,5-dimethylpyrrolidine, N-(cyclohexylcarbonyl)-azetidine, N-(tert-butoxycarbonyl)-2,6-dimethylpiperidine, N-(tert-butoxycarbonyl)-2,2,6,6-tetramethylpiperidine, N-(tert-butoxycarbonyl) diisopropylamine, N-(tert-butoxycarbonyl)pyrrolidine, N-(tert-butoxycarbonyl)-2,5-dimethylpyrrolidine, N-(tert-butoxycarbonyl)-azetidine, N-(benzyloxycarbonyl)-2,6-dimethylpiperidine, N-(benzyloxycarbonyl)-2,2,6,6-tetramethylpiperidine, N-(benzyloxycarbonyl)diisopropylamine, N-(benzyloxycarbonyl)pyrrolidine, N-(benzyloxycarbonyl)-2,5-dimethylpyrrolidine, N-(benzyloxycarbonyl)-azetidine, 1,4-bis(N,N'-diisopropylaminocarbonyloxy)cyclohexane, imidazole compounds disclosed in JP 5609815 B, and the like.

The protective amine compound according to the present embodiment is particularly preferably decomposed 100% at 200°C or lower. In this manner, a basic compound can be generated more efficiently to promote imidization of a polyimide precursor or to promote the crosslinking reaction between a heat crosslinking agent and a resin. A base obtained by heating the protective amine compound and other decomposed products preferably have a boiling point of 200°C or lower under 1 atmosphere (0.1 GPa). This is because the decomposed product can be volatilized in a low-temperature process from during coating when the boiling point is 200°C or lower. The lower limit of the boiling point of the decomposed product under 1 atmosphere is not particularly limited, but is preferably -150°C or higher from the viewpoint of synthesizing the protective amine compound simply and conveniently.

When an amine compound is added directly to the inventive photosensitive resin composition, there is concern that the component (C) crosslinking agent and the amine compound react under room temperature and the composition becomes viscous over time so that storage stability becomes degraded. On the other hand, with an amine compound whose basic site is protected by a protecting group, the component (C) does not react under room temperature, in the same manner as when unheated. Therefore, storage stability of the photosensitive resin composition over time can be raised. In addition, since a base is only generated once heated, such an amine compound becomes a catalyst in an imide ring-closing reaction or a reaction between the component (A) polymer and the component (C) crosslinking agent, so that a crosslinking reaction can be promoted effectively.

One kind of the protective amine compound can be used or a combination of two or more kinds can be used. When 0 to 10 parts by mass of the protective amine compound is to be blended relative to 100 parts by mass of the component (A) polymer (alkali-soluble resin), a protective amine compound is preferably mixed in a blending amount of 0.01 to 10 parts by mass, in particular, 0.01 to 5 parts by mass. When the blending amount is 10 parts by mass or less, the alkali-solubility of the composition is sufficient, so that favorable lithography patterning property can be achieved.

The inventive positive photosensitive resin composition can further contain (G) an antioxidant. Degradation of an aliphatic group or a phenolic hydroxy group of the component (A) by oxidation can be suppressed by the component (G) antioxidant being contained. In addition, by an anticorrosive effect to metal materials, it is possible to suppress oxidation of metal by water from outside, a photoacid generator, or a thermal acid generator, etc. and accompanying adhesion degradation and delamination.

Specific examples of antioxidants (G) that can be used here include hindered phenol-based antioxidants, phosphorus-based antioxidants, and sulfur-based antioxidants as preferable examples. However, the antioxidant is not limited thereto. Moreover, one of these antioxidants (G) can be used or two or more thereof can be used in combination.

Furthermore, out of the above-described specific examples of antioxidants (G), examples of the hindered phenol-based antioxidants include pentaerythritol tetrakis[3-(3,5-di-tert-butyl-4-hydroxyphenyl)propionate] (Irganox 1010 (trade name), manufactured by BASF Japan Ltd.), thiodiethylenebis[3-(3,5-di-tert-butyl-4-hydroxyphenyl)propionate] (Irganox 1035 (trade name), manufactured by BASF Japan Ltd.), octadecyl[3-(3,5-di-tert-butyl-4-hydroxyphenyl)propionate] (Irganox 1076 (trade name), manufactured by BASF Japan Ltd.), octyl-1-3,5-di-tert-butyl-4-hydroxy-hydrocinnamic acid (Irganox 1135 (trade name), manufactured by BASF Japan Ltd.), 4,6-bis(octylthiomethyl-o-cresol) (Irganox 1520L, manufactured by BASF Japan Ltd.), Sumilizer GA80 (trade name, manufactured by Sumitomo Chemical Co., Ltd.), Adekastab AO-20 (trade name, manufactured by ADEKA CORPORATION), Adekastab AO-30 (trade name, manufactured by ADEKA CORPORATION), Adekastab AO-40 (trade name, manufactured by ADEKA CORPORATION), Adekastab AO-50 (trade name, manufactured by ADEKA CORPORATION), Adekastab AO-60 (trade name, manufactured by ADEKA CORPORATION), Adekastab AO-80 (trade name, manufactured by ADEKA CORPORATION), Adekastab AO-330 (trade name, manufactured by ADEKA CORPORATION), hindered phenol-based antioxidants disclosed in WO 2017/188153 A1, and the like.

Furthermore, out of the above-described specific examples of antioxidants (G), examples of the phosphorus-based antioxidants include triphenyl phosphite, tris(methylphenyl) phosphite, triisooctyl phosphite, tridecyl phosphite, tris(2-ethylhexyl) phosphite, tris(nonylphenyl) phosphite, tris(octylphenyl) phosphite, tris[decylpoly(oxyethylene) phosphite, tris(cyclohexylphenyl) phosphite, tricyclohexyl phosphite, tri(decyl)thio phosphite, triisodecylthio phosphite, phenyl-bis(2-ethylhexyl) phosphite, phenyl-diisodecyl phosphite, tetradecylpoly(oxyethylene)-bis(ethylphenyl) phosphite, phenyl-dicyclohexyl phosphite, phenyl-diisooctyl phosphite, phenyl-di(tridecyl) phosphite, diphenyl-cyclohexyl phosphite, diphenyl-isooctyl phosphite, diphenyl-2-ethylhexyl phosphite, diphenyl-isodecyl phosphite, diphenyl-cyclohexylphenyl phosphite, diphenyl-(tridecyl)thio phosphite, and the like.

Furthermore, out of the above-described specific examples of antioxidants (G), examples of the sulfur-based antioxidants include Adekastab AO-412S (trade name, manufactured by ADEKA CORPORATION), AO-503S (trade name, manufactured by ADEKA CORPORATION), Sumilizer TP-D (trade name, manufactured by Sumitomo Chemical Co., Ltd.), and the like.

Sulfur-based antioxidants and phosphorus-based antioxidants can be expected to have an effect of decomposing peroxides.

The contained amount of the antioxidant (G) is preferably 0.1 to 10 parts by mass, more preferably 0.2 to 5 parts by mass relative to 100 parts by mass of the component (A) polymer. When the contained amount is 0.1 parts by mass or more, adhesiveness to metal materials is enhanced, while at the same time, delamination is suppressed. Meanwhile, when the contained amount is 10 parts by mass or less, the alkali developing properties of the composition and the toughness of the cured film are not degraded.

The inventive positive photosensitive resin composition can further contain (H) a silane compound. When the component (H) silane compound is contained, not only is the adhesiveness to metal materials enhanced, it is also possible to suppress the delamination of the cured film in reliability tests such as a thermal shock test and a high temperature and high humidity test.

A silane compound (H) usable here is not particularly limited, but preferably has an alkoxysilyl group. Suitable, specific examples include the following: γ-glycidoxypropyltriethoxysilane, γ-glycidoxypropyltrimethoxysilane, 2-(3,4-epoxycyclohexyl)ethyltrimethoxysilane, bis(2-hydroxyethyl)-3-aminopropyl-triethoxysilane, γ-aminopropyltrimethoxysilane, γ-aminopropyltriethoxysilane, vinyltriethoxysilane, vinyltrimethoxysilane, γ-methacryloxypropyltrimethoxysilane, γ-acryloxypropyltrimethoxysilane, 3-mercaptopropyltrimethoxysilane, 3-isocyanatepropyltriethoxysilane, bis(2-hydroxyethyl)-3-aminopropyltriethoxysilane, triethoxysilylpropylethyl carbamate, 3-(triethoxysilyl)propyl succinic anhydride, phenyltriethoxysilane, phenyltrimethoxysilane, N-phenyl-3-aminopropyltrimethoxysilane, 3-triethoxysilyl-N-(1,3-dimethylbutylidene)propylamine, amide group-containing silane compounds disclosed in JP 6414060 B, thiourea group-containing silane compounds disclosed in WO 2016/140024 A1 and JP 5987984 B, thiol group-containing silane compounds disclosed in JP 2017-044964 A, and the like. However, the silane compound is not limited thereto. Furthermore, one of these silane compounds (H) can be used or a combination of two or more thereof can be used.

The contained amount of the silane compound (H) is preferably 0.1 to 20 parts by mass, more preferably 1 to 10 parts by mass, and further preferably 3 to 6 parts by mass relative to 100 parts by mass of the component (A) polymer. With 0.1 parts by mass or more, more sufficient adhesiveness with a substrate can be provided, and when 20 parts by mass or less, it is possible to further suppress the problem of increasing viscosity or the like when storing at room temperature. Meanwhile, when the contained amount is 10 parts by mass or less, degradation of the alkali developing properties of the composition does not occur, and thus, development residue does not occur.

The inventive positive photosensitive resin composition can further contain (I) a surfactant. The surfactant (I) is preferably nonionic. Examples thereof include fluorine-based surfactants, specifically, perfluoroalkyl polyoxyethylene ethanols, fluorinated alkyl esters, perfluoroalkylamine oxides, fluorine-containing organosiloxane-based compounds, non-fluorine organosiloxane-based compounds, etc.

As these surfactants (I), commercially available products can be used. Examples thereof include Fluorad FC-4430 (trade name, manufactured by Sumitomo 3M Limited), PF-6320 (trade name, manufactured by OMNOVA Solutions Inc.), PF-636 (trade name, manufactured by OMNOVA Solutions Inc.), Surflon S-141 and S-145 (both trade names, manufactured by ASAHI GLASS CO., LTD.), UNIDYNE DS-401, DS-4031, and DS-451 (all trade names, manufactured by DAIKIN INDUSTRIES, LTD.), Megafac F-8151 (trade name, manufactured by DIC Corporation), X-70-093 and KP-341 (trade names, manufactured by Shin-Etsu Chemical Co., Ltd.), etc. Among these, preferred are Fluorad FC-4430 (trade name, manufactured by Sumitomo 3M Limited), PF-6320 (trade name, manufactured by OMNOVA Solutions Inc.), PF-636 (trade name, manufactured by OMNOVA Solutions Inc.), and KP-341 (trade name, manufactured by Shin-Etsu Chemical Co., Ltd.).

The amount of the surfactant (I) to be contained is preferably 0.01 to 0.05 parts by mass based on 100 parts by mass of the component (A) polymer. When the amount is in such a range, there is an advantage that coatability on a substrate can be improved without degradation of patterning properties or properties of the cured film.

The inventive positive photosensitive resin composition can further contain (J) a dissolution inhibitor. Examples of the dissolution inhibitor (J) include compounds having two or more phenolic hydroxy groups in a molecule, where an average of 0 to 100 mol% of the hydrogen atoms of the phenolic hydroxy groups are substituted with acid-labile groups as a whole; or compounds having a carboxy group in a molecule, where an average of 50 to 100 mol% of the hydrogen atoms of the carboxy groups are substituted with acid-labile groups as a whole. In addition, the compounds have a weight-average molecular weight of 100 to 1,000, preferably 150 to 800.

The degree of substitution of the hydrogen atoms in the phenolic hydroxy groups with the acid-labile groups is, on average, 0 mol% or higher, preferably 30 mol% or higher of all the phenolic hydroxy groups, and the upper limit of the degree is 100 mol%, more preferably 80 mol%. The degree of substitution of the hydrogen atoms in the carboxy groups with the acid-labile group is, on average, 50 mol% or higher, preferably 70 mol% or higher of all the carboxy groups, and the upper limit of the degree is 100 mol%.

In this case, compounds represented by the following formulae (J1) to (J14) are preferable as the compounds having two or more phenolic hydroxy groups or the compounds having a carboxy group.

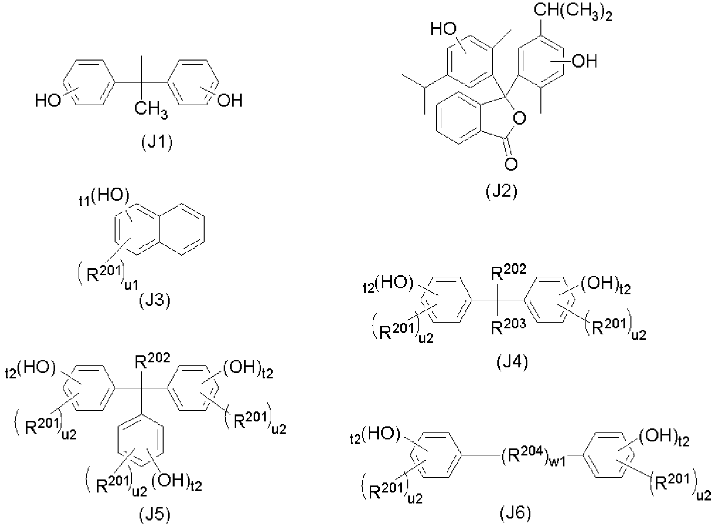

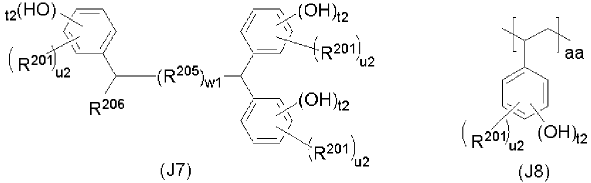

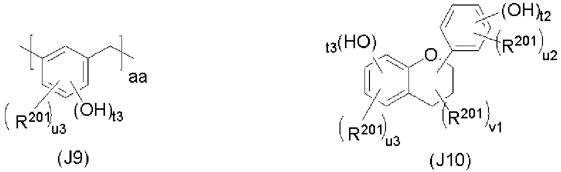

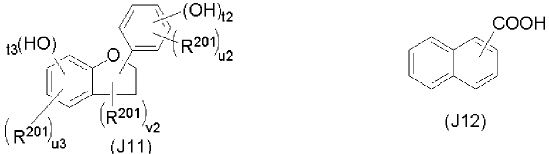

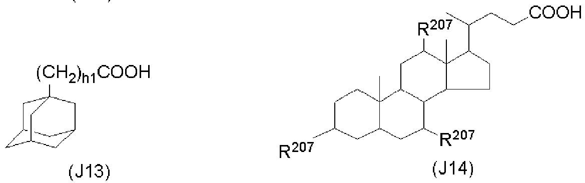

In the formulae, R²⁰¹ and R²⁰² each represent a hydrogen atom or a linear or branched alkyl group or alkenyl group having 1 to 8 carbon atoms. R²⁰³ represents a hydrogen atom or a linear or branched alkyl group or alkenyl group having 1 to 8 carbon atoms. R²⁰⁴ represents -(CH₂)ᵢ₁-(i1=2 to 10), an arylene group having 6 to 10 carbon atoms, a carbonyl group, a sulfonyl group, an oxygen atom, or a sulfur atom. R²⁰⁵ represents an alkylene group having 1 to 10 carbon atoms, an arylene group having 6 to 10 carbon atoms, a carbonyl group, a sulfonyl group, an oxygen atom, or a sulfur atom. R²⁰⁶ represents a hydrogen atom, a linear or branched alkyl group or alkenyl group having 1 to 8 carbon atoms, or a phenyl group or a naphthyl group each substituted with a hydroxy group. R²⁰⁷ represents a hydrogen atom or a hydroxy group. "v1" is an integer of 0 to 2, and "v2" is 0 or 1. "w1" and "h1" are each 0 or 1. "t1", "u1", "t2", "u2", "t3", and "u3" each satisfy t1 + u1 = 8, t2 + u2 = 5, t3 + u3 = 4, and are numbers such that there is at least one hydroxy group in each phenyl skeleton. "aa" is a number that gives a molecular weight of 100 to 1,000 to the compounds of the formulae (J8) and (J9).

The amount of the dissolution inhibitor (J) to be contained can be more than 0 parts by mass and 50 parts by mass or less, preferably 5 to 50 parts by mass, and more preferably 5 to 20 parts by mass based on 100 parts by mass of the component (A) polymer. One dissolution inhibitor can be used or a mixture of two or more thereof can be used. When the component (J) is contained, resolution is improved, and when the contained amount is 50 parts by mass or less, film loss of patterns does not occur, and resolution is not degraded.

### [Negative Photosensitive Resin Composition]

Among photosensitive resin compositions containing the inventive polymer as a base resin, a negative photosensitive resin composition capable of alkaline development will be described. The inventive negative photosensitive resin composition can be, for example, an embodiment to be described below, but is not limited thereto.

The inventive negative photosensitive resin composition contains:
(A) a polymer containing the structural unit (1) and/or the structural unit (2) and the structural unit (3) and/or the structural unit (4);
(B') a photoacid generator;
(C) one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (C-1), and a compound containing two or more nitrogen atoms each having a glycidyl group represented by the following formula (C-2), 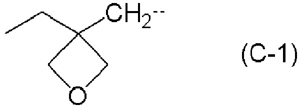 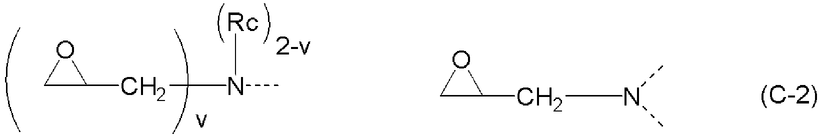 where a dotted line represents an attachment point, Rc represents a linear, branched, or cyclic alkyl group having 1 to 6 carbon atoms, and "v" represents 1 or 2; and
(D) a solvent.

The component (A) of the negative photosensitive resin composition is a polymer containing the structural unit (1) and/or the structural unit (2) and the structural unit (3) and/or the structural unit (4). The amount of the component (A) to be contained is preferably 1 to 50 parts by mass, more preferably 5 to 40 parts by mass, and further preferably 10 to 30 parts by mass based on 100 parts by mass of the entire composition. Moreover, one kind of the component (A) may be used, or two or more kinds thereof may be used in combination.

In the negative photosensitive resin composition, crosslinking groups of the component (C) can be crosslinked with the polymer of the component (A) by using an acid generated from the component (B') as a catalyst, thereby forming a negative type photosensitive resin composition.

The component (B') of the negative photosensitive resin composition is a photoacid generator. The photoacid generator (B') contained in the inventive negative photosensitive resin composition is not particularly limited, and can be a material which generates an acid by irradiation with light having a wavelength of 190 to 500 nm, and the acid serves as a curing catalyst. Examples of such a photoacid generator include onium salts, diazomethane derivatives, glyoxime derivatives, oximesulfonate derivatives, β-ketosulfone derivatives, disulfone derivatives, nitrobenzylsulfonate derivatives, sulfonate ester derivatives, imid-yl-sulfonate derivatives, iminosulfonate derivatives triazine derivatives, etc. As described in detail below, one of these materials can be used or two or more thereof may be used in mixture.

Examples of the onium salt include compounds represented by the following general formula (51).

(R₆)ⱼM⁺K⁻ (51)

In the formula, R₆ represents a linear, branched, or cyclic alkyl group having 1 to 12 carbon atoms, an aryl group having 6 to 12 carbon atoms, or an aralkyl group having 7 to 12 carbon atoms, all of which optionally have a substituent; M⁺ represents an iodonium ion or a sulfonium ion; K⁻ represents a non-nucleophilic counter ion; and "j" represents 2 or 3.

In R₆, examples of the linear, branched, or cyclic alkyl group having 1 to 12 carbon atoms include a methyl group, an ethyl group, a propyl group, a butyl group, a cyclohexyl group, a 2-oxocyclohexyl group, a norbornyl group, an adamantyl group, etc. Examples of the aryl group having 6 to 12 carbon atoms include a phenyl group; alkoxyphenyl groups, such as o-, m- or p-methoxyphenyl group, ethoxyphenyl group, and m- or p-tert-butoxyphenyl group; and alkylphenyl groups, such as 2-, 3-, or 4-methylphenyl group, ethylphenyl group, 4-tert-butylphenyl group, 4-butylphenyl group, and dimethylphenyl group; etc. Examples of the aralkyl group having 7 to 12 carbon atoms include a benzyl group, a phenethyl group, etc.

Examples of the non-nucleophilic counter ion of K⁻include halide ions, such as chloride ion and bromide ion; fluoroalkylsulfonates, such as triflate, 1,1,1-trifluoroethanesulfonate and nonafluorobutanesulfonate; arylsulfonates, such as tosylate, benzenesulfonate, 4-fluorobenzenesulfonate and 1,2,3,4,5-pentafluorobenzenesulfonate; and alkylsulfonates, such as mesylate and butanesulfonate; etc.

Examples of the diazomethane derivative include a compound represented by the following general formula (52) .

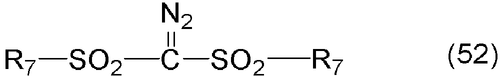

In the formula, R₇s are identical to or different from each other and each represent a linear, branched, or cyclic alkyl group or halogenated alkyl group having 1 to 12 carbon atoms, an aryl group or halogenated aryl group having 6 to 12 carbon atoms, or an aralkyl group having 7 to 12 carbon atoms.

In R₇, examples of the linear, branched, or cyclic alkyl group having 1 to 12 carbon atoms include a methyl group, an ethyl group, a propyl group, a butyl group, an amyl group, a cyclopentyl group, a cyclohexyl group, a norbornyl group, an adamantyl group, etc. Examples of the linear, branched, or cyclic halogenated alkyl group having 1 to 12 carbon atoms include a trifluoromethyl group, a 1,1,1-trifluoroethyl group, a 1,1,1-trichloroethyl group, a nonafluorobutyl group, etc. Examples of the aryl group having 6 to 12 carbon atoms include a phenyl group; alkoxyphenyl groups, such as o-, m- or p-methoxyphenyl group, ethoxyphenyl group, and m- or p-tert-butoxyphenyl group; and alkylphenyl groups, such as 2-, 3-, or 4-methylphenyl group, ethylphenyl group, 4-tert-butylphenyl group, 4-butylphenyl group, and dimethylphenyl group; etc. Examples of the halogenated aryl group having 6 to 12 carbon atoms include a fluorophenyl group, a chlorophenyl group, a 1,2,3,4,5-pentafluorophenyl group, etc. Examples of the aralkyl group having 7 to 12 carbon atoms include a benzyl group, a phenethyl group, etc.

Specific examples of such a photoacid generator include: onium salts, such as diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate and diphenyl(4-thiophenoxyphenyl)sulfonium hexafluoroantimonate; diazomethane derivatives, such as bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-amylsulfonyl)diazomethane, bis(isoamylsulfonyl)diazomethane, bis(sec-amylsulfonyl)diazomethane, bis(tert-amylsulfonyl)diazomethane, 1-cyclohexylsulfonyl-1-(tert-butylsulfonyl)diazomethane, 1-cyclohexylsulfonyl-1-(tert-amylsulfonyl)diazomethane and 1-tert-amylsulfonyl-1-(tert-butylsulfonyl)diazomethane; glyoxime derivatives, such as bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluorooctanesulfonyl)-α-dimethylglyoxime, bis-o-(cyclohexanesulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime and bis-o-(camphorsulfonyl)-α-dimethylglyoxime; oximesulfonate derivatives, such as α-(benzenesulfonium oxyimino)-4-methylphenylacetonitrile; β-ketosulfone derivatives, such as 2-cyclohexylcarbonyl-2-(p-toluenesulfonyl)propane and 2-isopropylcarbonyl-2-(p-toluenesulfonyl)propane; disulfone derivatives, such as diphenyldisulfone and dicyclohexyldisulfone; nitrobenzylsulfonate derivatives, such as 2,6-dinitrobenzyl p-toluenesulfonate and 2,4-dinitrobenzyl p-toluenesulfonate; sulfonate ester derivatives, such as 1,2,3-tris(methanesulfonyloxy)benzene, 1,2,3-tris(trifluoromethanesulfonyloxy)benzene, 1,2,3-tris(p-toluenesulfonyloxy)benzene; imid-yl-sulfonate derivatives, such as phthalimid-yl-triflate, phthalimid-yl-tosylate, 5-norbornene 2,3-dicarboxyimid-yl-triflate, 5-norbornene 2,3-dicarboxyimid-yl-tosylate, 5-norbornene 2,3-dicarboxyimid-yl-n-butyl-sulfonate and n-trifluoromethylsulfonyloxynaphthylimide; iminosulfonate derivatives, such as (5-(4-methylphenyl)sulfonyloxyimino-5H-thiophen-2-ylidene)-(2-methylphenyl)acetonitrile and (5-(4-(4-methylphenylsulfonyloxy)phenylsulfonyloxyimino)-5H-thiophen-2-ylidene)-(2-methylphenyl)-acetonitrile; 2-methyl-2[(4-methylphenyl)sulfonyl]-1-[(4-methylthio)phenyl]-1-propane, etc. Among them, imid-yl-sulfonate derivatives, iminosulfonate derivatives, oximesulfonate derivatives and the like are suitably used. One of the photoacid generators, or two or more thereof can be used.

The photoacid generator of the component (B') is contained in an amount of preferably 0.05 to 20 parts by mass, particularly preferably 0.2 to 5 parts by mass, relative to 100 parts by mass of the component (A) in the inventive negative photosensitive resin composition from the viewpoints of photoabsorption of the photoacid generator itself and photocurability in a thick film.

As the component (C) of the inventive negative photosensitive resin composition, the same crosslinking agents as the component (C) described for the second embodiment of the positive photosensitive resin composition can be favorably used.

As described above, the component (C) of the inventive negative photosensitive resin composition is a component that not only can form a negative type pattern by using an acid generated from the component (B') as a catalyst to crosslink the crosslinking groups of the component (C) with the polymer of component (A), but also causes crosslinking reaction in the post-curing after the patterning, thereby further increases the strength of a cured product. The weight-average molecular weight of such component (C) is preferably 150 to 10,000 and particularly preferably 200 to 3,000 from the viewpoints of photocurability and heat resistance.

The component (C) is contained in an amount of preferably 0.5 to 50 parts by mass, particularly preferably 1 to 30 parts by mass, relative to 100 parts by mass of the component (A) in the inventive negative photosensitive resin composition.

As the solvent of the component (D), the solvents exemplified for the positive photosensitive resin composition can be favorably used.

The component (D) is contained in an amount of preferably 50 to 2,000 parts by mass, particularly preferably 100 to 1,000 parts by mass, relative to 100 parts by mass of a total amount of the components (A) and (B') to be contained.

The inventive negative photosensitive resin composition can further contain, besides the components (A), (B'), (C), and (D), a basic compound as a component (K) as necessary. As this basic compound, suitable is a compound that can inhibit a diffusion rate of the acid which is generated from the photoacid generator, and which diffuses in the resist film. Moreover, by blending the basic compound, the resolution can be improved, change in sensitivity after exposure can be inhibited, a substrate or environment dependency can be reduced, and exposure margin, pattern shape and the like can be improved.

Examples of the basic compound may include ammonia, primary, secondary and tertiary aliphatic amines, hybrid amines, aromatic amines, heterocyclic amines, nitrogen-containing compounds having a carboxy group, nitrogen-containing compounds having a sulfonyl group, nitrogen-containing compounds having a hydroxy group, nitrogen-containing compounds having a hydroxyphenyl group, alcoholic nitrogen-containing compounds, amide derivatives, imide derivatives, compounds represented by the following general formula (53), etc.

N(α)_{q}(β)_{3-q} (53)

In the formula, q=1, 2, or 3. The side chain α may be identical to or different from the other(s), and is any of the substituents represented by the following general formulae (54) to (56). The side chain β may be identical to or different from the other(s), and represents a hydrogen atom, or a linear, branched or cyclic alkyl group having 1 to 20 carbon atoms, which may contain an ether bond or a hydroxy group. In addition, the side chains α may be bonded to each other to form a ring.

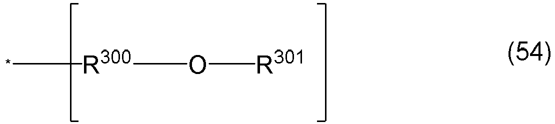

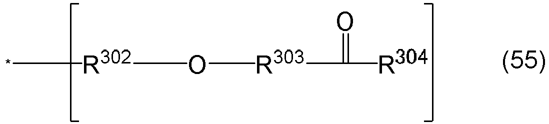

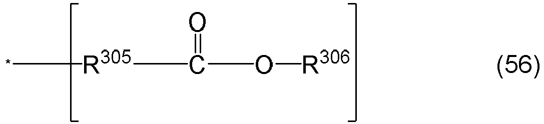

Here, R³⁰⁰, R³⁰² and R³⁰⁵ are each a linear or branched alkylene group having 1 to 4 carbon atoms, and R³⁰¹ and R³⁰⁴ are each a hydrogen atom or a linear, branched or cyclic alkyl group having 1 to 20 carbon atoms, each of which may contain one or more hydroxy groups, ether bonds, ester bonds or lactone rings. R³⁰³ is a single bond or a linear or branched alkylene group having 1 to 4 carbon atoms, and R³⁰⁶ is a linear, branched or cyclic alkyl group having 1 to 20 carbon atoms, each of which may contain one or more hydroxy groups, ether bonds, ester bonds or lactone rings. Note that "*" represents a bonding end.

Examples of the primary aliphatic amine include methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, tetraethylenepentamine, etc.

Examples of the secondary aliphatic amine include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, N,N-dimethyltetraethylenepentamine, etc.

Examples of the tertiary aliphatic amine include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, N,N,N',N'-tetramethyltetraethylenepentamine, etc.

Examples of the hybrid amine include dimethylethylamine, methylethylpropylamine, benzylamine, phenethyl amine, benzyldimethylamine, etc.

Examples of the aromatic amine and the heterocyclic amine include aniline derivatives (for example, aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, N,N-dimethyltoluidine, etc.), diphenyl(p-tolyl)amine, methyldiphenylamine, triphenylamine, phenylenediamine, naphthylamine, diaminonaphthalene, pyrrole derivatives (for example, pyrrole, 2H-pyrrole, 1-methylpyrrole, 2,4-dimethylpyrrole, 2,5-dimethylpyrrole, N-methylpyrrole, etc.), oxazole derivatives (for example, oxazole, isoxazole, etc.), thiazole derivatives (for example, thiazole, isothiazole, etc.), imidazole derivatives (for example, imidazole, 4-methylimidazole, 4-methyl-2-phenylimidazole, etc.), pyrazole derivatives, furazan derivatives, pyrroline derivatives (for example, pyrroline, 2-methyl-1-pyrroline, etc.), pyrrolidine derivatives (for example, pyrrolidine, N-methylpyrrolidine, pyrrolidinone, N-methylpyrrolidon, etc.), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperadine derivatives, morpholine derivatives, indole derivatives, isoindole derivatives, 1H-indazole derivatives, indoline derivatives, quinoline derivatives (for example, quinoline, 3-quinolinecarbonitrile, etc.), isoquinoline derivatives, cinnoline derivatives, quinazoline derivatives, quinoxaline derivatives, phthalazine derivatives, purine derivatives, puteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, etc.

Examples of the nitrogen-containing compound having a carboxy group include aminobenzoic acid, indolecarboxylic acid, amino acid derivatives (such as, for example, nicotinic acid, alanine, arginine, aspartic acid, glutamic acid, glycine, histidine, isoleucine, glycylleucine, leucine, methionine, phenylalanine, threonine, lysine, 3-aminopyrazine-2-carboxylic acid, methoxyalanine), etc.

Examples of the nitrogen-containing compound having a sulfonyl group include 3-pyridinesulfonic acid pyridinium p-toluenesulfonate, etc.

Examples of the nitrogen-containing compound having a hydroxy group, the nitrogen-containing compound having a hydroxyphenyl group, and the alcoholic nitrogen-containing compound include 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperadine, 1-[2-(2-hydroxyethoxy)ethyl]piperadine, piperidineethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyjulolidine, 3-quinuclidinol, 3-tropanol, 1-methyl-2-pyrrolidineethanol, 1-aziridineethanol, N-(2-hydroxyethyl)phthalimide, N-(2-hydroxyethyl)isonicotinamide, etc.

Examples of the amide derivative include formamide, N-methylformamide, N,N-dimethylformamide, acetamide, N-methylacetamide, N,N-dimethylacetamide, propionamide, benzamide, etc. Examples of the imide derivative include phthalimide, succinimide, maleimide, etc.

Examples of the compound represented by the above-described general formula (53) include, but are not limited to tris[2-(methoxymethoxy)ethyl]amine, tris[2-(2-methoxyethoxy)ethyl]amine, tris[2-(2-methoxyethoxymethoxy)ethyl]amine, tris[2-(1-methoxyethoxy)ethyl]amine, tris[2-(1-ethoxyethoxy)ethyl]amine, tris[2-(1-ethoxypropoxy)ethyl]amine, tris[2-{2-(2-hydroxyethoxy)ethoxy}ethyl]amine, 4,7,13,16,21,24-hexaoxa-1,10-diazabicyclo[8.8.8]hexacosane, 4,7,13,18-tetraoxa-1,10-diazabicyclo[8.5.5]eicosane, 1,4,10,13-tetraoxa-7,16-diazabicyclooctadecane, 1-aza-12-crown-4, 1-aza-15-crown-5, 1-aza-18-crown-6, tris(2-formyloxyethyl)amine, tris(2-acetoxyethyl)amine, tris(2-propionyloxyethyl)amine, tris(2-butyryloxyethyl)amine, tris(2-isobutyryloxyethyl)amine, tris(2-valeryloxyethyl)amine, tris(2-pivaloyloxyethyl)amine, N,N-bis(2-acetoxyethyl)2-(acetoxyacetoxy)ethylamine, tris(2-methoxycarbonyloxyethyl)amine, tris(2-tert-butoxycarbonyloxyethyl)amine, tris[2-(2-oxopropoxy)ethyl]amine, tris[2-(methoxycarbonylmethyl)oxyethyl]amine, tris[2-(tert-butoxycarbonylmethyloxy)ethyl]amine, tris[2-(cyclohexyloxycarbonylmethyloxy)ethyl]amine, tris(2-methoxycarbonylethyl)amine, tris(2-ethoxycarbonylethyl)amine, N,N-bis(2-hydroxyethyl)2-(methoxycarbonyl)ethylamine, N,N-bis(2-acetoxyethyl)2-(methoxycarbonyl)ethylamine, N,N-bis(2-hydroxyethyl)2-(ethoxycarbonyl)ethylamine, N,N-bis(2-acetoxyethyl)2-(ethoxycarbonyl)ethylamine, N,N-bis(2-hydroxyethyl)2-(2-methoxyethoxycarbonyl)ethylamine, N,N-bis(2-acetoxyethyl)2-(2-methoxyethoxycarbonyl)ethylamine, N,N-bis(2-hydroxyethyl)2-(2-hydroxyethoxycarbonyl)ethylamine, N,N-bis(2-acetoxyethyl)2-(2-acetoxyethoxycarbonyl)ethylamine, N,N-bis(2-hydroxyethyl)2-[(methoxycarbonyl)methoxycarbonyl]ethylamine, N,N-bis(2-acetoxyethyl)2-[(methoxycarbonyl)methoxycarbonyl]ethylamine, N,N-bis(2-hydroxyethyl)2-(2-oxopropoxycarbonyl)ethylamine, N,N-bis(2-acetoxyethyl)2-(2-oxopropoxycarbonyl)ethylamine, N,N-bis(2-hydroxyethyl)2-(tetrahydrofurfuryloxycarbonyl)ethylamine, N,N-bis(2-acetoxyethyl)2-(tetrahydrofurfuryloxycarbonyl)ethylamine, N,N-bis(2-hydroxyethyl)2-[(2-oxotetrahydrofuran-3-yl)oxycarbonyl]ethylamine, N,N-bis(2-acetoxyethyl)2-[(2-oxotetrahydrofuran-3-yl)oxycarbonyl]ethylamine, N,N-bis(2-hydroxyethyl)2-(4-hydroxybutoxycarbonyl)ethylamine, N,N-bis(2-formyloxyethyl)2-(4-formyloxybutoxycarbonyl)ethylamine, N,N-bis(2-formyloxyethyl)2-(2-formyloxyethoxycarbonyl)ethylamine, N,N-bis(2-methoxyethyl)2-(methoxycarbonyl)ethylamine, N-(2-hydroxyethyl)bis[2-(methoxycarbonyl)ethyl]amine, N-(2-acetoxyethyl)bis[2-(methoxycarbonyl)ethyl]amine, N-(2-hydroxyethyl)bis[2-(ethoxycarbonyl)ethyl]amine, N-(2-acetoxyethyl)bis[2-(ethoxycarbonyl)ethyl]amine, N-(3-hydroxy-1-propyl)bis[2-(methoxycarbonyl)ethyl]amine, N-(3-acetoxy-1-propyl)bis[2-(methoxycarbonyl)ethyl]amine, N-(2-methoxyethyl)bis[2-(methoxycarbonyl)ethyl]amine, N-butylbis[2-(methoxycarbonyl)ethyl]amine, N-butylbis[2-(2-methoxyethoxycarbonyl)ethyl]amine, N-methylbis(2-acetoxyethyl)amine, N-ethylbis(2-acetoxyethyl)amine, N-methylbis(2-pivaloyloxyethyl)amine, N-ethylbis[2-(methoxycarbonyloxy)ethyl]amine, N-ethylbis[2-(tert-butoxycarbonyloxy)ethyl]amine, tris(methoxycarbonylmethyl)amine, tris(ethoxycarbonylmethyl)amine, N-butylbis(methoxycarbonylmethyl)amine, N-hexylbis(methoxycarbonylmethyl)amine, and β-(diethylamino)-δ-valerolactone.

One of the above-described basic compounds, or two or more thereof can be used.

The basic compound is contained in an amount of preferably 0 to 3 parts by mass, particularly preferably 0.01 to 1 parts by mass, relative to 100 parts by mass of the component (A) in the inventive negative photosensitive resin composition from the viewpoint of sensitivity.

The inventive negative photosensitive resin composition can also further contain other components besides the components (A), (B'), (C), (D), and (K). As the other components, the composition can contain one or more selected from (E) a thermal acid generator, (F) a protective amine compound, (G) an antioxidant, (H) a silane compound, (I) a surfactant, (J) a dissolution inhibitor, etc. and for each component, the materials described in the case of the positive photosensitive resin composition can be favorably used.

### (Patterning Process)

Next, patterning processes using the inventive positive photosensitive resin composition and negative photosensitive resin composition will be described.

The present invention provides a patterning process including the steps of:
(1) applying the above-described positive photosensitive resin composition onto a substrate to form a photosensitive material film;
(2) heating the photosensitive material film;
(3) exposing the photosensitive material film with a high-energy beam having a wavelength of 190 to 500 nm or an electron beam through a photomask; and
(4) developing the film with a developing solution of an aqueous alkaline solution.

The present invention also provides a patterning process including the steps of:
(I) applying the above-described negative photosensitive resin composition onto a substrate to form a photosensitive material film;
(II) heating the photosensitive material film;
(III) exposing the photosensitive material film with a high-energy beam having a wavelength of 190 to 500 nm or an electron beam through a photomask; and
(IV) after irradiation, subjecting the substrate to heat treatment, followed by development using a developing solution of an aqueous alkaline solution.

In the case of either the positive photosensitive resin composition or the negative photosensitive resin composition according to the present invention, a pattern may be formed by employing a known lithography technology. For example, a silicon wafer, an SiO₂ substrate, an SiN substrate, or a substrate on which a pattern of copper wiring or the like has been formed is coated with the photosensitive resin composition by a spin coating technique (spin coating method) and pre-baked under conditions of about 80 to 130°C for about 50 to 600 seconds to form a photosensitive material film with a thickness of 1 to 50 pm, preferably 1 to 30 pm, further preferably 5 to 20 µm.

In the spin coating method, the photosensitive resin composition can be applied onto the silicon substrate by dispensing the photosensitive resin composition onto the substrate in an amount of approximately 5 mL, and then rotating the substrate. Upon this, the film thickness of the photosensitive material film on the substrate can be readily controlled by adjusting the rotation speed. Then, the remaining solvent can be removed by pre-baking.

Then, a mask for forming the target pattern is put on the photosensitive material film, and a high energy beam, such as i-line and g-line, having a wavelength of 190 to 500 nm or an electron beam is applied thereto with an exposure value of approximately 1 to 5,000 mJ/cm², preferably approximately 100 to 2,000 mJ/cm².

Next, as necessary, between the exposure step and the development step, heating treatment after the exposure (post-exposure baking (PEB)) may be carried out on a hot plate at 60 to 150°C for 1 to 10 minutes, preferably at 80 to 120°C for 1 to 5 minutes.

Thereafter, development is performed. For the above-described inventive positive photosensitive resin composition and negative photosensitive resin composition, alkaline development with an aqueous alkaline solution is possible.

Meanwhile, a suitable aqueous alkaline solution that can be used for the alkali development is a 2.38% aqueous solution of tetramethylammonium hydroxide (TMAH). The development can be carried out by normal methods such as spray method and paddle method, or by dipping the film in a developing solution, for example. Thereafter, by carrying out washing, rinsing, drying and the like, as necessary, a resist film having a desired pattern can be obtained.

### (Method for Forming Cured Film)

The present invention also provides a method for forming a cured film, including heating and post-curing a patterned film obtained by the above-described patterning process at a temperature of 100 to 300°C.

By heating and post-curing the patterned film obtained by the above-described patterning process at a temperature of 100 to 300°C, preferably 150 to 300°C, and further preferably 180 to 250°C, using an oven, a hot plate, etc., a cured film can be formed. When the post-curing temperature is 100 to 300°C, the crosslinking density of the film of the photosensitive resin composition can be increased and the remaining volatile components can be removed. The post-curing temperature is preferable from the viewpoints of adhesiveness to the substrate, heat resistance and strength, as well as electrical properties. The post-curing time can be 10 minutes to 10 hours.

The formed pattern described above is used for a protective film that covers a wiring, circuit, substrate and the like. Such a formed pattern and protective film have excellent insulating property, and also exhibit excellent adhesive force to wirings to be covered, to a metal layer of a circuit such as Cu, on a metal electrode existing on the substrate, or on an insulating substrate such as SiN existing in wirings or circuits to be coated. Furthermore, the pattern and protective film can also significantly improve the resolution performance for realizing further finer patterning, while having the appropriate mechanical strength as a protective film.

### (Cured Film)

The cured film thus obtained is excellent in adhesiveness to a substrate, heat resistance, electrical properties, mechanical strength and chemical resistance to an alkaline stripping solution and the like. A semiconductor device using the cured film as a protective film is also excellent in reliability. In particular, the cured film can prevent cracking upon a temperature cycle test. Therefore, the cured film is suitably used as a protective film (interlayer insulating film or surface protective film) for electrical and electronic components, semiconductor devices, etc.

Thus, the present invention provides an interlayer insulating film or a surface protective film including a cured film obtained by curing the above-described positive photosensitive resin composition or negative photosensitive resin composition.

The protective films are effective for applications as an insulating film for semiconductor devices including a rewiring application, an insulating film for multilayer printed circuit board, a solder mask, a coverlay film, and so forth, because the protective films have the heat resistance, chemical resistance, and insulating property.

Furthermore, the present invention provides an electronic component having the interlayer insulating film or surface protective film described above.

Such an electronic component has a protective film (interlayer insulating film or surface protective film) with heat resistance, chemical resistance, and insulating property, and is thus excellent in reliability.

### EXAMPLES

Hereinafter, the present invention will be described specifically with reference to Synthesis Examples, Comparative Synthesis Examples, Examples, and Comparative Examples, but the present invention is not limited by the following Examples.

### I. Synthesis of Polymers

Chemical structural formulae and names of the compounds used in the following Synthesis Examples are shown below. 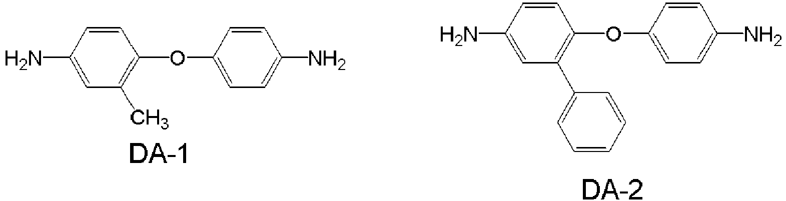 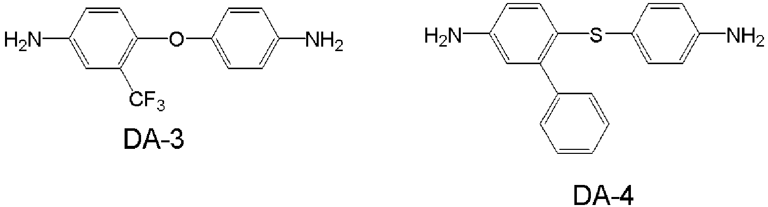 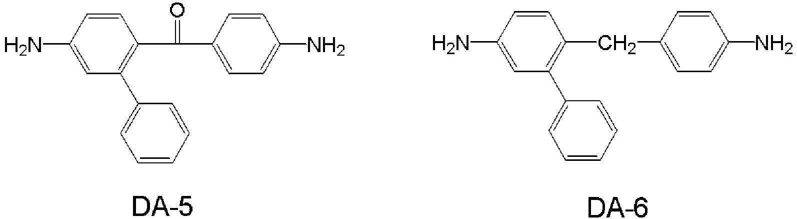 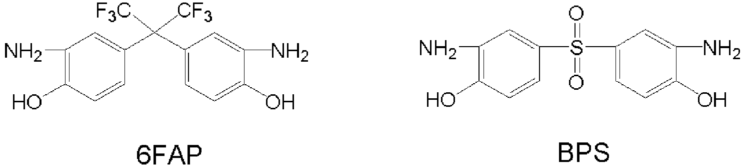 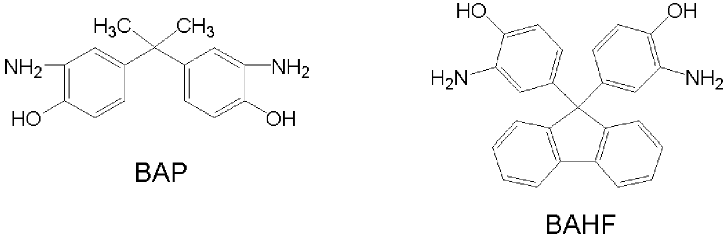 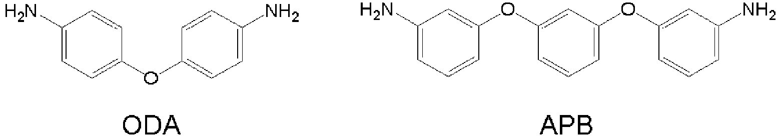 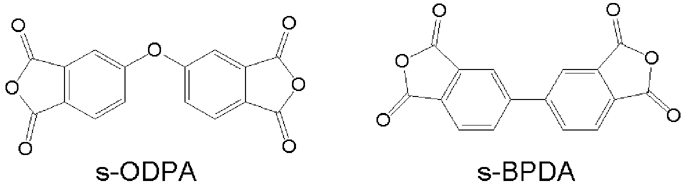 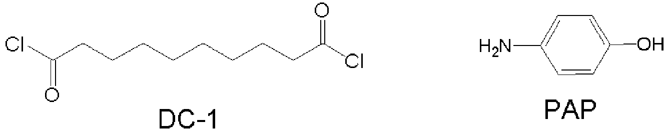 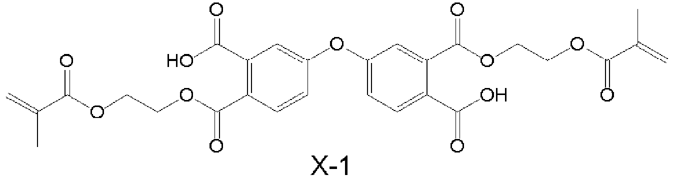
DA-1 4-(4-aminophenoxy)-3-methylbenzenamine
DA-2 2-phenyl-4,4'-diaminodiphenyl ether
DA-3 4-(4-aminophenoxy)-3-(trifluoromethyl)benzenamine
DA-4 4-((4-aminophenyl)thio)-3-phenylbenzenamine
DA-5 (4-amino-2-(phenyl)phenyl)(4-aminophenyl)methanone
DA-6 4-((4-aminophenyl)methyl)-3-phenylbenzenamine
6FAP 2,2-bis(3-amino-4-hydroxyphenyl)hexafluoropropane
BPS bis(3-amino-4-hydroxyphenyl)sulfone
BAP 2,2-bis(3-amino-4-hydroxyphenyl)propane
BAHF 9,9-bis(3-amino-4-hydroxyphenyl)fluorene
ODA 4,4`-diaminodiphenyl ether
APB 1,3-bis(3-aminophenoxy)benzene
s-ODPA 3,3',4,4'-oxydiphthalic dianhydride
s-BPDA 3,3',4,4'-biphenyltetracarboxylic dianhydride
DC-1 sebacic acid dichloride
PAP 4-aminophenol

D-400 and RT-1000 are diamines manufactured by Huntsman Corporation.

### [Synthesis Example 1] Synthesis of Polyimide Resin (A-1)

Into a 1-L flask provided with a stirrer and a thermometer, 2.1 g (9.6 mmol) of DA-1, 30.0 g (81.9 mmol) of 6FAP, 1.0 g (9.6 mmol) of PAP, and 132 g of N-methyl-2-pyrrolidone were added, followed by dissolving by stirring at room temperature. Next, under room temperature, a solution in which 29.9 g (96.4 mmol) of s-ODPA was dissolved in 269 g of N-methyl-2-pyrrolidone was dropped thereto, followed by stirring for 1 hour under room temperature after dropping. Thereafter, 20 g of xylene was added to the reaction liquid, followed by heating and refluxing for 3 hours while removing water generated at 170°C outside the system. After cooling to room temperature, the reaction liquid was dropped into 2 L of ultrapure water under stirring, a precipitate was collected by filtration to be washed appropriately with water, followed by drying under reduced pressure at 40°C for 48 hours. Thus, a polyimide resin (A-1) was obtained. The molecular weight of the polymer was measured by GPC. The weight-average molecular weight was 34,000 in terms of polystyrene.

### [Synthesis Example 11] Synthesis of Polyamide-Imide Resin (A-11)

Into a 1-L flask provided with a stirrer and a thermometer, 2.1 g (9.6 mmol) of DA-1, 30.0 g (81.9 mmol) of 6FAP, 1.0 g (9.6 mmol) of PAP, and 132 g of N-methyl-2-pyrrolidone were added, followed by dissolving by stirring at room temperature. Next, under room temperature, a solution in which 23.9 g (77.1 mmol) of s-ODPA was dissolved in 215 g of N-methyl-2-pyrrolidone was dropped thereto, followed by stirring for 1 hour under room temperature after dropping. Thereafter, 20 g of xylene was added to the reaction liquid, followed by heating and refluxing for 3 hours while removing water generated at 170°C outside the system. After cooling to room temperature, 3.1 g (38.6 mmol) of pyridine was added thereto, and 4.6 g (19.3 mmol) of DC-1 was dropped thereto so as to keep the temperature to 20°C or lower. After completion of the dropping, the reaction liquid was dropped into 2 L of ultrapure water under stirring. A precipitate was collected by filtration to be washed appropriately with water, followed by drying under reduced pressure at 40°C for 48 hours. Thus, a polyamide-imide resin (A-11) was obtained. The molecular weight of the polymer was measured by GPC. The weight-average molecular weight was 33,000 in terms of polystyrene.

### [Synthesis Example 17] Synthesis of Polyamide Resin (A-17)

Into a 1-L flask provided with a stirrer and a thermometer, 2.7 g (9.6 mmol) of DA-2, 30.0 g (81.9 mmol) of 6FAP, 1.0 g (9.6 mmol) of PAP, and 135 g of N-methyl-2-pyrrolidone were added, followed by dissolving by stirring at room temperature. Next, 15.3 g (192.8 mmol) of pyridine was added thereto, and 23.1 g (96.4 mmol) of DC-1 was dropped thereto so as to keep the temperature to 20°C or lower. After completion of the dropping, the reaction liquid was dropped into 2 L of ultrapure water under stirring. A precipitate was collected by filtration to be washed appropriately with water, followed by drying under reduced pressure at 40°C for 48 hours. Thus, a polyamide resin (A-17) was obtained. The molecular weight of the polymer was measured by GPC. The weight-average molecular weight was 38,000 in terms of polystyrene.

### [Synthesis Example 18] Synthesis of Tetracarboxylic Acid Diester Compound (X-1)

Into a 3-L flask provided with a stirrer and a thermometer, 100 g (322 mmol) of s-ODPA, 65.2 g (644 mmol) of triethylamine, 39.3 g (322 mmol) of N,N-dimethyl-4-aminopyridine, and 400 g of γ-butyrolactone were added, under stirring at room temperature, 83.8 g (644 mmol) of hydroxyethylmethacrylate (HEMA) was dropped thereto, followed by stirring for 24 hours under room temperature. After that, 370 g of a 10% aqueous solution of hydrochloric acid was dropped in under ice cooling to terminate the reaction. To the reaction liquid, 800 g of 4-methyl-2-pentanone was added to sample an organic layer, followed by washing 6 times with 600 g of water. A solvent of the obtained organic layer was distilled off and 180 g of a tetracarboxylic acid diester compound (X-1) was obtained.

### [Synthesis Example 19] Synthesis of Polyimide Precursor (A-18)

Into a 1-L flask provided with a stirrer and a thermometer, 44.0 g (77.1 mmol) of X-1 and 176 g of N-methyl-2-pyrrolidone were added, followed by dissolving by stirring at room temperature. Next, under ice cooling, 18.8 g (158.1 mmol) of thionyl chloride was dropped thereto so as to keep the reaction solution temperature to 10°C or lower. After completion of the dropping, the solution was stirred under ice cooling for 2 hours. Subsequently, 4.6 g (19.3 mmol) of DC-1 was added thereto, and then a solution obtained by dissolving 2.7 g (9.6 mmol) of DA-2, 30.0 g (81.9 mmol) of 6FAP, 1.0 g (9.6 mmol) of PAP, and 15.3 g (192.8 mmol) of pyridine with 135 g of N-methyl-2-pyrrolidone was dropped thereto under ice cooling so as to keep the reaction solution temperature to 10°C or lower. After completion of the dropping, the temperature was restored to room temperature, and the reaction liquid was dropped into 3 L of water under stirring. A precipitate was collected by filtration to be washed appropriately with water, followed by drying under reduced pressure at 40°C for 48 hours. Thus, a polyimide precursor (A-18) was obtained. The molecular weight of the polymer was measured by GPC. The weight-average molecular weight was 35,000 in terms of polystyrene.

### [Synthesis Example 2] to [Synthesis Example 10], [Synthesis Example 12] to [Synthesis Example 16], and [Comparative Synthesis Examples 1 and 2] Synthesis of Polyimide Resin or Polyamide-Imide Resin (A-2) to (A-10), (A-12) to (A-16), (A-19), and (A-20)

Using the compounds in the weight shown in Table 1 below as diamine compounds, monoamine compounds, tetracarboxylic dianhydrides, and a dicarboxylic acid dichloride, resins (A-2) to (A-10), (A-12) to (A-16), (A-19), and (A-20) were obtained by a method similar to that in Synthesis Example 1 in the case of a polyimide resin, and by a method similar to that in Synthesis Example 11 in the case of a polyamide-imide resin. The molecular weight of each polymer was measured by GPC. The weight-average molecular weight in terms of polystyrene is shown in Table 1 below.

Note that the (A-19) and (A-20) obtained in Comparative Synthesis Examples 1 and 2 do not contain structural units represented by the general formulae (1) and (2), which are essential in the present invention.

**[Table 1]**

| | | Diamine compound | | | Monoamine compound | Tetracarboxylic dianhydride | | Dicarboxylic acid dichloride | Tetracarboxylic acid diester | Molecular weight |
|---|---|---|---|---|---|---|---|---|---|---|
| Synthesis Example 1 | A-1 | DA-1 | 6FAP | | PAP | s-ODPA | | | | 34,000 |
| | | 2.1 g (9.6 mmol) | 30.0 g (81.9 mmol) | | 1.0 g (9.6 mmol) | 29.9 g (96.4 mmol) | | | | |
| Synthesis Example 2 | A-2 | DA-2 | 6FAP | | PAP | s-ODPA | | | | 33,000 |
| | | 2.7 g (9.6 mmol) | 30.0 g (81.9 mmol) | | 1.0 g (9.6 mmol) | 29.9 g (96.4 mmol) | | | | |
| Synthesis Example 3 | A-3 | DA-3 | 6FAP | | PAP | s-ODPA | | | | 33,000 |
| | | 2.6 g (9.6 mmol) | 30.0 g (81.9 mmol) | | 1.0 g (9.6 mmol) | 29.9 g (96.4 mmol) | | | | |
| Synthesis Example 4 | A-4 | DA-4 | 6FAP | | PAP | s-ODPA | | | | 32,000 |
| | | 2.8 g (9.6 mmol) | 30.0 g (81.9 mmol) | | 1.0 g (9.6 mmol) | 29.9 g (96.4 mmol) | | | | |
| Synthesis Example 5 | A-5 | DA-5 | 6FAP | | PAP | s-ODPA | | | | 34,000 |
| | | 2.8 g (9.6 mmol) | 30.0 g (81.9 mmol) | | 1.0 g (9.6 mmol) | 29.9 g (96.4 mmol) | | | | |
| Synthesis Example 6 | A-6 | DA-6 | 6FAP | | PAP | s-ODPA | | | | 33,000 |
| | | 2.6 g (9.6 mmol) | 30.0 g (81.9 mmol) | | 1.0 g (9.6 mmol) | 29.9 g (96.4 mmol) | | | | |
| Synthesis Example 7 | A-7 | DA-2 | 6FAP | | PAP | s-ODPA | s-BPDA | | | 31,000 |
| | | 2.7 g (9.6 mmol) | 30.0 g (81.9 mmol) | | 1.0 g (9.6 mmol) | 26.9 g (86.8 mmol) | 2.8 g (9.6 mmol) | | | |
| Synthesis Example 8 | A-8 | DA-2 | BPS | | PAP | s-ODPA | | | | 32,000 |
| | | 2.7 g (9.6 mmol) | 23.0 g (81.9 mmol) | | 1.0 g (9.6 mmol) | 29.9 g (96.4 mmol) | | | | |
| Synthesis Example 9 | A-9 | DA-2 | BAP | | PAP | s-ODPA | | | | 33,000 |
| | | 2.7 g (9.6 mmol) | 21.2 g (81.9 mmol) | | 1.0 g (9.6 mmol) | 2 9.9 g (96.4 mmol) | | | | |
| Synthesis Example 10 | A-10 | DA-2 | BAHF | | PAP | s-ODPA | | | | 31,000 |
| | | 2.7 g (9.6 mmol) | 31.2 g (81.9 mmol) | | 1.0 g (9.6 mmol) | 29.9 g (96.4 mmol) | | | | |
| Synthesis Example 11 | A-11 | DA-1 | 6FAP | | PAP | s-ODPA | | DC-1 | | 33,000 |
| | | 2.1 g (9.6 mmol) | 30.0 g (81.9 mmol) | | 1.0 g (9.6 mmol) | 23.9 g (77.1 mmol) | | 4.6 g (19.3 mmol) | | |
| Synthesis Example 12 | A-12 | DA-2 | 6FAP | | PAP | s-ODPA | | DC-1 | | 32,000 |
| | | 2.7 g (9.6 mmol) | 30.0 g (81.9 mmol) | | 1.0 g (9.6 mmol) | 23.9 g (77.1 mmol) | | 4.6 g (19.3 mmol) | | |
| Synthesis Example 13 | A-13 | DA-2 | 6FAP | ODA | PAP | s-ODPA | | DC-1 | | 32,000 |
| | | 2.7 g (9.6 mmol) | 26.5 g (72.3 mmol) | 1.9 g (9.6 mmol) | 1.0 g (9.6 mmol) | 23.9 g (77.1 mmol) | | 4.6 g (19.3 mmol) | | |
| Synthesis Example 14 | A-14 | DA-2 | 6FAP | APB | PAP | s-ODPA | | DC-1 | | 33,000 |
| | | 2.7 g (9.6 mmol) | 26.5 g (72.3 mmol) | 2.8 g (9.6 mmol) | 1.0 g (9.6 mmol) | 23.9 g (77.1 mmol) | | 4.6 g (19.3 mmol) | | |
| Synthesis Example 15 | A-15 | DA-2 | 6FAP | D-400 | PAP | s-ODPA | | DC-1 | | 33,000 |
| | | 2.7 g (9.6 mmol) | 26.5 g (72.3 mmol) | 3.8 g (9.6 mmol) | 1.0 g (9.6 mmol) | 23.9 g (77.1 mmol) | | 4.6 g (19.3 mmol) | | |
| Synthesis Example 16 | A-16 | DA-2 | 6FAP | RT-1000 | PAP | s-ODPA | | DC-1 | | 34,000 |
| | | 2.7 g (9.6 mmol) | 26.5 g (72.3 mmol) | 9.6 g (9.6 mmol) | 1.0 g (9.6 mmol) | 23.9 g (77.1 mmol) | | 4.6 g (19.3 mmol) | | |
| Synthesis Example 17 | A-17 | DA-2 | 6FAP | | PAP | | | DC-1 | | 38,000 |
| | | 2.7 g (9.6 mmol) | 30.0 g (81.9 mmol) | | 1.0 g (9.6 mmol) | | | 23.1 g (96.4 mmol) | | |
| Synthesis Example 19 | A-18 | DA-2 | 6FAP | | PAP | | | DC-1 | X-1 | 35,000 |
| | | 2.7 g (9.6 mmol) | 30.0 g (81.9 mmol) | | 1.0 g (9.6 mmol) | | | 4.6 g (19.3 mmol) | 44.0 g (77.1 mmol) | |
| Comparative Synthesis Example 1 | A-19 | | 6FAP | ODA | PAP | s-ODPA | | | | 34,000 |
| | | | 30.0 g (81.9 mmol) | 1.9 g (9.6 mmol) | 1.0 g (9.6 mmol) | 29.9 g (96.4 mmol) | | | | |
| Comparative Synthesis Example 2 | A-20 | | 6FAP | ODA | PAP | s-ODPA | | DC-1 | | 33,000 |
| | | | 30.0 g (81.9 mmol) | 1.9 g (9.6 mmol) | 1.0 g (9.6 mmol) | 23.9 g (77.1 mmol) | | 4.6 g (19.3 mmol) | | |

### II. Preparation of Photosensitive Resin Composition

Using the polymers synthesized in the above-described Synthesis Example 1 to Synthesis Example 19 and Comparative Synthesis Examples 1 and 2 as base resins, 20 mass% resin compositions in terms of resin were prepared with the compositions and blending amounts described in Tables 2 and 3. Thereafter, after stirring, mixing, and dissolving, micro-filtering was applied with a Teflon (registered trademark) 0.5 um filter to obtain a photosensitive resin composition. In the Tables, the solvent PGMEA represents propylene glycol monomethyl ether acetate and GBL represents γ-butyrolactone.

**[Table 2]**

| | Resin | Photosensitizer | Crosslinking agent | | Thermal acid generator | Protective amine compound | Antioxidant | Silane compound | Surfactant | Dissolution inhibitor | Solvent | |
|---|---|---|---|---|---|---|---|---|---|---|---|---|
| | Component (A) | Component (B) | Component (C) | | Component (E) | Component (F) | Component (G) | Component (H) | Component (I) | Component (J) | Component (D) | |
| Photosensitive resin composition 1 | A1 | PAC-1 | | | | | | | I-1 | | PGMEA | GBL |
| | 100 parts by weight | 20 parts by weight | | | | | | | 0.02 parts by weight | | 320 parts by weight | 80 parts by weight |
| Photosensitive resin composition 2 | A2 | PAC-1 | | | | | | | I-1 | | PGMEA | GBL |
| | 100 parts by weight | 20 parts by weight | | | | | | | 0.02 parts by weight | | 320 parts by weight | 80 parts by weight |
| Photosensitive resin composition 3 | A1 | PAC-1 | CL-1 | CL-2 | | | G-1 | H-1 | I-1 | | PGMEA | GBL |
| | 100 parts by weight | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 4 | A2 | PAC-1 | CL-1 | CL-2 | | | G-1 | H-1 | I-1 | | PGMEA | GBL |
| | 100 parts by weight | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 5 | A3 | PAC-1 | CL-1 | CL-2 | | | G-1 | H-1 | I-1 | | PGMEA | GBL |
| | 100 parts by weiqht | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 6 | A4 | PAC-1 | CL-1 | CL-2 | | | G-1 | H-1 | I-1 | | PGMEA | GBL |
| | 100 parts by weight | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 7 | A5 | PAC-1 | CL-1 | CL-2 | | | G-1 | H-1 | I-1 | | PGMEA | GBL |
| | 100 parts by weight | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 8 | A6 | PAC-1 | CL-1 | CL-2 | | | G-1 | H-1 | I-1 | | PGMEA | GBL |
| | 100 parts by weight | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 9 | A7 | PAC-1 | CL-1 | CL-2 | | | G-1 | H-1 | I-1 | | PGMEA | GBL |
| | 100 parts by weight | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 10 | A8 | PAC-1 | CL-1 | CL-2 | | | G-1 | H-1 | I-1 | | PGMEA | GBL |
| | 100 parts by weight | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 11 | A9 | PAC-1 | CL-1 | CL-2 | | | G-1 | H-1 | I-1 | | PGMEA | GBL |
| | 100 parts by weight | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 12 | A10 | PAC-1 | CL-1 | CL-2 | | | G-1 | H-1 | I-1 | | PGMEA | GBL |
| | 100 parts by weight | 20 parts by weight | 10 parts by weight | 10 parts by weight | | | 1 part by weight | 0.5 parts by weight | 0.02 parts by weight | | 320 parts by weight | 80 parts by weight |
| Photosensitive resin composition 13 | A11 | PAC-1 | CL-1 | CL-2 | E1 | | G-1 | H-1 | I-1 | | PGMEA | GBL |
| | 100 parts by weight | 20 parts by weight | 10 parts by weight | 10 parts by weight | 1 part by weight | | 1 part by weight | 0.5 parts by weight | 0.02 parts by weight | | 320 parts by weight | 80 parts by weight |
| Photosensitive resin composition 14 | A12 | PAC-1 | CL-1 | CL-2 | | F-1 | G-1 | H-1 | I-1 | | PGMEA | GBL |
| | 100 parts by weight | 20 parts by weight | 10 parts by weight | 10 parts by weight | | 1 part by weight | 1 part by weight | 0.5 parts by weight | 0.02 parts by weight | | 320 parts by weight | 80 parts by weight |
| Photosensitive resin composition 15 | A13 | PAC-1 | CL-1 | CL-2 | E1 | | G-1 | H-1 | I-1 | | PGMEA | GBL |
| | 100 parts by weight | 20 parts by weight | 10 parts by weight | 10 parts by weight | 1 part by weight | | 1 part by weight | 0.5 parts by weight | 0.02 parts by weight | | 320 parts by weight | 80 parts by weight |
| Photosensitive resin composition 16 | A14 | PAC-1 | CL-1 | CL-2 | | F-1 | G-1 | H-1 | I-1 | | PGMEA | GBL |
| | 100 parts by weight | 20 parts by weight | 10 parts by weight | 10 parts by weight | | 1 part by weight | 1 part by weight | 0.5 parts by weight | 0.02 parts by weight | | 320 parts by weight | 80 parts by weight |
| Photosensitive resin composition 17 | A15 | PAC-1 | CL-1 | CL-2 | E1 | | G-1 | H-1 | I-1 | | PGMEA | GBL |
| | 100 parts by weight | 20 parts by weight | 10 parts by weight | 10 parts by weight | 1 part by weight | | 1 part by weight | 0.5 parts by weight | 0.02 parts by weight | | 320 parts by weight | 80 parts by weight |
| Photosensitive resin composition 18 | A16 | PAC-1 | CL-1 | CL-2 | | F-1 | G-1 | H-1 | I-1 | | PGMEA | GBL |
| | 100 parts by weight | 20 parts by weight | 10 parts by weight | 10 parts by weight | | 1 part by weight | 1 part by weight | 0.5 parts by weight | 0.02 parts by weight | | 320 parts by weight | 80 parts by weight |
| Photosensitive resin composition 19 | A17 | PAC-1 | CL-1 | CL-2 | E1 | | G-1 | H-1 | I-1 | J-1 | PGMEA | GBL |
| | 100 parts by weight | 20 parts by weight | 10 parts by weight | 10 parts by weight | 1 part by weight | | 1 part by weight | 0.5 parts by weight | 0.02 parts by weight | 5 parts by weight | 320 parts by weight | 80 parts by weight |
| Photosensitive resin composition 20 | A18 | PAC-1 | CL-1 | CL-2 | | F-1 | G-1 | H-1 | I-1 | | PGMEA | GBL |
| | 100 parts by weight | 20 parts by weight | 10 parts by weight | 10 parts by weight | | 1 part by weight | 1 part by weight | 0.5 parts by weight | 0.02 parts by weight | | 320 parts by weight | 80 parts by weight |
| Comparative photosensitive resin composition 1 | A19 | PAC-1 | | | | | G-1 | H-1 | I-1 | | PGMEA | GBL |
| | 100 parts by weight | 20 parts by weight | | | | | 1 part by weight | 0.5 parts by weight | 0.02 parts by weight | | 320 parts by weight | 80 parts by weight |
| Comparative photosensitive resin composition 2 | A20 | PAC-1 | CL-1 | CL-2 | | F-1 | G-1 | H-1 | I-1 | | PGMEA | GBL |
| | 100 parts by weight | 20 parts by weight | 10 parts by weight | 10 parts by weight | | 1 part by weight | 1 part by weight | 0.5 parts by weight | 0.02 parts by weight | | 320 parts by weight | 80 parts by weight |

The photosensitive resin compositions 1 to 20 shown in Table 2 relate to the inventive positive photosensitive resin composition described above. The comparative photosensitive resin compositions 1 and 2 are compositions in which the polymers synthesized in Comparative Synthesis Examples 1 and 2 are used instead of the inventive polymers as the base resin in the inventive positive photosensitive resin compositions described above.

**[Table 3]**

| | Resin | Photoacid generator | Crosslinking agent | | | Thermal acid generator | Protective amine compound | Antioxidant | Silane compound | Surfactant | Dissolution inhibitor | Basic compound | Solvent | |
|---|---|---|---|---|---|---|---|---|---|---|---|---|---|---|
| | Component (A) | Component (B) | Component (C) | | | Component (E) | Component (F) | Component (G) | Component (H) | Component (I) | Component (J) | Component (K) | Component (D) | |
| Photosensitive resin composition 21 | A1 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 22 | A2 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 23 | A3 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 29 | A9 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 25 | A5 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 26 | A6 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 27 | A7 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 28 | A8 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 29 | A9 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 30 | A10 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Photosensitive resin composition 31 | A11 | PAG-1 | CL-3 | CL-2 | CL-1 | E-1 | | G-1 | H-1 | I-1 | | K-1 | PGMEA | GBL |
| | 100 parts by weight | 3 parts by weight | 5 parts by weight | 10 parts by weight | 10 parts by weight | 1 part by weight | | 1 part by weight | 0.5 parts by weight | 0.02 parts by weight | | 1 part by weight | 320 parts by weight | 80 parts by weight |
| Photosensitive resin composition 32 | A12 | PAG-1 | CL-3 | CL-2 | CL-1 | | F-1 | G-1 | H-1 | I-1 | | K-1 | PGMEA | GBL |
| | 100 parts by weight | 3 parts by weight | 5 parts by weight | 10 parts by weight | 10 parts by weight | | 1 part by weight | 1 part by weight | 0.5 parts by weight | 0.02 parts by weight | | 1 part by weight | 320 parts by weight | 80 parts by weight |
| Photosensitive resin composition 33 | A13 | PAG-1 | CL-3 | CL-2 | CL-1 | | | G-1 | H-1 | I-1 | | K-1 | PGMEA | GBL |
| | 100 parts by weight | 3 parts by weight | 5 parts by weight | 10 parts by weight | 10 parts by weight | | | 1 part by weight | 0.5 parts by weight | 0.02 parts by weight | | 1 part by weight | 320 parts by weight | 80 parts by weight |
| Photosensitive resin composition 34 | A14 | PAG-1 | CL-3 | CL-2 | CL-1 | | | G-1 | H-1 | I-1 | | K-1 | PGMEA | GBL |
| | 100 parts by weight | 3 parts by weight | 5 parts by weight | 10 parts by weight | 10 parts by weight | | | 1 part by weight | 0.5 parts by weight | 0.02 parts by weight | | 1 part by weight | 320 parts by weight | 80 parts by weight |
| Photosensitive resin composition 35 | A15 | PAG-1 | CL-3 | CL-2 | CL-1 | | | G-1 | H-1 | I-1 | | K-1 | PGMEA | GBL |
| | 100 parts by weight | 3 parts by weight | 5 parts by weight | 10 parts by weight | 10 parts by weight | | | 1 part by weight | 0.5 parts by weight | 0.02 parts by weight | | 1 part by weight | 320 parts by weight | 80 parts by weight |
| Photosensitive resin composition 36 | A16 | PAG-1 | CL-3 | CL-2 | CL-1 | | | G-1 | H-1 | I-1 | | K-1 | PGMEA | GBL |
| | 100 parts by weight | 3 parts by weight | 5 parts by weight | 10 parts by weight | 10 parts by weight | | | 1 part by weight | 0.5 parts by weight | 0.02 parts by weight | | 1 part by weight | 320 parts by weight | 80 parts by weight |
| Photosensitive resin composition 37 | A17 | PAG-1 | CL-3 | CL-2 | CL-1 | | | G-1 | H-1 | I-1 | J-1 | K-1 | PGMEA | GBL |
| | 100 parts by weight | 3 parts by weight | 5 parts by weight | 10 parts by weight | 10 parts by weight | | | 1 part by weight | 0.5 parts by weight | 0.02 parts by weight | 5 parts by weight | 1 part by weight | 320 parts by weight | 80 parts by weight |
| Photosensitive resin composition 38 | A18 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Comparative photosensitive resin composition 3 | A19 | PAG-1 | CL-3 | CL-2 | | | | G-1 | H-1 | I-1 | | K-1 | PGMEA | GBL |
| | 100 parts by weight | 3 parts by weight | 5 parts by weight | 10 parts by weight | | | | 1 part by weight | 0.5 parts by weight | 0.02 parts by weight | | 1 part by weight | 320 parts by weight | 80 parts by weight |
| Comparative photosensitive resin composition 4 | A20 | PAG-1 | CL-3 | CL-2 | CL-1 | E-1 | | G-1 | H-1 | I-1 | | K-1 | PGMEA | GBL |
| | 100 parts by weight | 3 parts by weight | 5 parts by weight | 10 parts by weight | 10 parts by weight | 1 part by weight | | 1 part by weight | 0.5 parts by weight | 0.02 parts by weight | | 1 part by weight | 320 parts by weight | 80 parts by weight |

The photosensitive resin compositions 21 to 38 shown in Table 3 relate to the inventive negative photosensitive resin composition described above. The comparative photosensitive resin compositions 3 and 4 are compositions in which the polymers synthesized in Comparative Synthesis Examples 1 and 2 are used instead of the inventive polymers as the base resin in the inventive negative photosensitive resin compositions described above.

Note that, in Table 2 and Table 3, details of the photosensitizer (PAC-1), being a quinonediazide compound, photoacid generator (PAG-1), crosslinking agents (CL-1) to (CL-3), thermal acid generator (E-1), protective amine compound (F-1), antioxidant (G-1), silane compound (H-1), surfactant (I-1), dissolution inhibitor (J-1), and basic compound (K-1) are as follows. "Parts by weight" has the same meaning as "parts by mass".

### Photosensitizer (PAC-1)

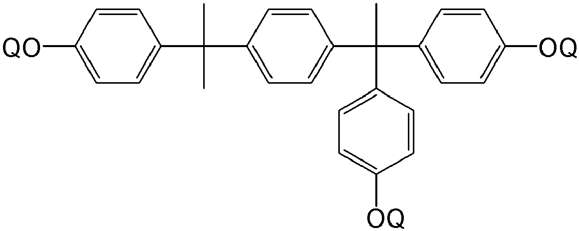

In the formula, Q represents a 1,2-naphthoquinone diazide sulfonyl group represented by the following formula (57) or a hydrogen atom, and 90% of Qs are substituted with the 1,2-naphthoquinone diazide sulfonyl group represented by the following formula (57).

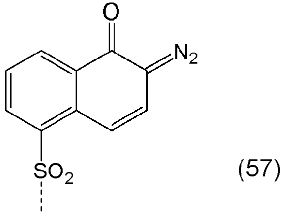

### Photoacid generator (PAG-1)

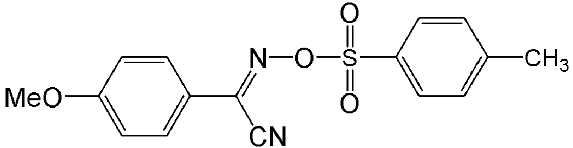

### Crosslinking agent (CL-1)

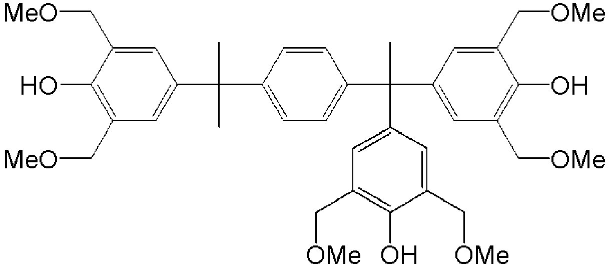

### Crosslinking agent (CL-2)

### Epoxy resin: EP4000L manufactured by ADEKA CORPORATION

### Crosslinking agent (CL-3)

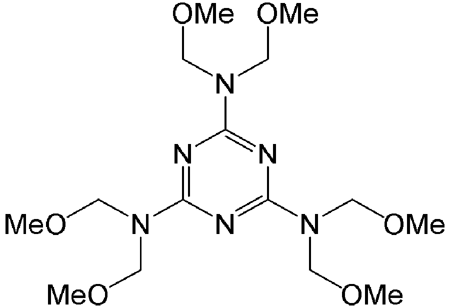

### Thermal acid generator (E-1)

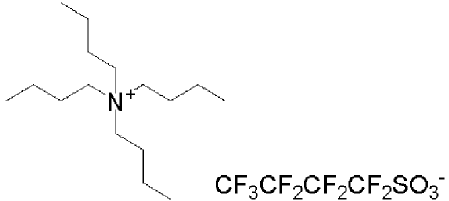

### Protective amine compound (F-1)

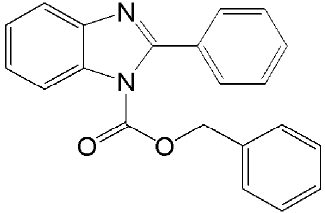

### Antioxidant (G-1)

Hindered phenol-based antioxidant: Sumilizer GA-80 manufactured by Sumitomo Chemical Co., Ltd.

### Silane compound (H-1)

Amino silane coupling agent: KBM-573 manufactured by Shin-Etsu Chemical Co., Ltd.

### Surfactant (I-1)

Fluorinated surfactant: PF-6320 manufactured by OMNOVA Solutions Inc.

### Dissolution inhibitor (J-1)

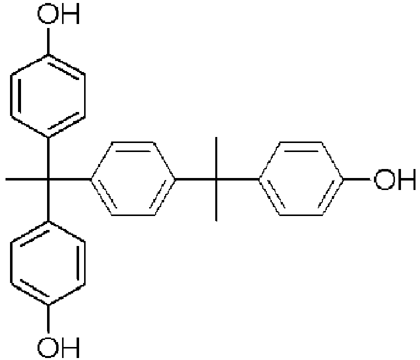

### Basic compound (K-1)

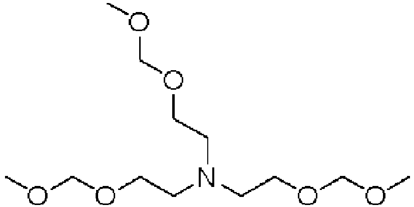

### III. Pattern formation

By rotating a substrate after each of the photosensitive resin compositions 1 to 38 and comparative photosensitive resin compositions 1 to 4 was dispensed by 5 mL on a silicon substrate, that is, by a spin-coating method, the photosensitive resin composition was applied such that a film thickness was 5 um after patterning and heating for the post-curing. That is, by studying in advance that after the post-curing step, the film thickness decreases, the rotational rate during coating was adjusted such that a finishing film thickness after the post-curing was 5 um.

Next, the compositions applied on the substrates were pre-baked on a hot plate at 100°C for 2 minutes. Then, an i-line stepper NSR-2205i11 manufactured by Nikon Corporation was used for i-line exposure and patterning. In the patterning, a mask for positive pattern or negative pattern was used appropriately in accordance with the photosensitive resin compositions used. The mask has a pattern capable of forming 20 µm holes arranged by a fineness ratio of 1:1, and can form a hole pattern of 50 µm to 20 µm holes with 10 µm pitch, 20 µm to 10 µm holes with 5 µm pitch, and 10 µm to 1 µm holes with 1 µm pitch.

Next, for those to which the heating step was performed, it was performed under conditions as shown later in Table 5.

In the development step, an aqueous alkaline solution was used as the developing solution, and a 2.38% aqueous solution of tetramethylammonium hydroxide was used as the developing solution. After performing paddle development for 1 minute with the 2.38% aqueous solution of tetramethylammonium hydroxide (TMAH) three times, rinsing with ultrapure water was carried out.

Then, the obtained pattern on the substrate was post-cured using an oven at 200°C for 2 hours while the oven was purged with nitrogen.

Next, each substrate was cut out so that the shape of the obtained hole pattern could be observed, and the shape of the hole pattern was observed by using a scanning electron microscope (SEM). The aperture of the smallest opening hole at a film thickness of 5 pm after the post-curing was determined, and the pattern shape was evaluated. Together with these results, the sensitivities at which the minimum pattern was successfully formed are shown in Tables 4 and 5.

Note that the shape of the hole pattern was evaluated by the criteria as described below, and the evaluation results were shown in Tables 4 and 5.
Good: holes were observed in a rectangular shape or forward taper shape (the shape in which the dimension of the upper part of a hole is larger than the dimension of the bottom part)
Poor: holes were observed in a reverse taper shape (the shape in which the dimension of the upper part of a hole is smaller than the dimension of the bottom part) or overhang shape (the shape in which the upper part of a hole protrudes), remarkable film thinning was observed, or residue was observed at the bottom part of a hole

### IV. Rupture Elongation and Rupture Strength

Each of the photosensitive resin compositions 1 to 38 and the comparative photosensitive resin compositions 1 to 4 was respectively applied onto an aluminum substrate by spin-coating so that a finishing film thickness after curing was 10 um. Next, pre-baking was performed on a hot plate at 100°C for 3 minutes to obtain a photosensitive resin film.

Thereafter, curing was performed with an oven at 200°C for 2 hours while purging with nitrogen to obtain a photosensitive resin cured film. Next, a wafer with a cured film was cut in strips of a width of 10 mm and a length of 60 mm, followed by peeling the cured film from the substrate by dipping in hydrochloric acid of 20 mass%. The obtained cured film was subjected to a measurement of the rupture elongation and rupture strength using an Autograph AGX-1KN manufactured by Shimadzu Corporation. The measurement was performed 10 times per sample, and an average value thereof is shown in Tables 4 and 5.

Firstly, the results obtained by carrying out the patterning using the positive photosensitive resin compositions (photosensitive resin compositions 1 to 20 and comparative photosensitive resin compositions 1 and 2) and the rupture elongation and rupture strength of the cured film are shown in Table 4.

**[Table 4]**

| | Composition | Pattern | Hole shape | Minimum hole diameter (µm) | Sensitivity (mJ/cm²) | Rupture elongation (%) | Rupture strength (MPa) |
|---|---|---|---|---|---|---|---|
| Example 1 | Photosensitive resin composition 1 | Positive type | Good | 5 | 720 | 35 | 96 |
| Example 2 | Photosensitive resin composition 2 | Positive type | Good | 5 | 740 | 40 | 98 |
| Example 3 | Photosensitive resin composition 3 | Positive type | Good | 4 | 640 | 45 | 102 |
| Example 4 | Photosensitive resin composition 4 | Positive type | Good | 4 | 660 | 50 | 110 |
| Example 5 | Photosensitive resin composition 5 | Positive type | Good | 4 | 640 | 4 8 | 105 |
| Example 6 | Photosensitive resin composition 6 | Positive type | Good | 4 | 680 | 52 | 108 |
| Example 7 | Photosensitive resin composition 7 | Positive type | Good | 4 | 660 | 55 | 110 |
| Example 8 | Photosensitive resin composition 8 | Positive type | Good | 4 | 640 | 50 | 108 |
| Example 9 | Photosensitive resin composition 9 | Positive type | Good | 4 | 620 | 52 | 110 |
| Example 10 | Photosensitive resin composition 10 | Positive type | Good | 4 | 580 | 54 | 108 |
| Example 11 | Photosensitive resin composition 11 | Positive type | Good | 4 | 640 | 53 | 106 |
| Example 12 | Photosensitive resin composition 12 | Positive type | Good | 4 | 660 | 50 | 109 |
| Example 13 | Photosensitive resin composition 13 | Positive type | Good | 3 | 560 | 60 | 110 |
| Example 14 | Photosensitive resin composition 14 | Positive type | Good | 3 | 580 | 64 | 115 |
| Example 15 | Photosensitive resin composition 15 | Positive type | Good | 4 | 600 | 62 | 112 |
| Example 16 | Photosensitive resin composition 16 | Positive type | Good | 4 | 620 | 64 | 114 |
| Example 17 | Photosensitive resin composition 17 | Positive type | Good | 4 | 580 | 65 | 110 |
| Example 18 | Photosensitive resin composition 18 | Positive type | Good | 4 | 600 | 64 | 108 |
| Example 19 | Photosensitive resin composition 19 | Positive type | Good | 4 | 480 | 62 | 102 |
| Example 20 | Photosensitive resin composition 20 | Positive type | Good | 4 | 600 | 56 | 115 |
| Comparative Example 1 | Comparative photosensitive resin composition 1 | Positive type | Good | 5 | 480 | 25 | 90 |
| Comparative Example 2 | Comparative photosensitive resin composition 2 | Positive type | Good | 5 | 380 | 35 | 100 |

As shown in Table 4, the inventive positive photosensitive resin compositions exhibit good pattern shape in the development with the aqueous alkaline solution, and the minimum hole dimensions thereof exhibit values of 5 pm or less for the finishing film thickness of 5 µm. This verified that the aspect ratio of 1 or more can be accomplished.

In addition, the inventive positive photosensitive resin compositions successfully gave a cured film having excellent mechanical properties even when cured at a low temperature of 200°C or lower.

Meanwhile, comparing Examples 1 and 2 with Comparative Example 1, which are compositions that do not contain the component (C) crosslinking agent, the composition using comparative photosensitive resin composition 1 had a pattern shape and minimum hole dimensions equivalent to those of the inventive compositions, but regarding mechanical properties, the comparative compositions had both poor rupture elongation and poor rupture strength compared to those of the cured film obtained from the inventive compositions. Similarly, comparing Examples 3 to 20 with Comparative Example 2, which are compositions that contain the component (C) crosslinking agent, the composition using comparative photosensitive resin composition 2 had a pattern shape and minimum hole dimensions equivalent to those of the inventive compositions, but regarding mechanical properties, the comparative compositions had both poor rupture elongation and poor rupture strength compared to those of the cured film obtained from the inventive compositions.

Next, the results obtained by carrying out the patterning using the negative photosensitive resin compositions (photosensitive resin compositions 21 to 38 and comparative photosensitive resin compositions 3 and 4) and the rupture elongation and rupture strength of the cured film are shown in Table 5.

**[Table 5]**

| | Composition | Pattern | Post-exposure baking | Hole shape | Minimum hole diameter (um) | Sensitivity (mJ/cm²) | Rupture elongation (%) | Rupture strength (MPa) |
|---|---|---|---|---|---|---|---|---|
| Example 21 | Photosensitive resin composition 21 | Negative type | 100°C×120 sec | Good | 5 | 940 | 40 | 105 |
| Example 22 | Photosensitive resin composition 22 | Negative type | 100°C×120 sec | Good | 5 | 940 | 45 | 110 |
| Example 23 | Photosensitive resin composition 23 | Negative type | 100°C×120 sec | Good | 5 | 940 | 42 | 108 |
| Example 24 | Photosensitive resin composition 24 | Negative type | 100°C×120 sec | Good | 5 | 960 | 44 | 110 |
| Example 25 | Photosensitive resin composition 25 | Negative type | 100°C×120 sec | Good | 5 | 980 | 45 | 112 |
| Example 26 | Photosensitive resin composition 26 | Negative type | 100°C×120 sec | Good | 5 | 960 | 42 | 105 |
| Example 27 | Photosensitive resin composition 27 | Negative type | 100°C×120 sec | Good | 5 | 960 | 42 | 115 |
| Example 28 | Photosensitive resin composition 28 | Negative type | 100°C×120 sec | Good | 5 | 920 | 44 | 112 |
| Example 29 | Photosensitive resin composition 29 | Negative type | 100°C×120 sec | Good | 5 | 940 | 42 | 110 |
| Example 30 | Photosensitive resin composition 30 | Negative type | 100°C×120 sec | Good | 5 | 980 | 42 | 115 |
| Example 31 | Photosensitive resin composition 31 | Negative type | 100°C×120 sec | Good | 4 | 860 | 55 | 112 |
| Example 32 | Photosensitive resin composition 32 | Negative type | 100°C×120 sec | Good | 4 | 880 | 58 | 115 |
| Example 33 | Photosensitive resin composition 33 | Negative type | 100°C×120 sec | Good | 4 | 880 | 60 | 120 |
| Example 34 | Photosensitive resin composition 34 | Negative type | 100°C×120 sec | Good | 4 | 880 | 62 | 122 |
| Example 35 | Photosensitive resin composition 35 | Negative type | 100°C×120 sec | Good | 5 | 860 | 58 | 112 |
| Example 36 | Photosensitive resin composition 36 | Negative type | 100°C×120 sec | Good | 5 | 880 | 60 | 105 |
| Example 37 | Photosensitive resin composition 37 | Negative type | 100°C×120 sec | Good | 5 | 820 | 65 | 100 |
| Example 38 | Photosensitive resin composition 38 | Negative type | 100°C×120 sec | Good | 5 | 900 | 45 | 112 |
| Comparative Example 3 | Comparative photosensitive resin composition 3 | Negative type | 100°C×120 sec | Good | 5 | 980 | 25 | 95 |
| Comparative Example 4 | Comparative photosensitive resin composition 4 | Negative type | 100°C×120 sec | Good | 5 | 880 | 35 | 100 |

As shown in Table 5, the inventive negative photosensitive resin compositions exhibit good pattern shape in the development with the aqueous alkaline solution, and the minimum hole dimensions thereof exhibit smaller values than the finished film thickness of 5 µm. This verified that the aspect ratio of 1 or more can be accomplished.

In addition, the inventive negative photosensitive resin compositions successfully gave a cured film having excellent mechanical properties even when cured at a low temperature of 200°C or lower.

On the other hand, the cured films using comparative photosensitive resin composition 3 and comparative photosensitive resin composition 4 had pattern shapes and minimum hole dimensions equivalent to those of the inventive compositions, but regarding mechanical properties, the comparative compositions had both poor rupture elongation and poor rupture strength.

The present description includes the following inventions.
[1]: A polymer comprising: a structural unit represented by the following general formula (1) and/or (2); and a structural unit represented by the following general formula (3) and/or (4), 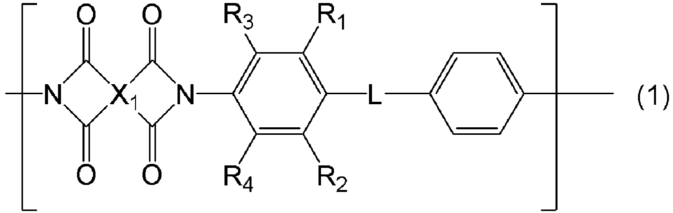 wherein X₁ represents a tetravalent organic group, R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom, and L represents a divalent organic group excluding a -O-C(=O)- bond or a -C(=O)-O- bond or represents a divalent atom, 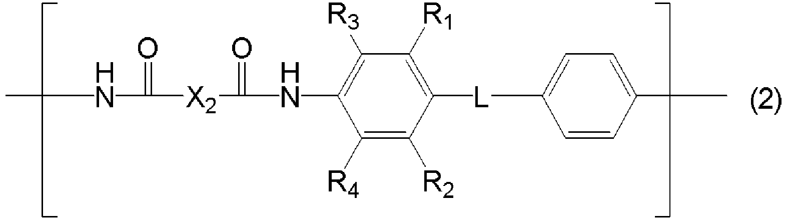 wherein X₂ represents a divalent organic group, and R₁ to R₄ and L are as defined above, 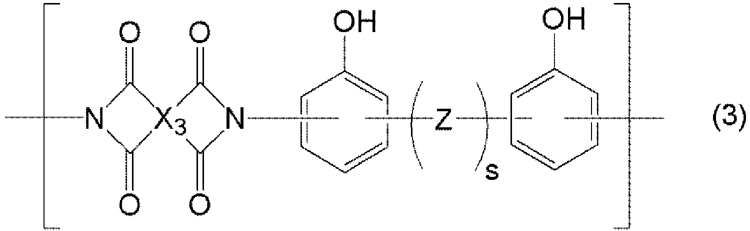 wherein X₃ represents a tetravalent organic group that is identical to or different from the X₁, "s" represents 0 or 1, Z represents a divalent bonding group, and when s=0, the two aromatic rings in the formula are directly bonded without an intervening bonding group, 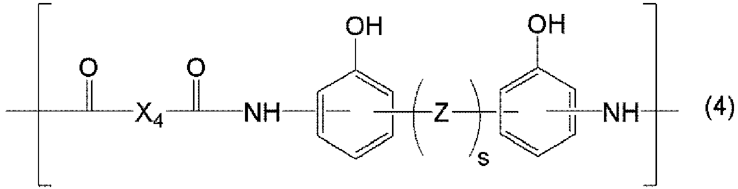 wherein X₄ represents a divalent organic group that is identical to or different from the X₂, and "s" and Z are as defined above.
[2]: The polymer according to the above [1], wherein in the general formulae (1) and (2), either one of the R₁ and the R₂ represents a monovalent organic group having 1 to 15 carbon atoms and optionally containing a heteroatom, the other of the R₁ and the R₂ represents a hydrogen atom, and the R₃ and the R₄ each represent a hydrogen atom.
[3]: The polymer according to the above [1] or [2], wherein in the general formulae (1) and (2), either one of the R₁ and the R₂ represents an aromatic group having 6 to 12 carbon atoms, and the other of the R₁ and the R₂ represents a hydrogen atom.
[4]: The polymer according to any one of the above [1] to [3], wherein the L in the general formulae (1) and (2) is at least one selected from any of an oxygen atom, a sulfur atom, a carbonyl group, a linear alkylene group having 1 to 15 carbon atoms, and a branched alkylene group having 3 to 15 carbon atoms.
[5]: The polymer according to any one of the above [1] to [4], wherein the Z in the general formulae (3) and (4) is at least one bonding group selected from any of groups represented by the following formulae (5), (6), (7), and (8), 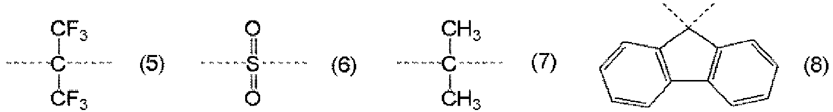 wherein a dotted line represents an attachment point.
[6]: A positive photosensitive resin composition comprising:
   (A) the polymer according to any one of the above [1] to [5];
   (B) a photosensitizer which is a compound having a quinonediazide structure and generates an acid by light to increase a dissolution rate in an aqueous alkaline solution; and
   (D) a solvent.
[7]: The positive photosensitive resin composition according to the above [6], further comprising the following component (C):
   (C) one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (C-1), and a compound containing two or more nitrogen atoms each having a glycidyl group represented by the following formula (C-2), 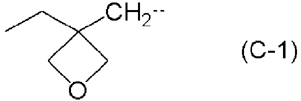 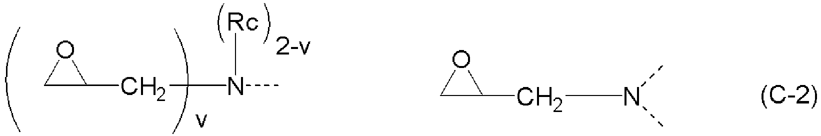 wherein a dotted line represents an attachment point, Rc represents a linear, branched, or cyclic alkyl group having 1 to 6 carbon atoms, and "v" represents 1 or 2.
[8]: A negative photosensitive resin composition comprising:
   (A) the polymer according to any one of the above [1] to [5];
   (B') a photoacid generator;
   (C) one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (C-1), and a compound containing two or more nitrogen atoms each having a glycidyl group represented by the following formula (C-2), 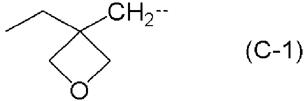 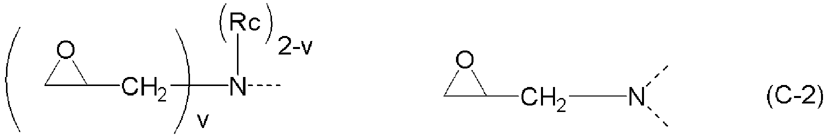 wherein a dotted line represents an attachment point, Rc represents a linear, branched, or cyclic alkyl group having 1 to 6 carbon atoms, and "v" represents 1 or 2; and
   (D) a solvent.
[9]: A patterning process comprising the steps of:
   (1) applying the positive photosensitive resin composition according to the above [6] or [7] onto a substrate to form a photosensitive material film;
   (2) heating the photosensitive material film;
   (3) exposing the photosensitive material film with a high-energy beam having a wavelength of 190 to 500 nm or an electron beam through a photomask; and
   (4) developing the film with a developing solution of an aqueous alkaline solution.
[10]: A patterning process comprising the steps of:
   (I) applying the negative photosensitive resin composition according to the above [8] onto a substrate to form a photosensitive material film;
   (II) heating the photosensitive material film;
   (III) exposing the photosensitive material film with a high-energy beam having a wavelength of 190 to 500 nm or an electron beam through a photomask; and
   (IV) after irradiation, subjecting the substrate to heat treatment, followed by development using a developing solution of an aqueous alkaline solution.
[11]: A method for forming a cured film, comprising heating and post-curing a patterned film obtained by the patterning process according to the above [9] or [10] at a temperature of 100 to 300°C.
[12]: An interlayer insulating film comprising a cured film of the positive photosensitive resin composition according to the above [6] or [7].
[13]: An interlayer insulating film comprising a cured film of the negative photosensitive resin composition according to the above [8].
[14]: A surface protective film comprising a cured film of the positive photosensitive resin composition according to the above [6] or [7].
[15]: A surface protective film comprising a cured film of the negative photosensitive resin composition according to the above [8].
[16]: An electronic component comprising the interlayer insulating film according to the above [12] or [13], or the surface protective film according to the above [14] or [15].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A polymer comprising: a structural unit represented by the following general formula (1) and/or (2); and a structural unit represented by the following general formula (3) and/or (4), 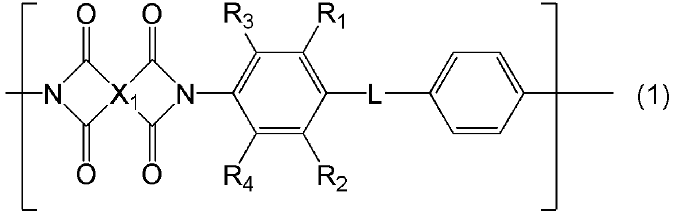 wherein X₁ represents a tetravalent organic group, R₁ to R₄ are each different from or identical to each other and represent a monovalent organic group having 1 to 15 carbon atoms and optionally containing a heteroatom or represent a hydrogen atom, provided that at least one of R₁ to R₄ represents a monovalent organic group having 1 to 15 carbon atoms and optionally containing a heteroatom, and L represents a divalent organic group excluding a -O-C(=O)- bond or a -C(=O)-O- bond or represents a divalent atom, 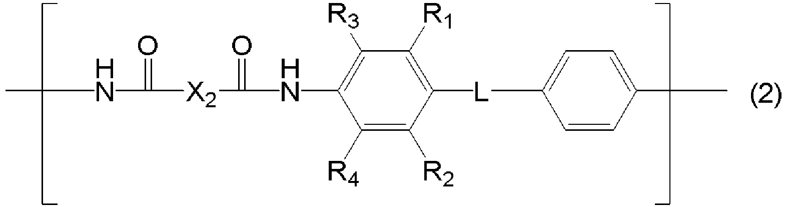 wherein X₂ represents a divalent organic group, and R₁ to R₄ and L are as defined above, 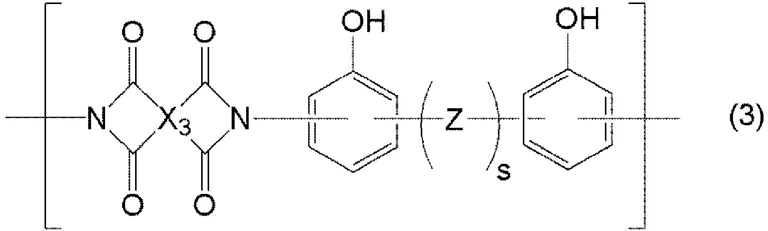 wherein X₃ represents a tetravalent organic group that is identical to or different from the X₁, "s" represents 0 or 1, Z represents a divalent bonding group, and when s=0, the two aromatic rings in the formula are directly bonded without an intervening bonding group, 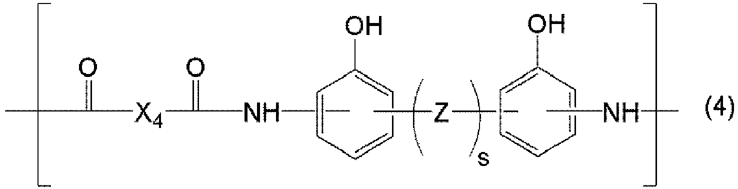 wherein X₄ represents a divalent organic group that is identical to or different from the X₂, and "s" and Z are as defined above.

2. The polymer according to claim 1, wherein in the general formulae (1) and (2), either one of the R₁ and the R₂ represents a monovalent organic group having 1 to 15 carbon atoms and optionally containing a heteroatom, the other of the R₁ and the R₂ represents a hydrogen atom, and the R₃ and the R₄ each represent a hydrogen atom.

3. The polymer according to claim 1, wherein in the general formulae (1) and (2), either one of the R₁ and the R₂ represents an aromatic group having 6 to 12 carbon atoms, and the other of the R₁ and the R₂ represents a hydrogen atom.

4. The polymer according to claim 1, wherein the L in the general formulae (1) and (2) is at least one selected from any of an oxygen atom, a sulfur atom, a carbonyl group, a linear alkylene group having 1 to 15 carbon atoms, and a branched alkylene group having 3 to 15 carbon atoms.

5. The polymer according to claim 1, wherein the Z in the general formulae (3) and (4) is at least one bonding group selected from any of groups represented by the following formulae (5), (6), (7), and (8), 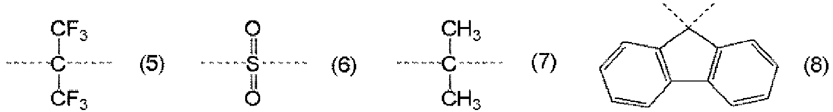 wherein a dotted line represents an attachment point.

6. A positive photosensitive resin composition comprising:
(A) the polymer according to claim 1;
(B) a photosensitizer which is a compound having a quinonediazide structure and generates an acid by light to increase a dissolution rate in an aqueous alkaline solution; and
(D) a solvent,
optionally, further comprising the following component (C):
(C) one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (C-1), and a compound containing two or more nitrogen atoms each having a glycidyl group represented by the following formula (C-2), 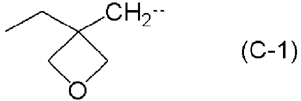 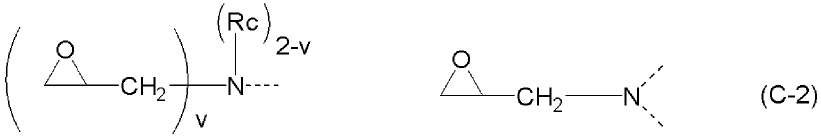 wherein a dotted line represents an attachment point, Rc represents a linear, branched, or cyclic alkyl group having 1 to 6 carbon atoms, and "v" represents 1 or 2.

7. A negative photosensitive resin composition comprising:
(A) the polymer according to claim 1;
(B') a photoacid generator;
(C) one or more crosslinking agents selected from the group consisting of an amino condensate modified with formaldehyde or formaldehyde-alcohol, a phenol compound having two or more methylol groups or alkoxymethylol groups on average in one molecule, a compound in which a hydrogen atom of a hydroxy group of a polyhydric phenol is substituted with a glycidyl group, a compound in which a hydrogen atom of a hydroxy group of a polyhydric phenol or a hydroxy group of a polyhydric alcohol is substituted with a substituent represented by the following formula (C-1), and a compound containing two or more nitrogen atoms each having a glycidyl group represented by the following formula (C-2), 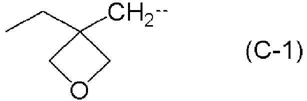 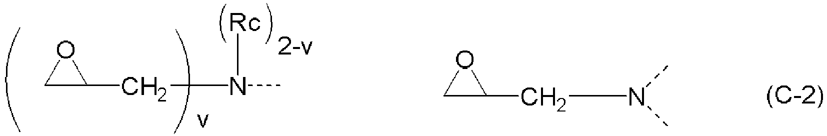 wherein a dotted line represents an attachment point, Rc represents a linear, branched, or cyclic alkyl group having 1 to 6 carbon atoms, and "v" represents 1 or 2; and
(D) a solvent.

8. A patterning process comprising the steps of:
(1) applying the positive photosensitive resin composition according to claim 6 onto a substrate to form a photosensitive material film;
(2) heating the photosensitive material film;
(3) exposing the photosensitive material film with a high-energy beam having a wavelength of 190 to 500 nm or an electron beam through a photomask; and
(4) developing the film with a developing solution of an aqueous alkaline solution.

9. A patterning process comprising the steps of:
(I) applying the negative photosensitive resin composition according to claim 7 onto a substrate to form a photosensitive material film;
(II) heating the photosensitive material film;
(III) exposing the photosensitive material film with a high-energy beam having a wavelength of 190 to 500 nm or an electron beam through a photomask; and
(IV) after irradiation, subjecting the substrate to heat treatment, followed by development using a developing solution of an aqueous alkaline solution.

10. A method for forming a cured film, comprising heating and post-curing a patterned film obtained by the patterning process according to claim 8 or 9 at a temperature of 100 to 300°C.

11. An interlayer insulating film comprising a cured film of the positive photosensitive resin composition according to claim 6.

12. An interlayer insulating film comprising a cured film of the negative photosensitive resin composition according to claim 7.

13. A surface protective film comprising a cured film of the positive photosensitive resin composition according to claim 6.

14. A surface protective film comprising a cured film of the negative photosensitive resin composition according to claim 7.

15. An electronic component comprising the interlayer insulating film according to claim 11 or 12, or the surface protective film according to claim 13 or 14.
